# EUROPEAN PATENT APPLICATION

(11) **EP 4 624 478 A1**
(43) Date of publication of application: **01.10.2025**
(21) Application number: 24738701.2
(22) Date of filing: 03.01.2024
(51) Int. Cl.: C07F 5/02, H10K 85/60, C09K 11/06

(54) **POLYCYCLIC COMPOUND AND ORGANIC LIGHT-EMITTING DEVICE USING SAME**

(30) Priority: 03.01.2023 KR 20230000558
(71) Applicant: SFC Co., Ltd., Cheongju-si, Chungcheongbuk-do 28122 (KR)
(72) Inventor: KIM, Ji-hwan, Cheongju-si Chungcheongbuk-do 28122 (KR); JOO, Sung-hoon, Cheongju-si Chungcheongbuk-do 28122 (KR); PARK, Kyung-hwa, Cheongju-si Chungcheongbuk-do 28122 (KR); WOO, Seong-eun, Cheongju-si Chungcheongbuk-do 28122 (KR); KANG, Soo-kyung, Cheongju-si Chungcheongbuk-do 28122 (KR); JO, Ju-hyoung, Cheongju-si Chungcheongbuk-do 28122 (KR); CHOI, Hui-jae, Cheongju-si Chungcheongbuk-do 28122 (KR)
(74) Representative: Grosse Schumacher Knauer von Hirschhausen
(86) International application number: PCT/KR2024/000102
(87) International publication number: WO 2024/147631

(57) **Abstract**

The present invention relates to a polycyclic compound having a characteristic fused ring structure and an organic light-emitting device employing the same as a dopant of a light-emitting layer, and since an improved organic light-emitting device with high efficiency and long lifespan may be achieved using the compound according to the present invention, the device is industrially useful not only in lighting elements, but also in various display devices such as flat panel, flexible and wearable displays.

## Description

### [Technical Field]

The present invention relates to a polycyclic compound employed in an organic layer such as a light-emitting layer in an organic light-emitting device, and an organic light-emitting device including the same.

### [Background Art]

Organic light-emitting devices are self-luminous devices in which electrons injected from an electron injecting electrode (cathode) combine with holes injected from a hole injecting electrode (anode) in a light-emitting layer to form excitons, which emit light while releasing energy. Such organic light-emitting devices have advantages of low driving voltage, high luminance, wide viewing angle and short response time, and being applicable to full-color light-emitting flat panel displays. Due to these advantages, organic light-emitting devices have received attention as next-generation light sources.

The above characteristics of organic light-emitting devices are achieved by structural optimization of organic layers of the devices and are supported by stable and efficient materials for the organic layers, such as hole injecting materials, hole transport materials, hole blocking materials, light-emitting materials, electron transport materials, electron injecting materials, and electron blocking materials. However, more research still needs to be done to develop structurally optimized structures of organic layers for organic light-emitting devices and stable and efficient materials for organic layers of organic light-emitting devices.

Particularly, to obtain maximum efficiency in a light-emitting layer, an appropriate combination of energy band gaps of a host and a dopant is required so that holes and electrons each migrate to the dopant through stable electrochemical paths to form excitons.

### [Detailed Description of the Invention]

### [Problems to be Solved by the Invention]

Therefore, the present invention is intended to provide a polycyclic compound having a characteristic fused ring structure, and a high-efficiency and long-lifespan organic light-emitting device having significantly improved long lifespan and luminous efficiency by employing the same as a dopant material in a light-emitting layer.

### [Means for Solving the Problems]

One aspect of the present invention provides a polycyclic compound represented by [Chemical Formula 1] or [Chemical Formula 2] having a characteristic fused ring structure as below, and an organic light-emitting device including the same as a dopant in a light-emitting layer.

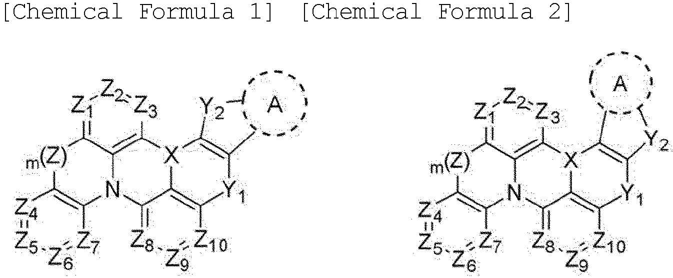

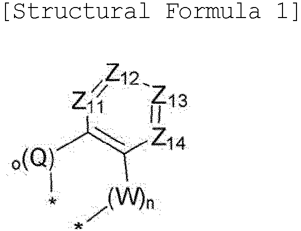

In [Chemical Formula 1] and [Chemical Formula 2], at least one pair of neighboring two, Z₁ and Z₂, Z₂ and Z₃, Z₄ and Z₅, Z₅ and Z₆, and Z₆ and Z₇, among Z₁ to Z₇ are carbon atoms, and linked to two *s in [Structural Formula 1] at the same time to form a ring.

Specific structures of [Chemical Formula 1] and [Chemical Formula 2], specific compounds according to the present invention obtained therefrom, and a definition of each substituent will be described later.

### [Effects of the Invention]

The present invention relates to a polycyclic compound having a characteristic fused ring structure, and an organic light-emitting device employing the same as a dopant of a light-emitting layer, and since an improved organic light-emitting device with high efficiency and long lifespan can be achieved, the device can be effectively used not only in lighting elements, but also in various display devices such as flat panel, flexible and wearable displays.

### [Best Mode for Carrying out the Invention]

Hereinafter, the present invention will be described in more detail.

One aspect of the present invention relates to a compound represented by the following [Chemical Formula 1] or [Chemical Formula 2].

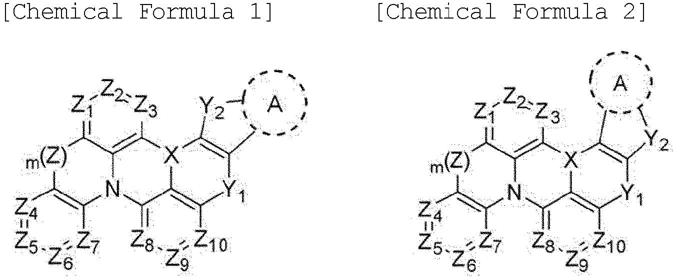

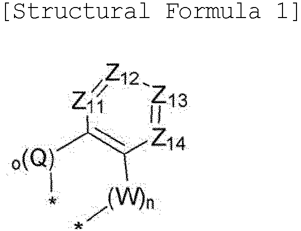

In [Chemical Formula 1] and [Chemical Formula 2],
X is B, P=O, P=S or Al, Y₁ is NR₁, O, S, CR₂R₃, SiR₄R₅ or GeR₆R₇, and Y₂ is NR₈, O or S.

A is selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring and a substituted or unsubstituted fused ring of C₃-C₃₀ aliphatic ring and C₃-C₃₀ aromatic ring.

In [Chemical Formula 1] and [Chemical Formula 2], at least one pair of neighboring two, Z₁ and Z₂, Z₂ and Z₃, Z₄ and Z₅, Z₅ and Z₆, and Z₆ and Z₇, among Z₁ to Z₇ are carbon atoms, and linked to two *s in [Structural Formula 1] at the same time to form a ring.

Herein, the rest of Z₁ to Z₇ not forming the ring and Z₈ to Z₁₄ are the same as or different from each other, and each independently CR₉ or N.

In addition, when Z₁ to Z₁₄ include a plurality of CR₉s, CR₉s are the same as or different from each other.

Z, Q and W are the same as or different from each other, and each independently NR₁₀, CR₁₁R₁₂, SiR₁₃R₁₄, GeR₁₅R₁₆, O or S.

R₁ to R₁₆ are the same as or different from each other, and each independently selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group and a halogen group.

m is 0 or 1, and when m is 0, the carbon atom between Z and Z₁ and the carbon atom between Z and Z₄ are linked through a single bond.

∘ is 0 or 1, and when o is 0, the carbon atom between Z₁₁ and Q and the carbon atom linked to * are linked through a single bond. n is 0 or 1, and when n is 0, the carbon atom between Z₁₄ and W and the carbon atom linked to * are linked through a single bond (however, o+n≥1).

In addition, R₂ to R₁₆ may be linked to adjacent substituents to further form an alicyclic or aromatic monocyclic or polycyclic ring.

In addition, the adjacent plurality of R₉s may be linked to each other to further form an alicyclic or aromatic monocyclic or polycyclic ring.

In addition, R₂ and R₃, R₄ and R₅, R₆ and R₇, R₁₁ and R₁₂, R₁₃ and R₁₄, and R₁₅ and R₁₆ may each be linked to each other to further form an alicyclic or aromatic monocyclic or polycyclic ring.

According to one embodiment of the present invention, at least one of Z₁ to Z₇ and Z₁₁ to Z₁₄ in [Chemical Formula 1] and [Chemical Formula 2] is CR₉, and at least one of the plurality of R₉s is a bulky substituent that is not hydrogen or deuterium.

According to one embodiment of the present invention, [Chemical Formula 1] may be represented by any one selected from the following [Chemical Formula 1-1] to [Chemical Formula 1-5].

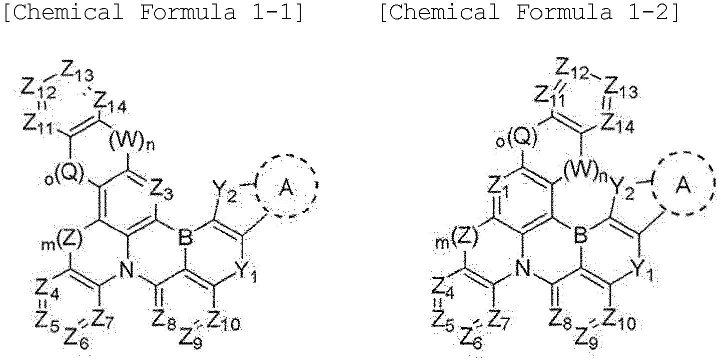

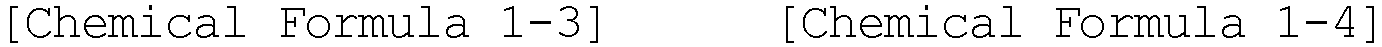

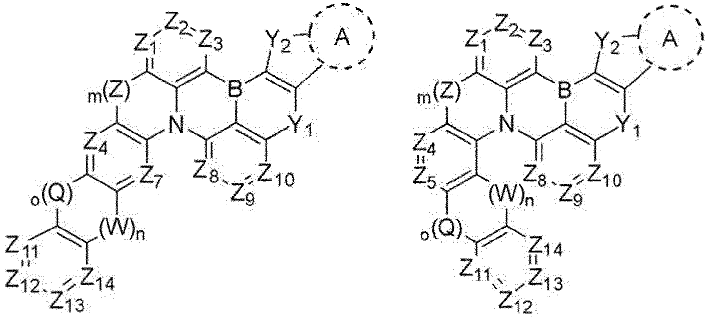

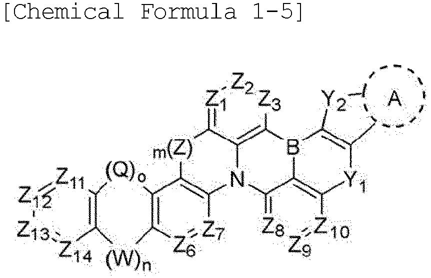

In [Chemical Formula 1-1] to [Chemical Formula 1-5], Z, Q, W, Z₁ to Z₁₄, Y₁, Y₂, m, n, o and A have the same definitions as in [Chemical Formula 1].

According to one embodiment of the present invention, [Chemical Formula 2] may be represented by any one selected from the following [Chemical Formula 2-1] to [Chemical Formula 2-5].

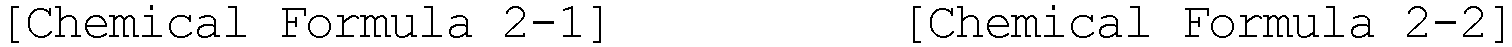

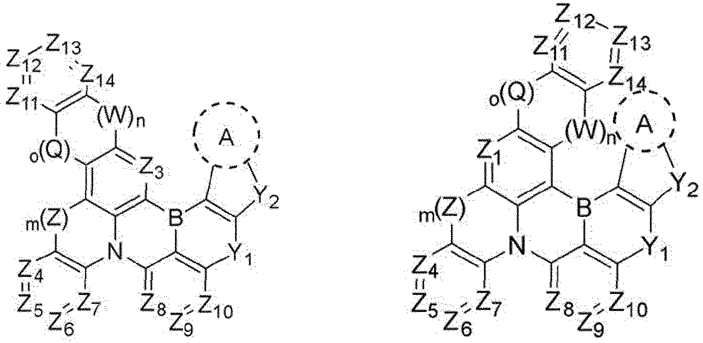

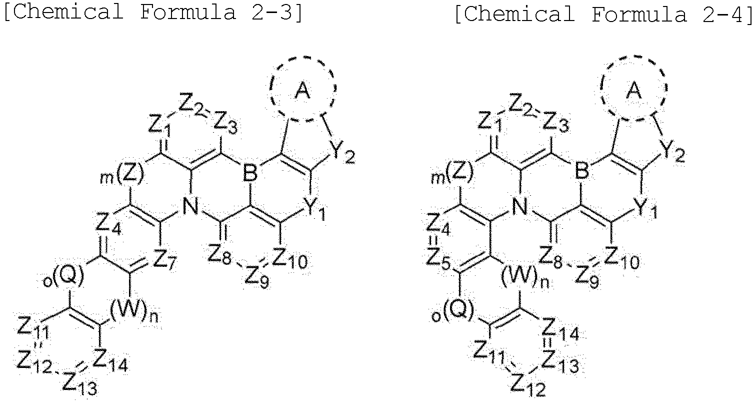

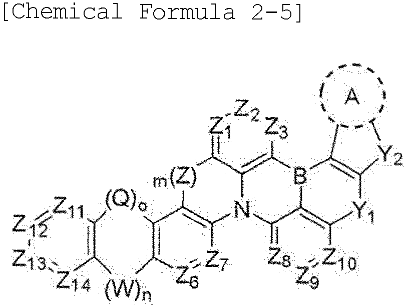

In [Chemical Formula 2-1] to [Chemical Formula 2-5], Z, Q, W, Z₁ to Z₁₄, Y₁, Y₂, m, n, o and A have the same definitions as in [Chemical Formula 2].

In addition, 'substituted or unsubstituted' in [Chemical Formula 1], [Chemical Formula 1-1] to [Chemical Formula 1-5], [Chemical Formula 2], [Chemical Formula 2-1] to [Chemical Formula 2-5] and [Structural Formula 1] means being substituted with one, or two or more substituents selected from the group consisting of deuterium, a C₁-C₂₄ alkyl group, a C₁-C₂₄ halogenated alkyl group, a C₃-C₂₄ cycloalkyl group, a C₂-C₂₄ alkenyl group, a C₂-C₂₄ alkynyl group, a C₁-C₂₄ heteroalkyl group, a C₂-C₂₄ heterocycloalkyl group, a C₆-C₃₀ aryl group, a C₇-C₃₀ arylalkyl group, a C₇-C₃₀ alkylaryl group, a C₂-C₃₀ heteroaryl group, a C₃-C₃₀ heteroarylalkyl group, a C₃-C₃₀ alkylheteroaryl group, a fused cyclic group of C₃-C₂₄ aliphatic ring and C₃-C₂₄ aromatic ring, a C₁-C₂₄ alkoxy group, a C₆-C₂₄ aryloxy group, a C₆-C₂₄ arylthionyl group, a C₁-C₄₀ amine group, a C₁-C₄₀ silyl group, a C₁-C₄₀ germanium group, a cyano group, a halogen group, a hydroxyl group and a nitro group, or being substituted with a substituent in which two or more of the above-mentioned substituents are linked, and hydrogens in the substituents may be substituted with one or more deuteriums, and two or more adjacent substituents may be linked to each other to further form an alicyclic or aromatic monocyclic or polycyclic ring.

Meanwhile, the range of the number of carbon atoms in the alkyl group or aryl group in the 'substituted or unsubstituted C₁-C₃₀ alkyl group', 'substituted or unsubstituted C₆-C₅₀ aryl group' and the like refers to the total number of carbon atoms forming the alkyl or aryl moiety when unsubstituted without considering the moiety substituted with the substituents. For example, it means that a phenyl group substituted with a butyl group at a para position corresponds to a C₆ aryl group substituted with a C₄ butyl group.

In addition, in the present invention, being linked to each other or to adjacent groups to further form a ring may mean that adjacent substituents among the specified substituents may bond to each other or the specified substituent and another adjacent group may bond to each other to form a substituted or unsubstituted alicyclic or aromatic ring, and the 'adjacent group' may refer to a substituent substituting on an atom directly linked to an atom substituted with the corresponding substituent, a substituent positioned sterically closest to the corresponding substituent, or another substituent substituting on an atom substituted with the corresponding substituent. For example, two substituents substituting at an ortho position of a benzene ring and two substituents substituting on the same carbon in an aliphatic ring may be interpreted as 'adjacent groups' to each other, and the linked pair of substituents each lose one hydrogen radical and linked to each other to further form a ring, and the carbon atoms of the formed alicyclic or aromatic monocyclic or polycyclic ring may be replaced by heteroatoms such as N, NR, O, S, Si and Ge. R has the same definition as R₁ to R₁₆ in [Chemical Formula 1] or [Chemical Formula 2].

In the present invention, the alkyl group may be linear or branched. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethylpropyl group, a 1,1-dimethyl-propyl group, an isohexyl group, a 2-methylpentyl group, a 4-methylhexyl group, a 5-methylhexyl group and the like, but are not limited thereto.

In the present invention, specific examples of the arylalkyl group may include phenylmethyl (benzyl), phenylethyl, phenylpropyl, naphthylmethyl, naphthylethyl and the like, but are not limited thereto.

In the present invention, specific examples of the alkylaryl group may include tolyl, xylenyl, dimethylnaphthyl, t-butylphenyl, t-butylnaphthyl, t-butylphenanthryl and the like, but are not limited thereto.

In the present invention, the alkenyl group includes linear or branched forms, and may be further substituted with other substituents. Specific examples thereof may include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present invention, the alkynyl group also includes linear or branched forms, and may be further substituted with other substituents. Examples thereof may include ethynyl, 2-propynyl and the like, but are not limited thereto.

In the present invention, the cycloalkenyl group is a non-aromatic cyclic unsaturated hydrocarbon group having one or more carbon double bonds. Examples thereof may include cyclopropenyl, cyclobutenyl, cyclopentenyl, cyclohexenyl, cycloheptenyl, 1,3-cyclohexadienyl, 1,4-cyclohexadienyl, 2,4-cycloheptadienyl, 1,5-cyclooctadienyl and the like, but are not limited thereto.

In the present invention, the aromatic hydrocarbon ring or the aryl group may be monocyclic or polycyclic. The term 'polycyclic group' refers to a group directly linked to or fused with other cyclic groups, and the other cyclic group may be an aromatic hydrocarbon ring, but may also be other types of cyclic groups such as an aliphatic heteroring, an aliphatic hydrocarbon ring and an aromatic heteroring. Examples of the monocyclic aryl group may include a phenyl group, a biphenyl group, a terphenyl group and the like, and examples of the polycyclic aryl group may include a naphthyl group, an anthracenyl group, a phenanthrenyl group, a pyrenyl group, a perylenyl group, a tetracenyl group, a chrysenyl group, a fluorenyl group, an acenaphathcenyl group, a triphenylene group, a fluoranthrene group and the like, however, the scope of the present invention is not limited to these examples.

In the present invention, the aromatic heteroring or the heteroaryl group is an aromatic ring including one or more of heteroatoms. Examples thereof may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, an indolocarbazole group, a benzoxazole group, a benzimidazole group, a benzothiazole group, a benzocarbazole group, a benzothiophene group, a dibenzothiophene group, a benzofuranyl group, a dibenzofuranyl group, a phenanthroline group, a thiazolyl group, an isoxazolyl group, an oxadiazolyl group, a thiadiazolyl group, a benzothiazolyl group, a phenothiazinyl and the like, but are not limited thereto.

In the present invention, the aliphatic hydrocarbon ring or the cycloalkyl group refers to a non-aromatic ring formed only with carbon and hydrogen atoms. Examples thereof may include monocyclic or polycyclic groups, and the aliphatic hydrocarbon ring or the cycloalkyl group may be further substituted with other substituents. The term 'polycyclic group' refers to a group directly linked to or fused with other cyclic groups, and the other cyclic group may be an aliphatic hydrocarbon ring, but may also be other types of cyclic groups such as an aliphatic heteroring, an aromatic hydrocarbon ring and an aromatic heteroring. Specific examples thereof may include a cycloalkyl group such as a cyclopropyl group, a cyclobutyl group, a cyclopentyl group, an adamantyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group and a cyclooctyl group, a cycloalkane group such as a cyclohexane group and a cyclopentane group, and a cycloalkene group such as a cyclohexene group and a cyclobutene group, but are not limited thereto.

In the present invention, the aliphatic heteroring or the heterocycloalkyl group refers to an aliphatic ring including one or more of heteroatoms such as O, S, Se, N or Si, includes monocyclic or polycyclic groups as well, and may be further substituted with other substituents. The term 'polycyclic group' refers to a group in which heterocycloalkyl, heterocycloalkane or the like is directly linked to or fused with other cyclic groups, and the other cyclic group may be an aliphatic heteroring, but may also be other types of cyclic groups such as an aliphatic hydrocarbon ring, an aromatic hydrocarbon ring and an aromatic heteroring.

In the present invention, the fused ring (cyclic group) of aliphatic ring and aromatic ring is an aliphatic-aromatic mixed ring (cyclic group), and refers to a ring in which two or more rings are linked to and fused with each other, and an aliphatic ring and an aromatic ring are fused to have non-aromaticity overall. More specifically, the fused ring (cyclic group) of aliphatic ring and aromatic ring may include an aromatic hydrocarbon ring (cyclic group) fused with an aliphatic hydrocarbon ring, an aromatic hydrocarbon ring (cyclic group) fused with an aliphatic heteroring, an aromatic heteroring (cyclic group) fused with an aliphatic hydrocarbon ring, an aromatic heteroring (cyclic group) fused with an aliphatic heteroring, an aliphatic hydrocarbon ring (cyclic group) fused with an aromatic hydrocarbon ring, an aliphatic hydrocarbon ring (cyclic group) fused with an aromatic heteroring, an aliphatic heteroring (cyclic group) fused with an aromatic hydrocarbon ring, an aliphatic heteroring (cyclic group) fused with an aromatic heteroring, and the like, and specific examples thereof may include a tetrahydronaphthyl group, a tetrahydrobenzocycloheptene group, a tetrahydrophenanthrene group, a tetrahydroanthracenyl group, an octahydrotriphenylene group, a tetrahydrobenzothiophene group, a tetrahydrobenzofuranyl group, a tetrahydrocarbazole group, a tetrahydroquinoline group and the like. In addition, heteroatoms such as N, NR, O, S, Si or Ge may replace other than carbon in the fused ring (cyclic group) of aliphatic ring and aromatic ring, and R has the same definition as R₁ to R₁₆ in [Chemical Formula 1] or [Chemical Formula 2].

In the present invention, the alkoxy group may specifically be methoxy, ethoxy, propoxy, isobutyloxy, sec-butyloxy, pentyloxy, iso-amyloxy, hexyloxy or the like, but is not limited thereto.

In the present invention, the silyl group may include -SiH₃, an alkylsilyl group, an arylsilyl group, an alkylarylsilyl group, an arylheteroarylsilyl group, a heteroarylsilyl group and the like. The arylsilyl group refers to a silyl group in which one, two or three hydrogen atoms are substituted with an aryl group in -SiH₃, the alkylsilyl group refers to a silyl group in which one, two or three hydrogen atoms are substituted with an alkyl group in -SiH₃, the alkylarylsilyl group refers to a silyl group including one or two alkyl groups and two or one aryl groups corresponding thereto by at least one hydrogen atom being substituted with an alkyl group and an aryl group in -SiH₃, the arylheteroarylsilyl group refers to a silyl group including one or two aryl groups and two or one heteroaryl groups corresponding thereto by at least one hydrogen atom being substituted with an aryl group and a heteroaryl group in -SiH₃, and the heteroarylsilyl group refers to a silyl group in which one, two or three hydrogen atoms are substituted with a heteroaryl group in -SiH₃. Examples of the arylsilyl group may include a substituted or unsubstituted monoarylsilyl group, a substituted or unsubstituted diarylsilyl group or a substituted or unsubstituted triarylsilyl group, and the same also applies to the alkylsilyl group and the heteroarylsilyl group.

Herein, the aryl group in each of the arylsilyl group, the heteroarylsilyl group and the arylheteroarylsilyl group may be a monocyclic aryl group or a polycyclic aryl group, and the heteroaryl group in each of the arylsilyl group, the heteroarylsilyl group and the arylheteroarylsilyl group may be a monocyclic heteroaryl group or a polycyclic heteroaryl group.

In addition, specific examples of the silyl group may include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl and the like, and one or more hydrogen atoms in the silyl group may be substituted with the same substituents as in the case of the aryl group.

In the present invention, the amine group may include -NH₂, an alkylamine group, an arylamine group, an alkylarylamine group, an arylheteroarylamine group, a heteroarylamine group and the like. The arylamine group refers to an amine group in which one or two hydrogen atoms are substituted with an aryl group in -NH₂, the alkylamine group refers to an amine group in which one or two hydrogen atoms are substituted with an alkyl group in -NH₂, and the alkylarylamine group refers to an amine group in which one hydrogen atom is substituted with an alkyl group and the other hydrogen atom is substituted with an aryl group in -NH₂. The arylheteroarylamine group refers to an amine group in which one hydrogen atom is substituted with an aryl group and the other hydrogen atom is substituted with a heteroaryl group in -NH₂, and the heteroarylamine group refers to an amine group in which one or two hydrogen atoms are substituted with a heteroaryl group in -NH₂. Examples of the arylamine group may include a substituted or unsubstituted monoarylamine group, a substituted or unsubstituted diarylamine group or a substituted or unsubstituted triarylamine griyo, and the same also applies to the alkylamine group and the heteroarylamine group.

Herein, the aryl group in each of the arylamine group, the heteroarylamine group and the arylheteroarylamine group may be a monocyclic aryl group or a polycyclic aryl group, and the heteroaryl group in each of the arylamine group, the heteroarylamine group and the arylheteroarylamine group may be a monocyclic heteroaryl group or a polycyclic heteroaryl group.

In the present invention, the germanium group (or germane group) may include -GeH₃, an alkylgermanium group, an arylgermanium group, a heteroarylgermanium group, an alkylarylgermanium group, an alkylheteroarylgermanium group, an arylheteroarylgermanium group and the like. Definitions thereof follow the description provided for the silyl group, and may be applied to each substituent as a substituent obtained by being substituted with a germanium (Ge) atom instead of a silicon (Si) atom in the silyl group.

In addition, specific examples of the germanium group may include trimethylgermane, triethylgermane, triphenylgermane, trimethoxygermane, dimethoxyphenylgermane, diphenylmethylgermane, diphenylvinylgermane, methylcyclobutylgermane, dimethylfurylgermane and the like, and one or more hydrogen atoms in the germanium group may be substituted with the same substituents as in the case of the aryl group.

The cycloalkyl group, the aryl group and the heteroaryl group in the cycloalkyloxy group, the aryloxy group, the heteroaryloxy group, the cycloalkylthioxy group, the arylthioxy group and the heteroarylthioxy group are the same as the examples of the cycloalkyl group, the aryl group and the heteroaryl group provided above. Specific examples of the aryloxy group may include a phenoxy group, a p-tolyloxy group, an m-tolyloxy group, a 3,5-dimethylphenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, and specific examples of the arylthioxy group may include a phenylthioxy group, a 2-methylphenylthioxy group, a 4-tert-butylphenylthioxy group and the like. However, the aryloxy group and the arylthioxy group are not limited thereto.

In the present invention, examples of the halogen group include fluorine, chlorine, bromine or iodine.

According to one embodiment of the present invention, the polycyclic compound represented by [Chemical Formula 1] or [Chemical Formula 2] may be any one selected from compounds represented by the following chemical formulae, however, the scope of the present invention is not limited thereby.

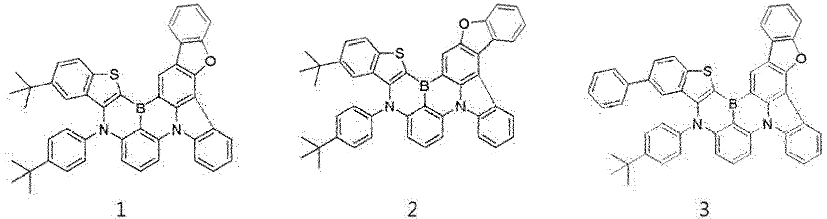

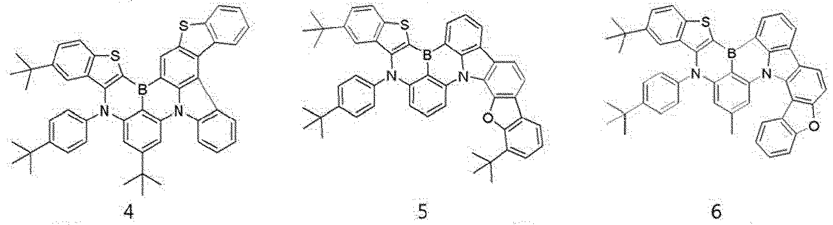

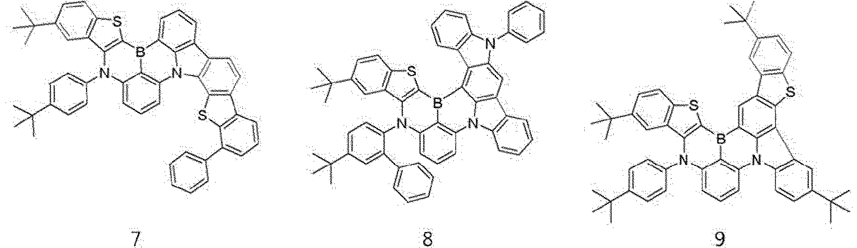

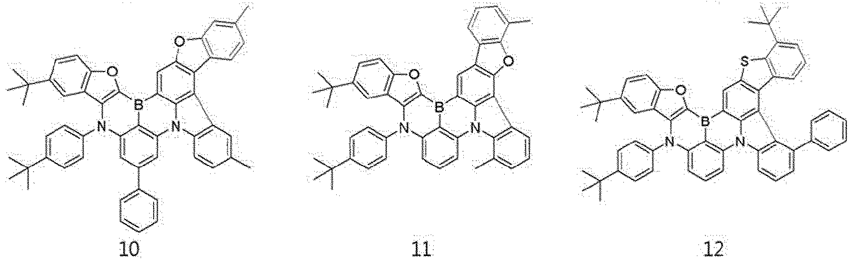

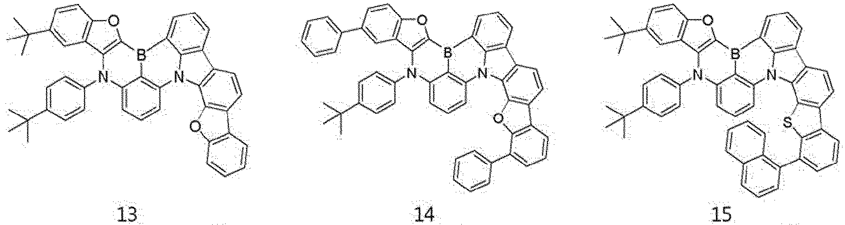

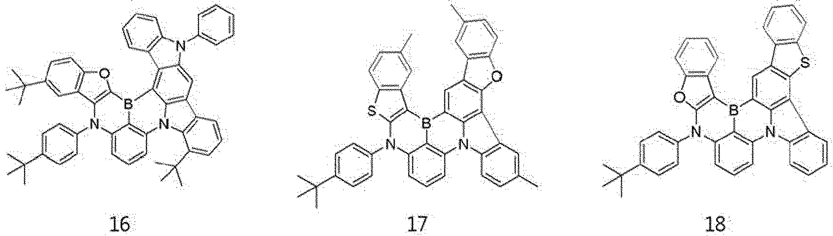

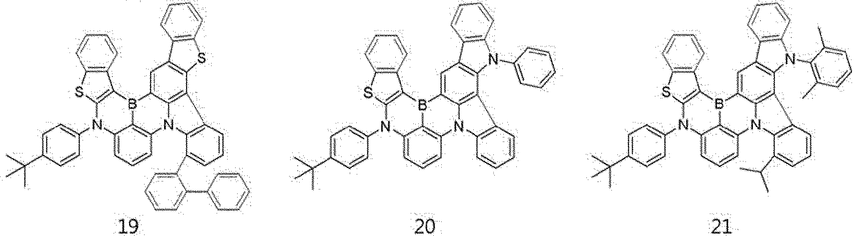

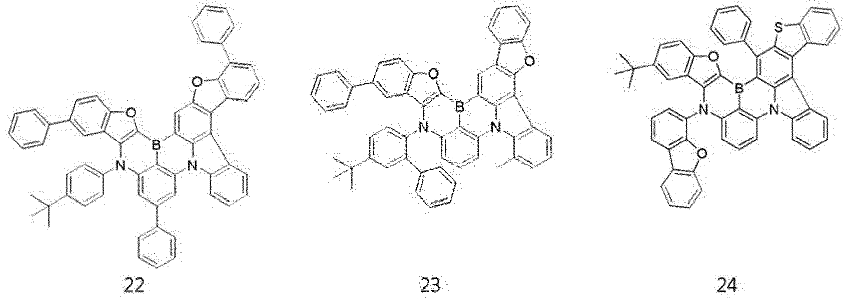

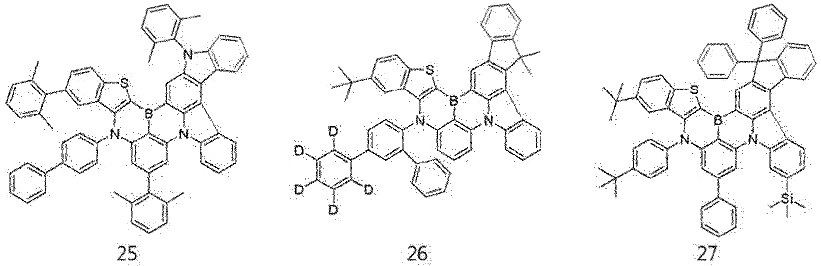

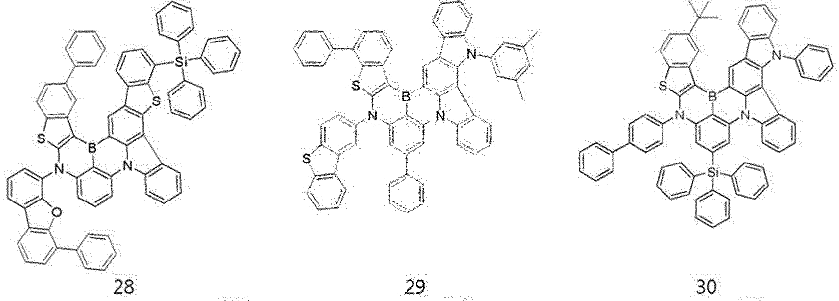

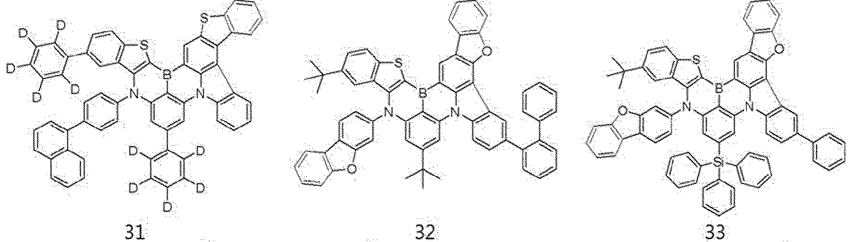

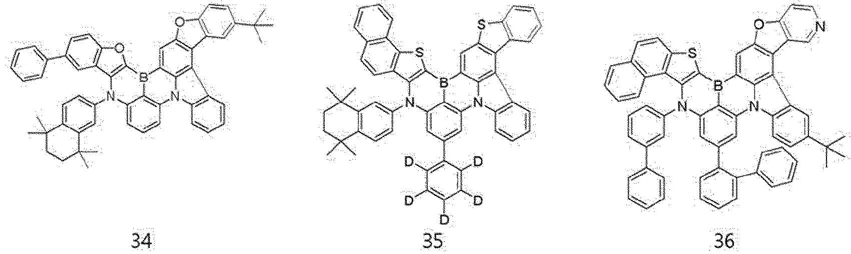

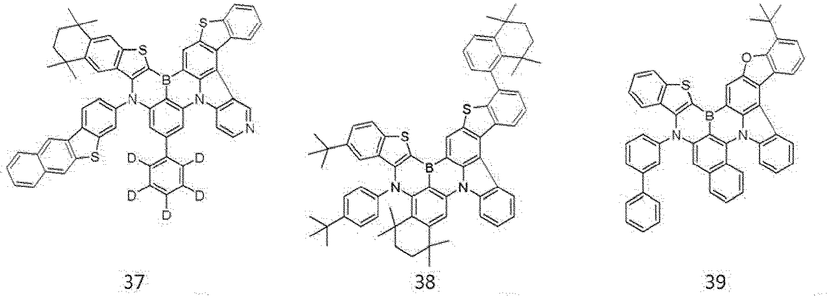

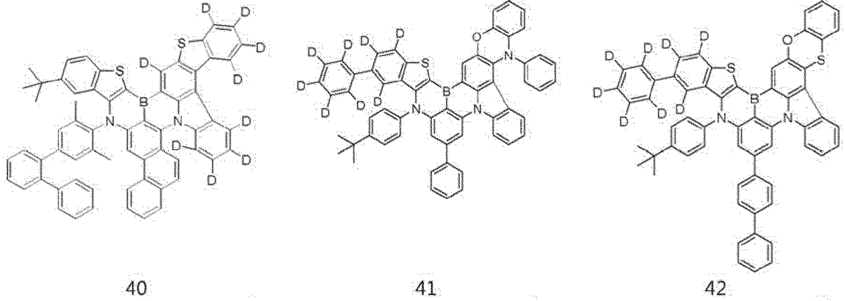

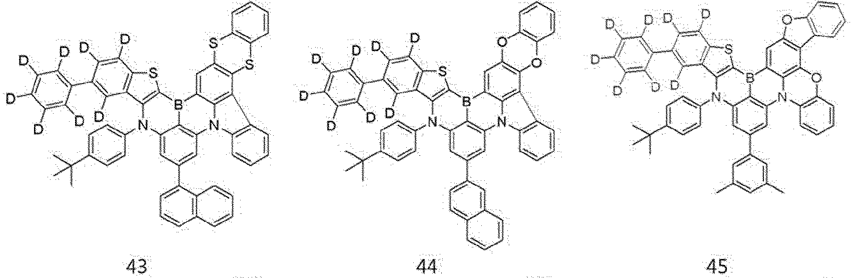

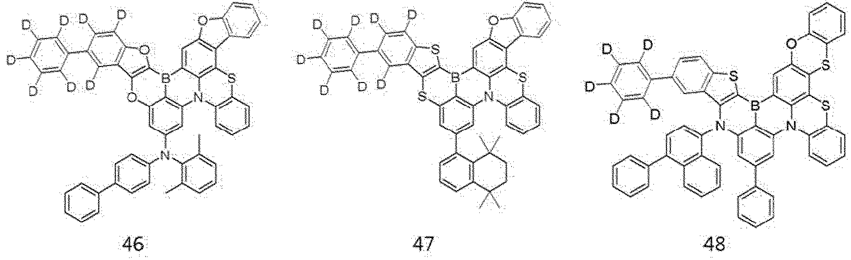

In addition, another aspect of the present invention relates to an organic light-emitting device formed with a first electrode, a second electrode and one or more organic layers interposed between the first electrode and the second electrode, and the organic layer, preferably a light-emitting layer, includes the compound represented by [Chemical Formula 1] or [Chemical Formula 2] as a dopant.

The light-emitting layer has a structure formed with a host and a dopant, and may further include a host material. Herein, the content of the dopant including the polycyclic compound according to the present invention may be typically selected in a range of about 0.01 parts by weight to about 20 parts by weight based on about 100 parts by weight of the host, however, the content is not limited thereto.

In addition, the light-emitting layer may further include various dopant and host materials in addition to the dopant compound and the host compound according to the present invention, and accordingly, one or more types of compounds different from each other may be mixed or laminated to be used not only as the host material but also as the dopant material in the light-emitting layer.

The host compound employed in the light-emitting layer according to one embodiment of the present invention may be an anthracene compound represented by the following [Chemical Formula 3].

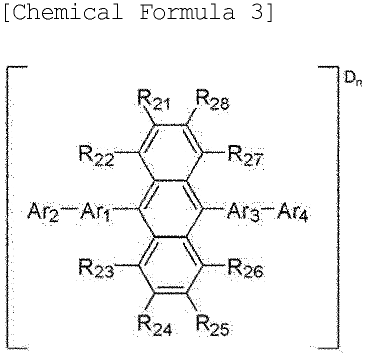

In [Chemical Formula 3],
R₂₁ to R₂₈ are the same as or different from each other, and each independently selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group and a halogen group.

Ar₁ and Ar₃ are the same as or different from each other, and each independently a single bond, or a substituted or unsubstituted C₆-C₃₀ arylene group or a substituted or unsubstituted C₅-C₃₀ heteroarylene group.

Ar₂ and Ar₄ are the same as or different from each other, and each independently selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted fused cyclic group of C₃-C₃₀ aliphatic ring and C₃-C₃₀ aromatic ring.

Dₙ refers to the number of hydrogens replaced by deuterium in [Chemical Formula 3], and n is an integer of 0 to 50.

According to one embodiment of the present invention, the anthracene compound represented by [Chemical Formula 3] may be any one selected from compounds represented by the following formulae, however, the scope of the present invention is not limited thereby.

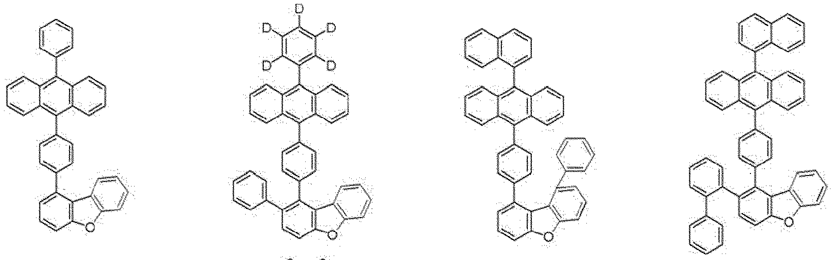

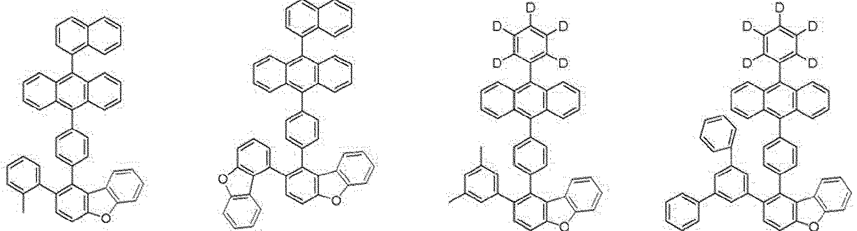

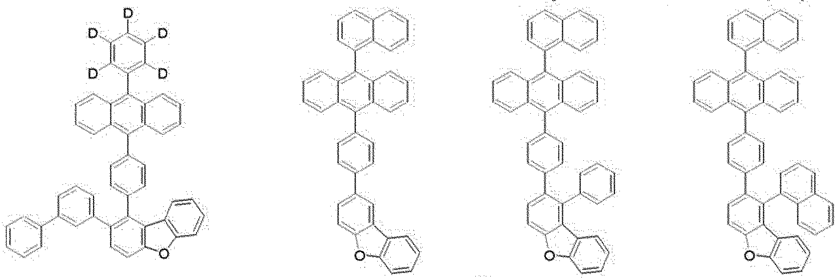

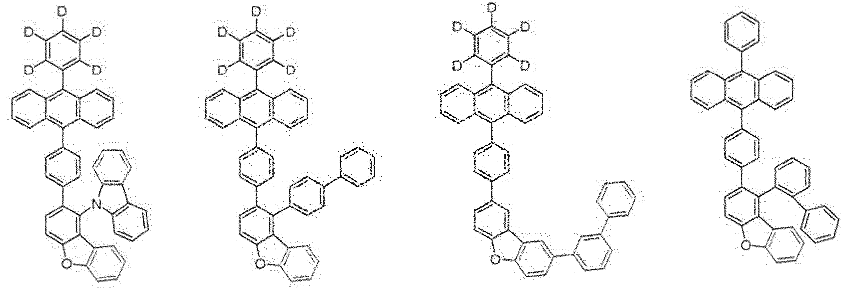

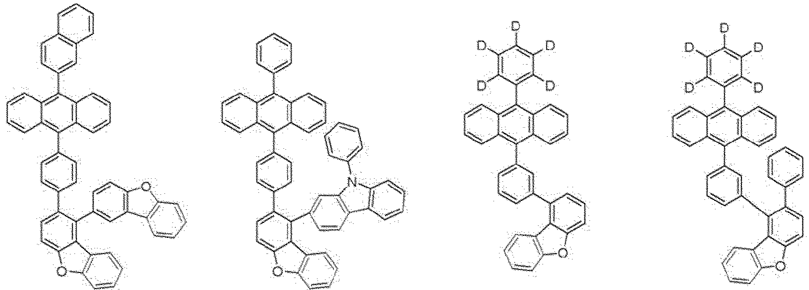

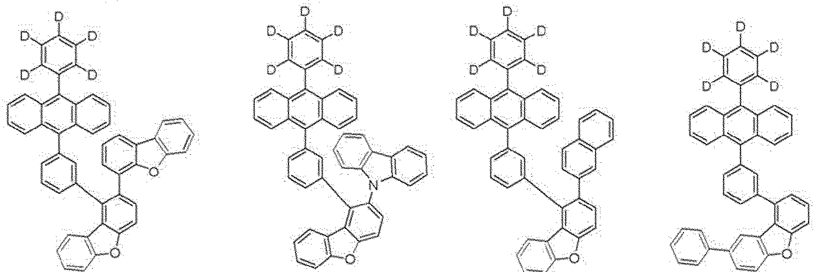

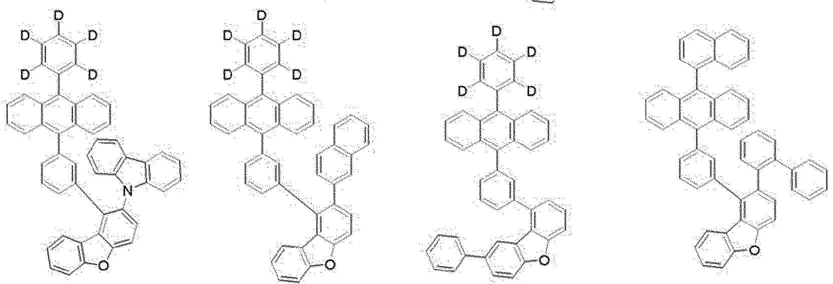

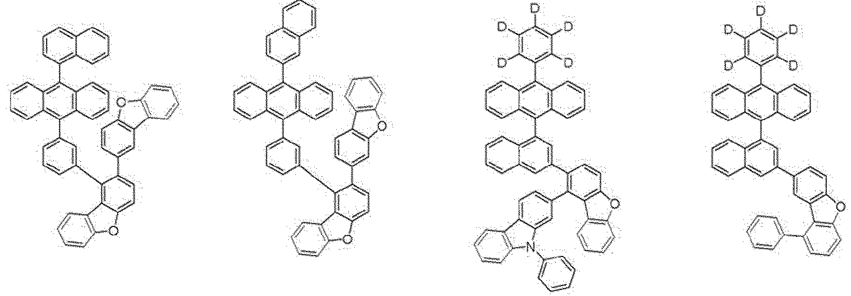

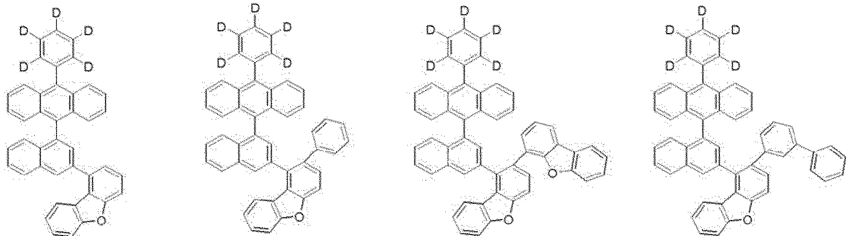

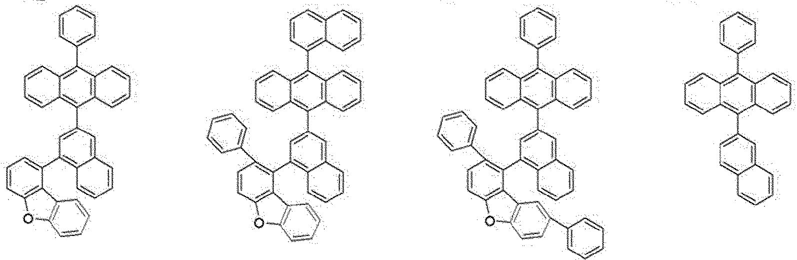

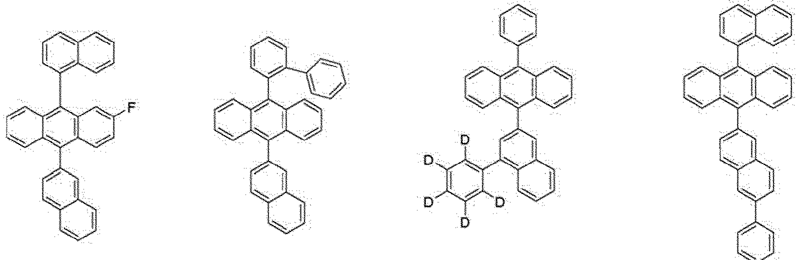

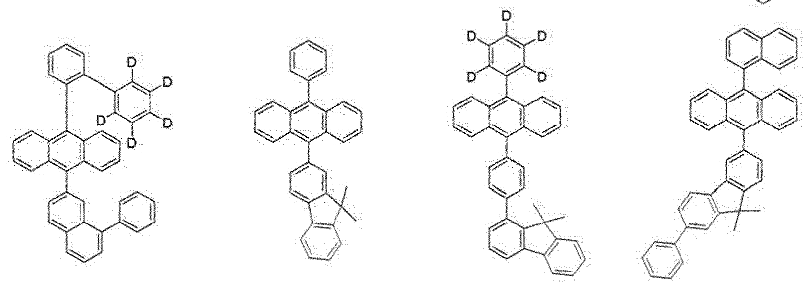

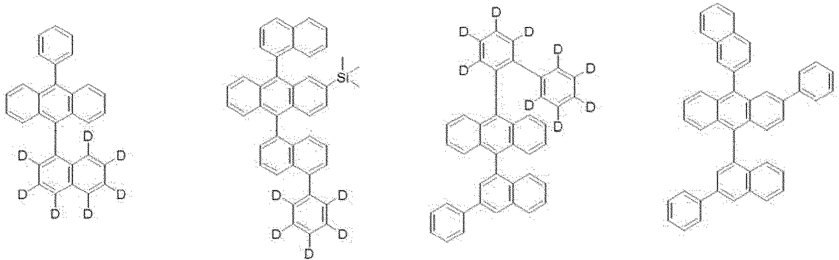

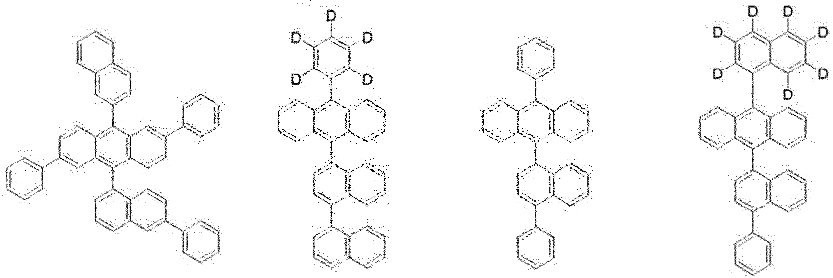

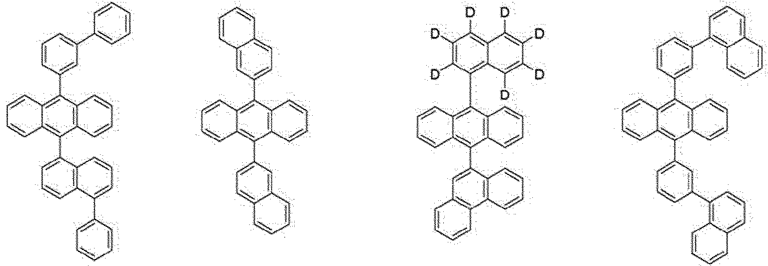

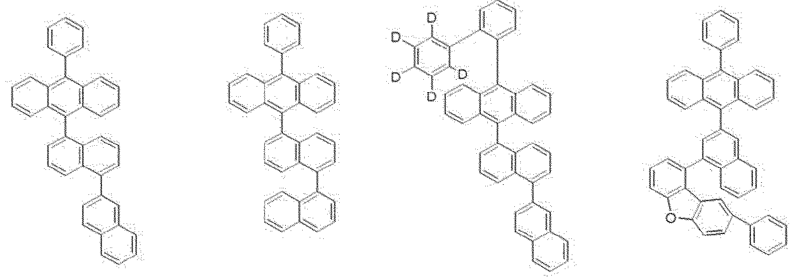

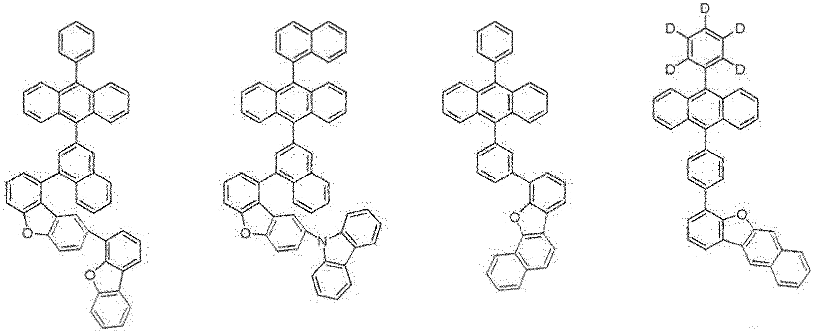

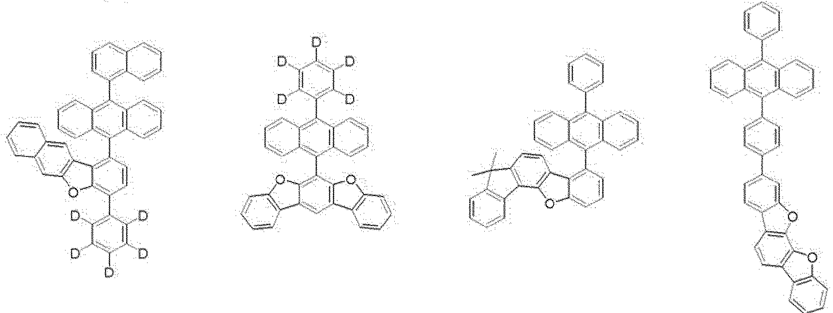

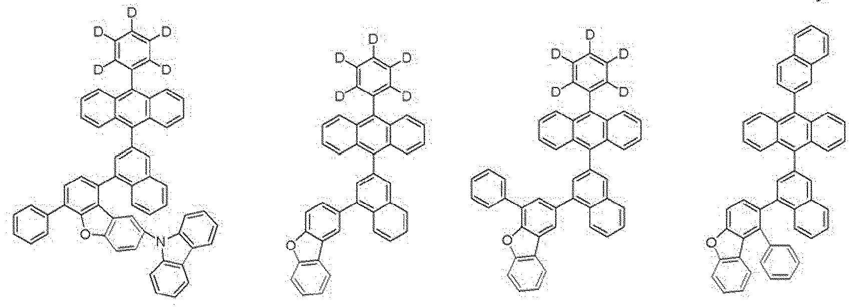

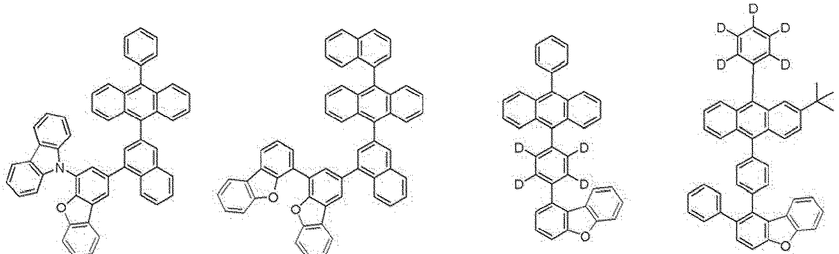

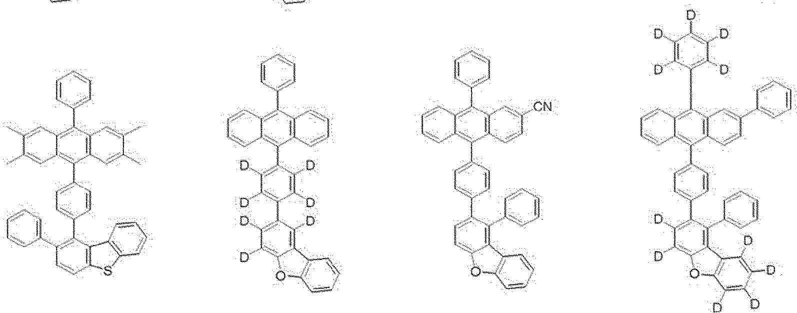

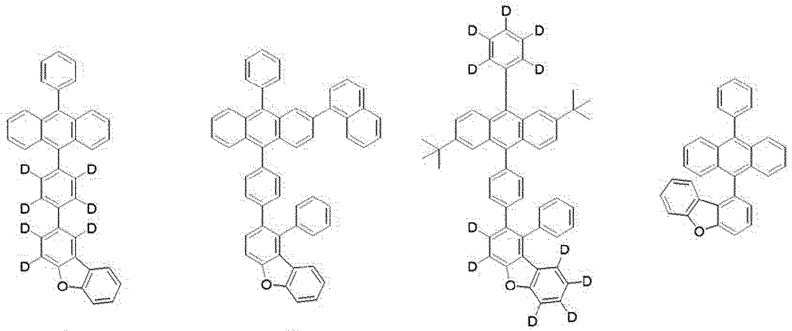

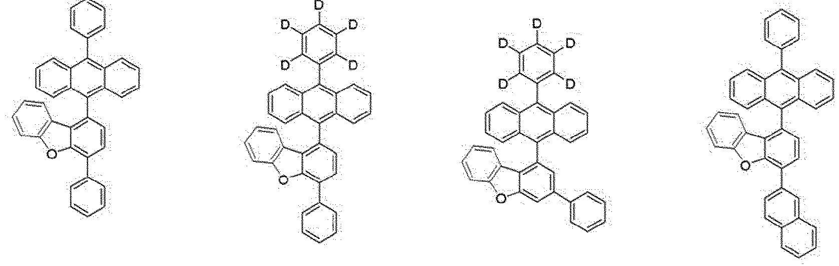

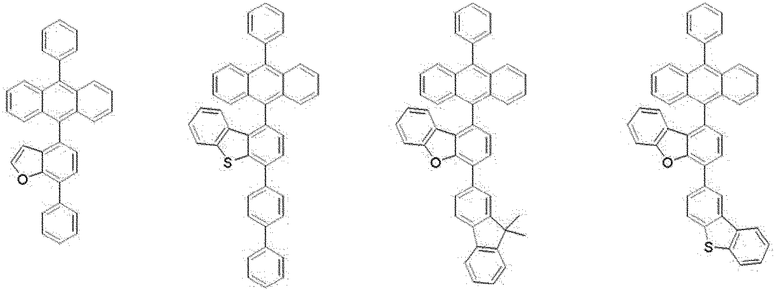

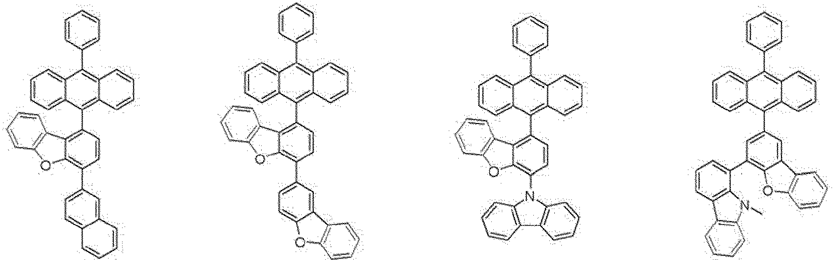

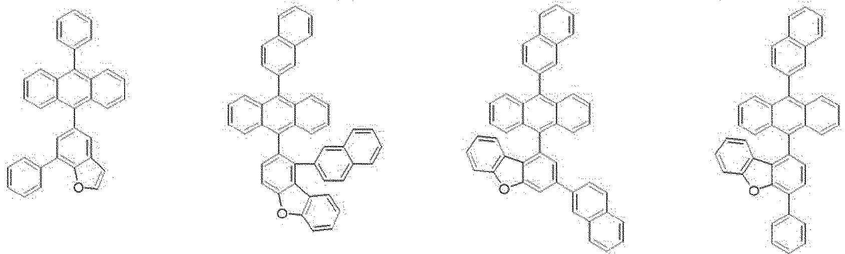

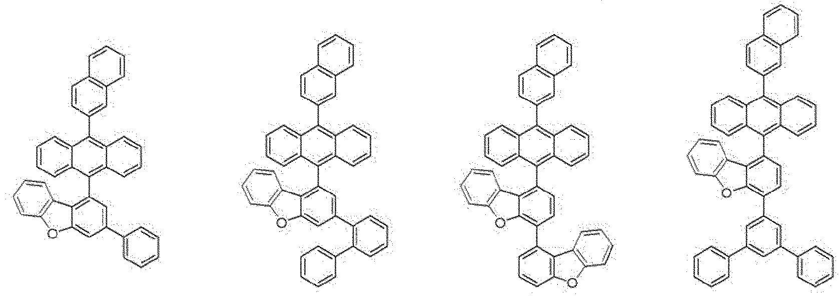

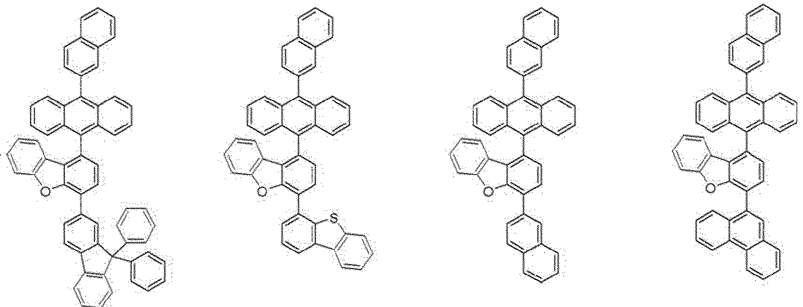

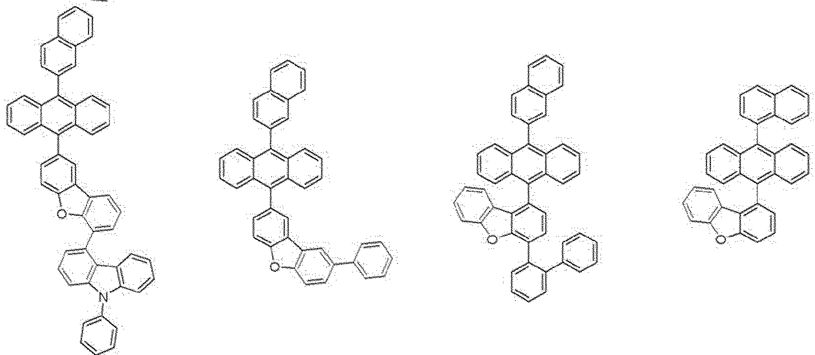

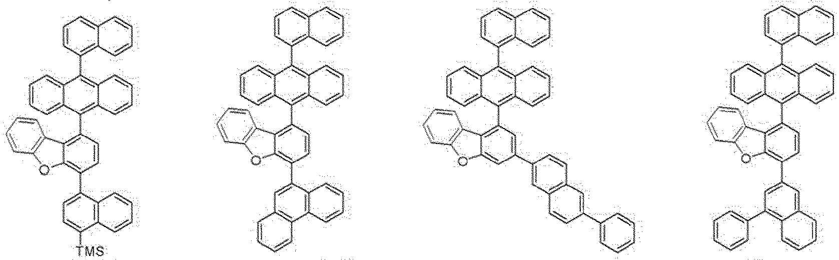

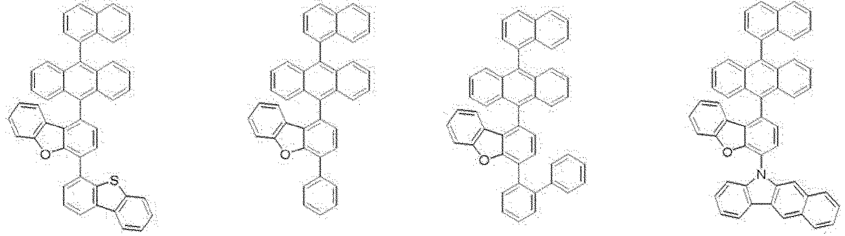

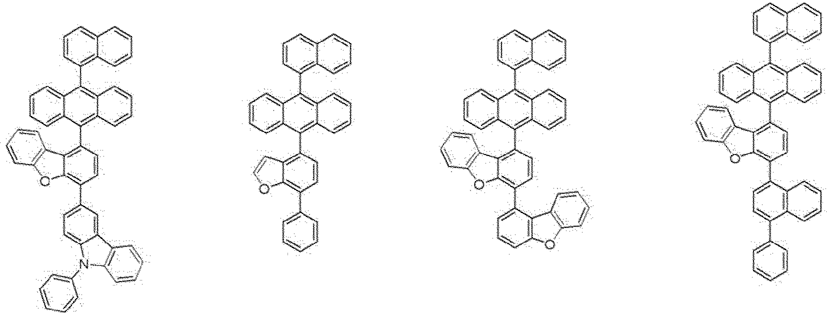

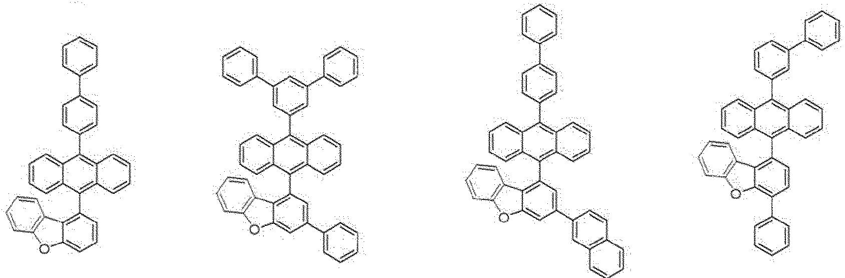

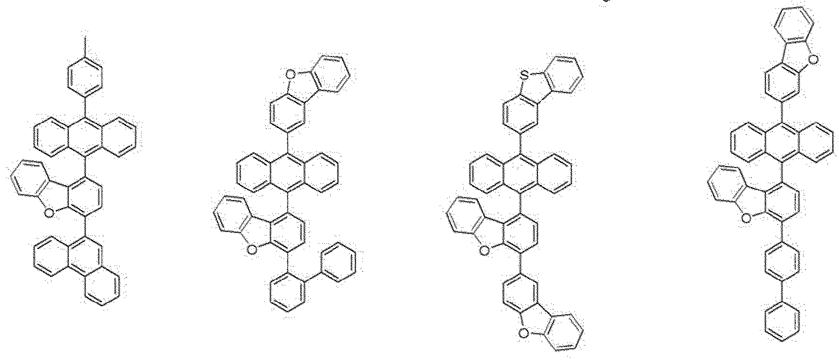

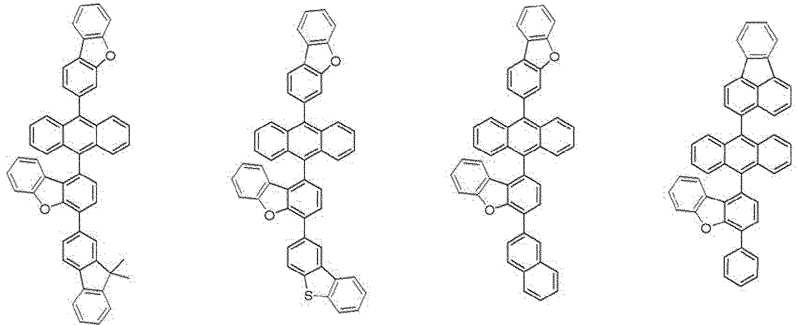

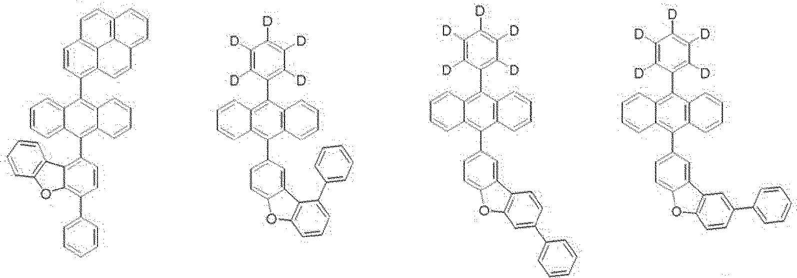

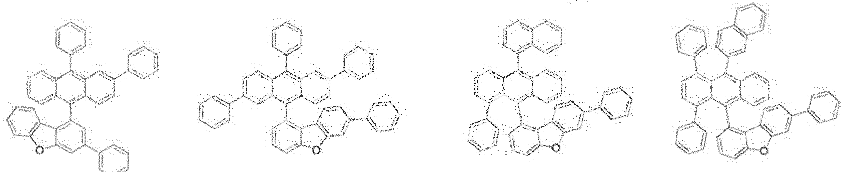

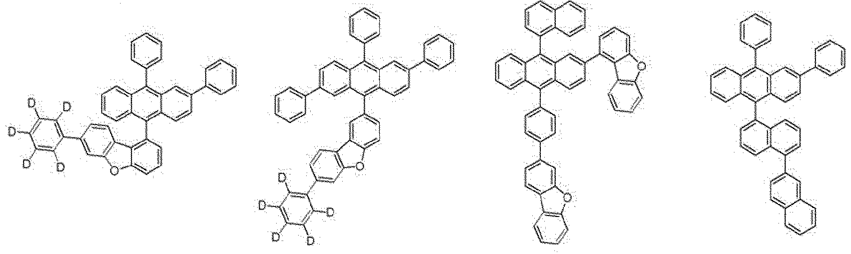

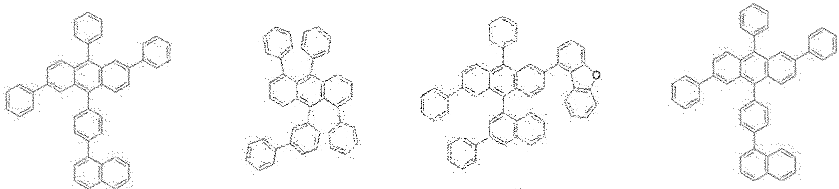

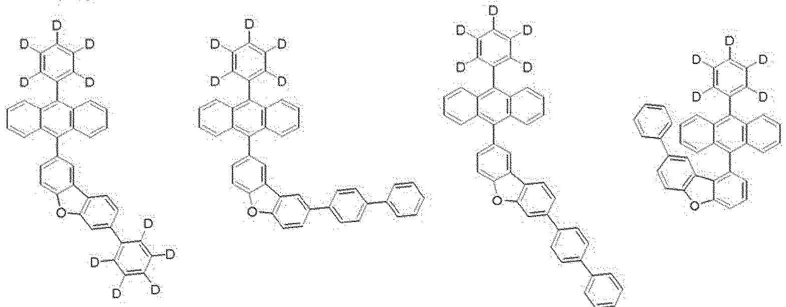

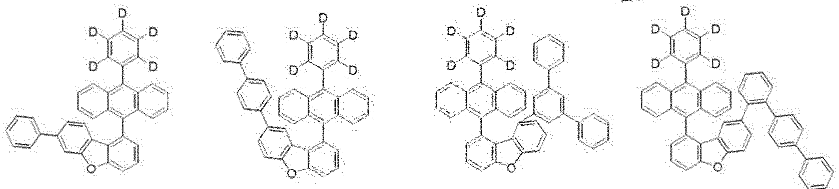

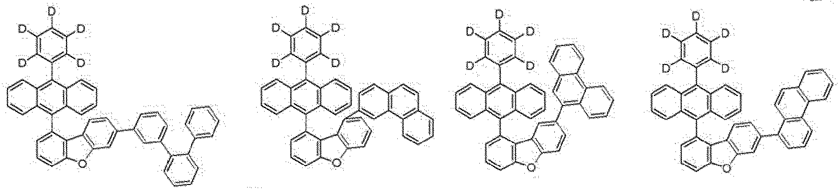

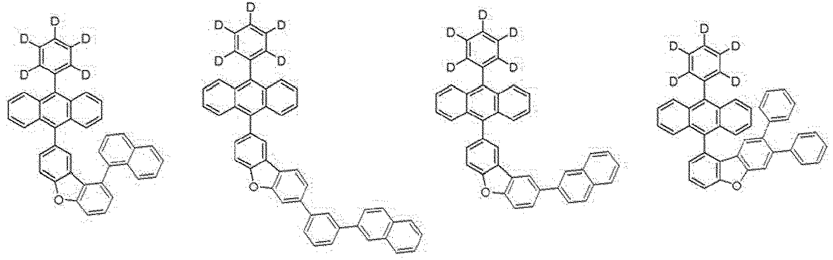

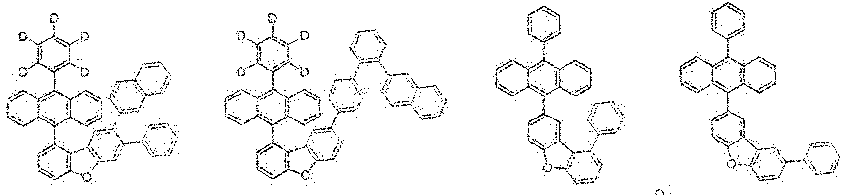

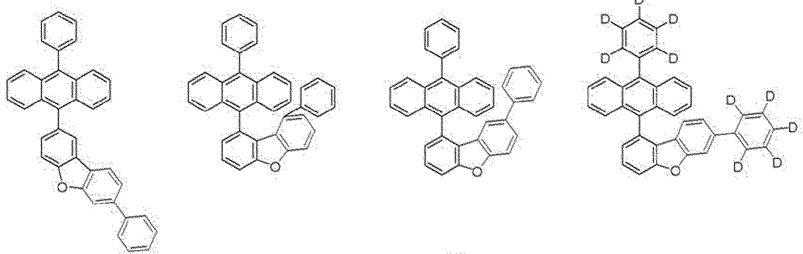

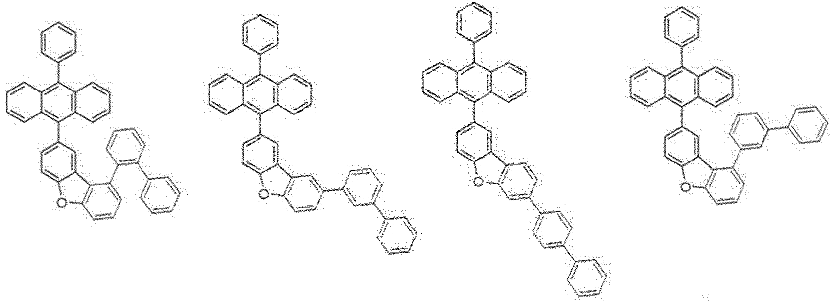

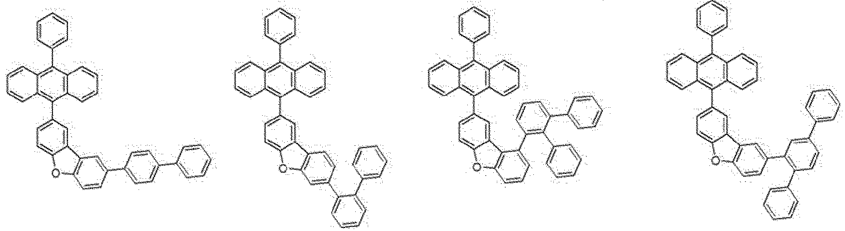

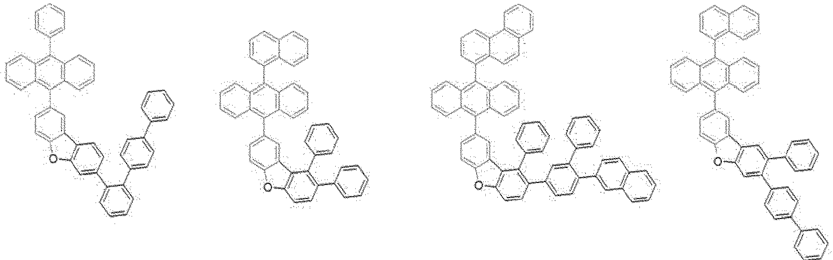

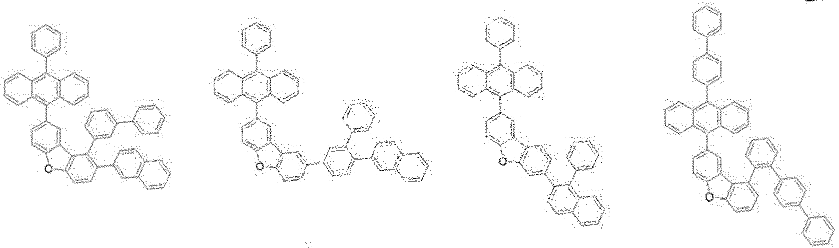

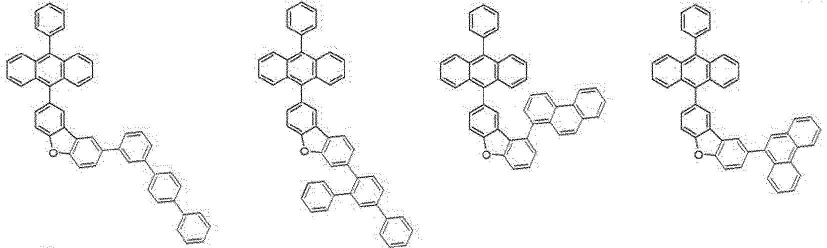

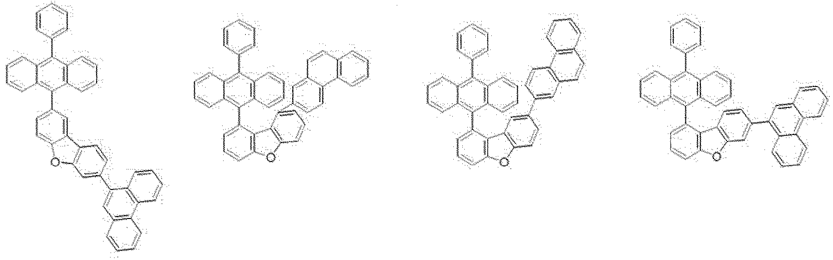

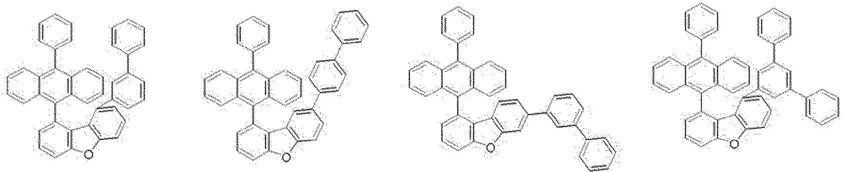

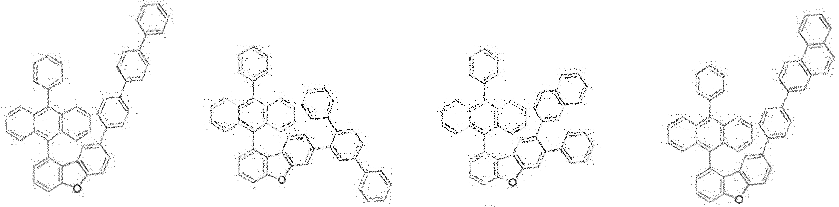

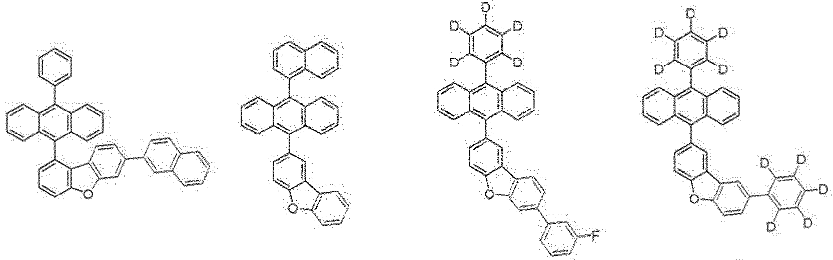

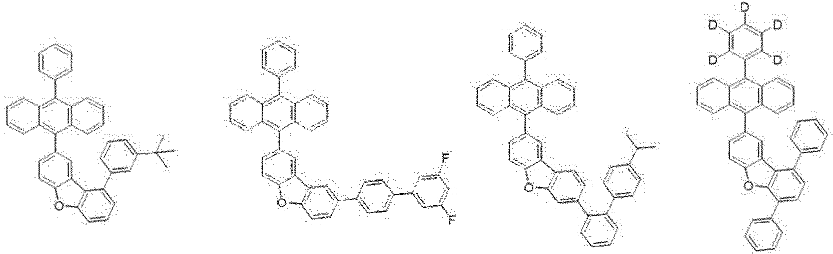

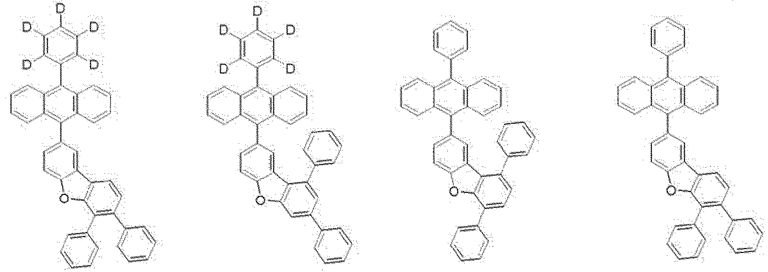

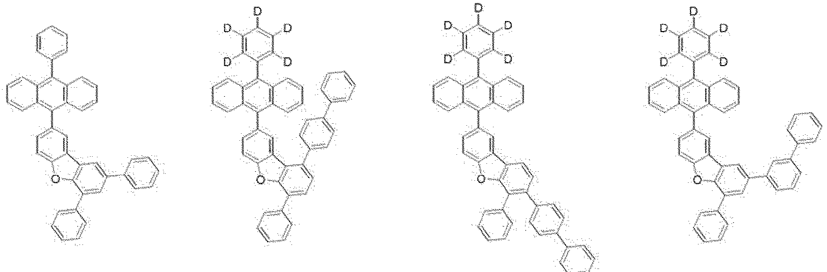

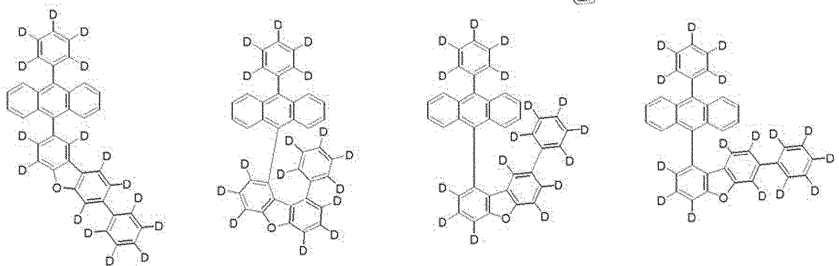

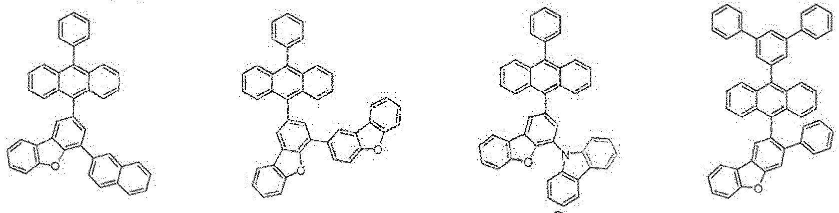

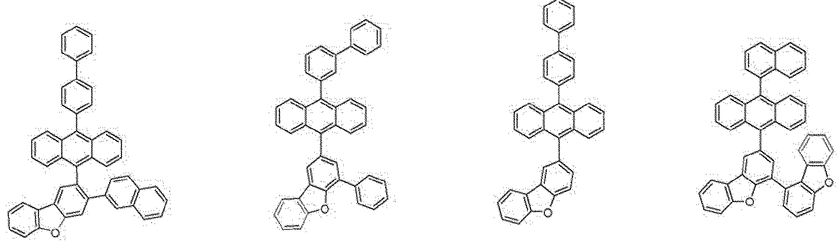

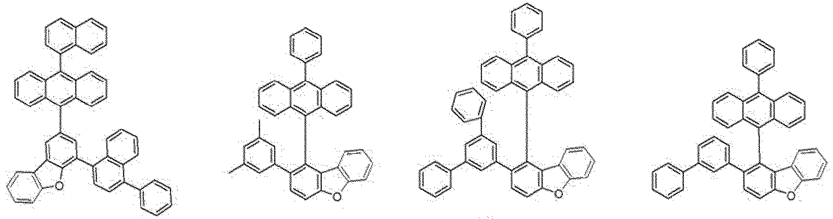

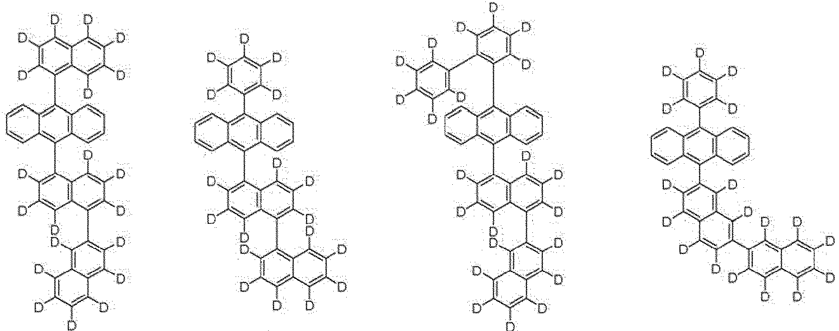

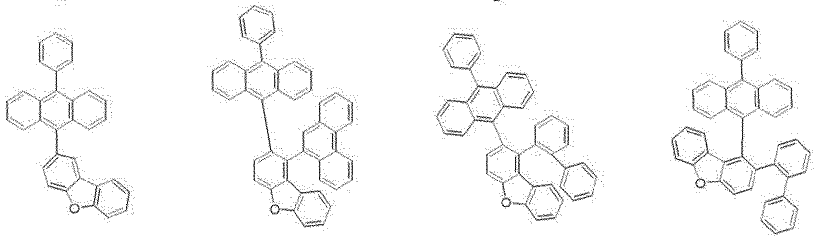

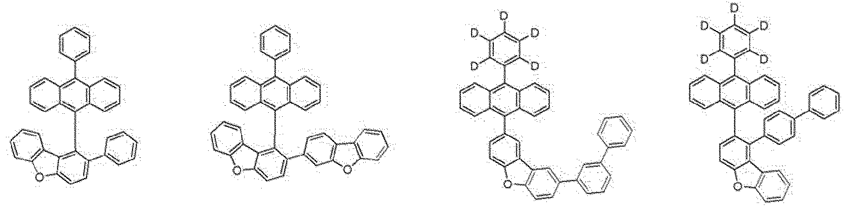

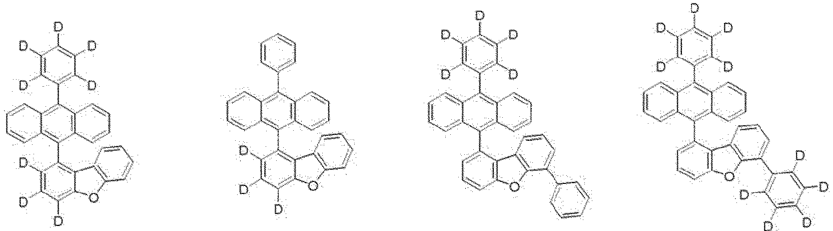

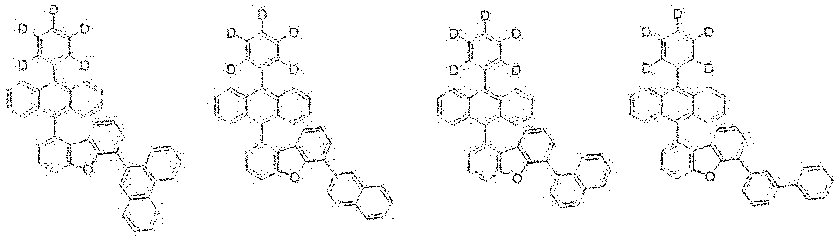

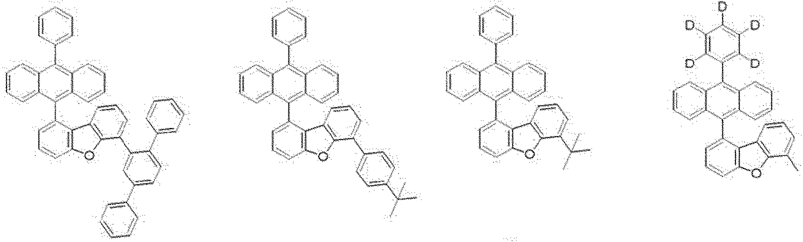

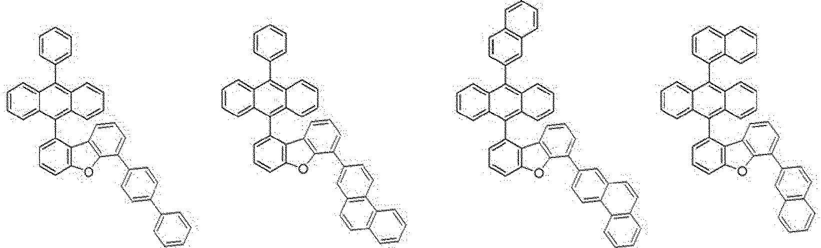

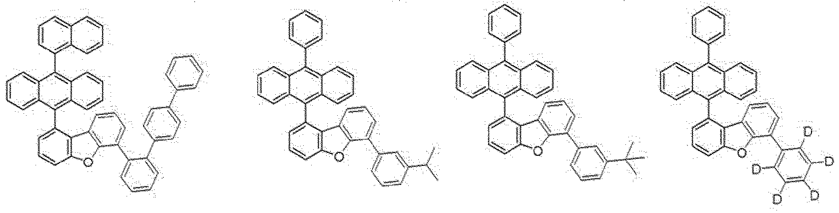

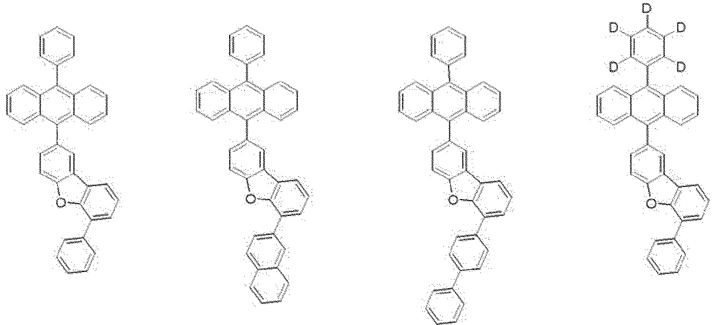

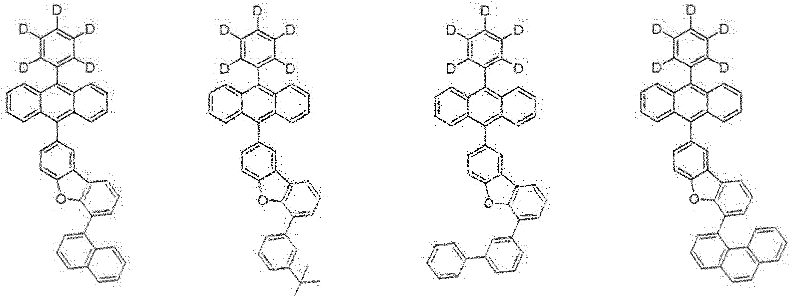

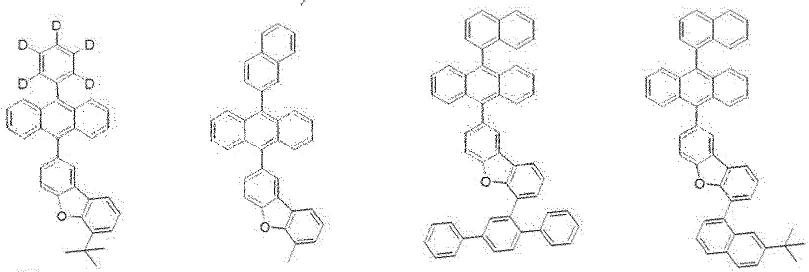

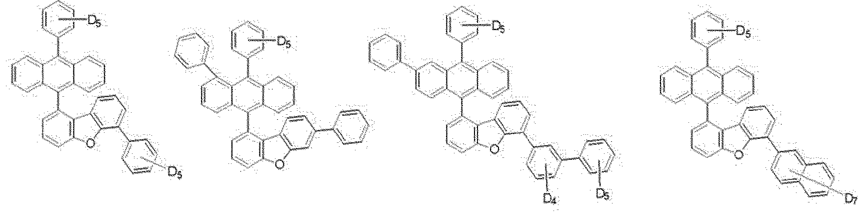

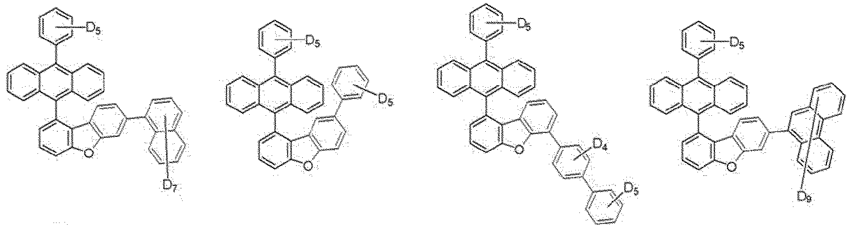

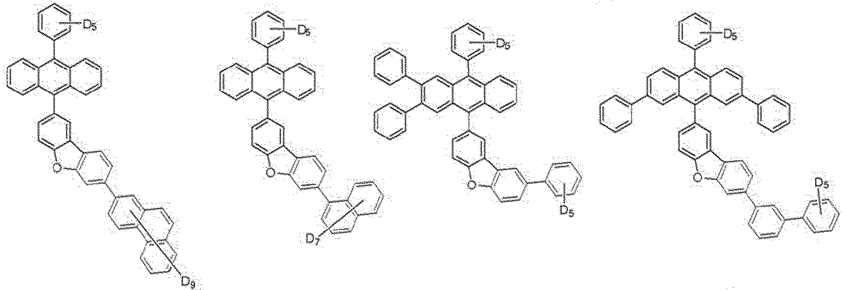

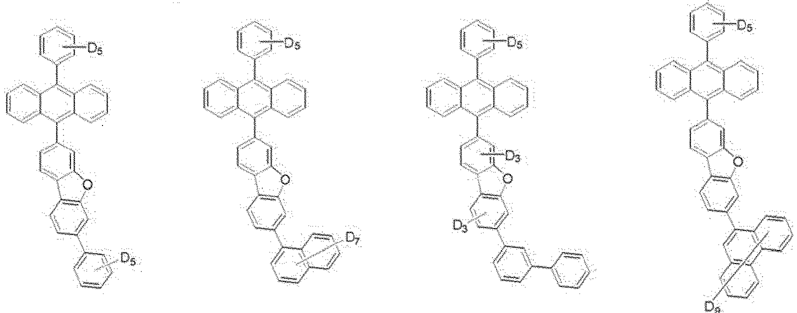

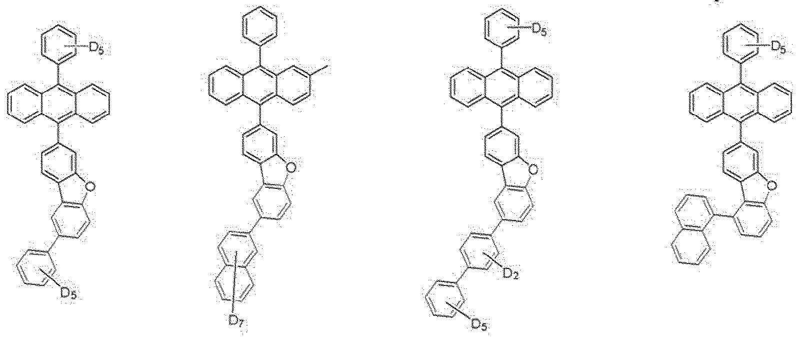

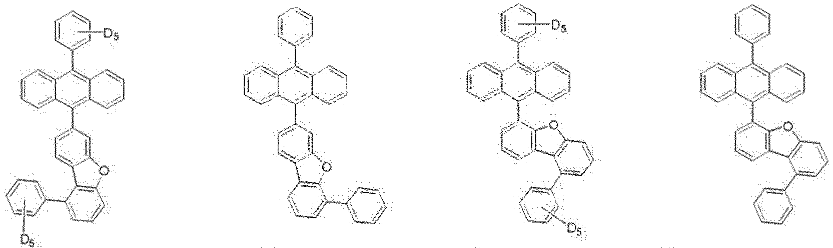

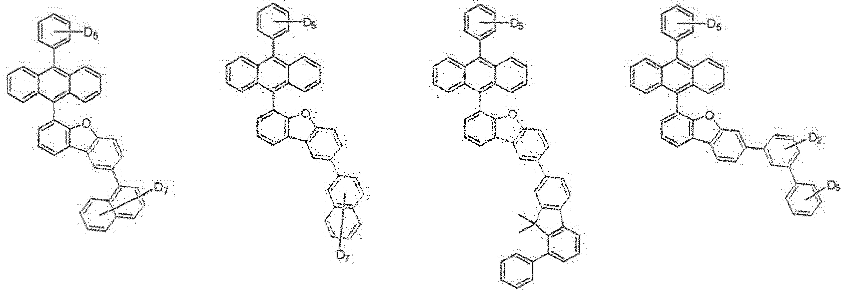

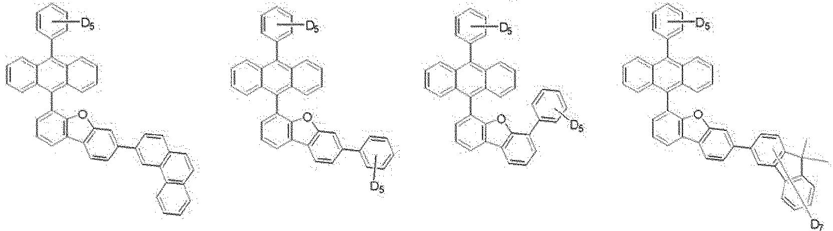

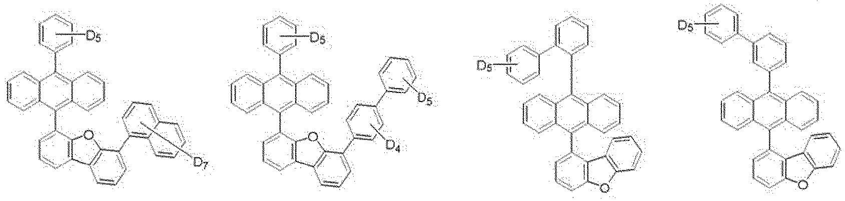

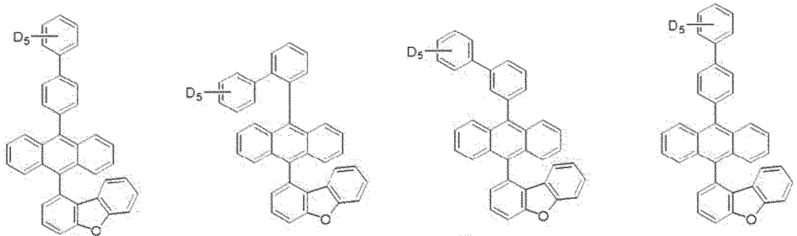

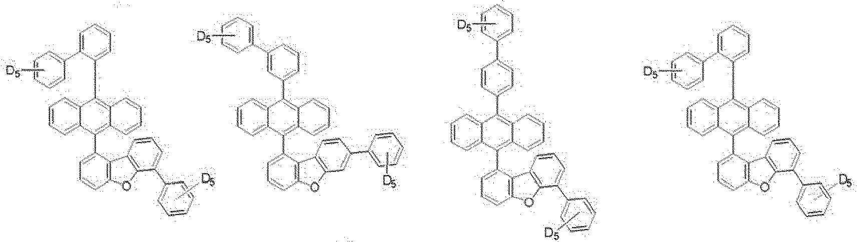

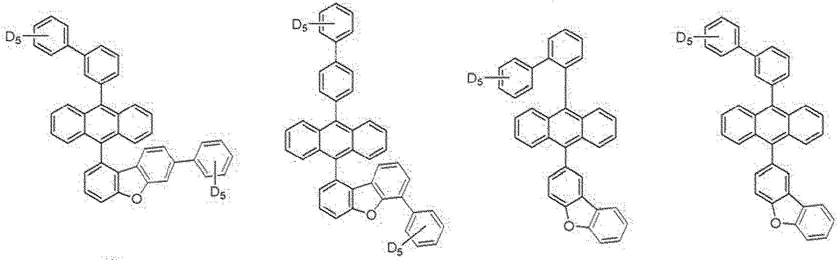

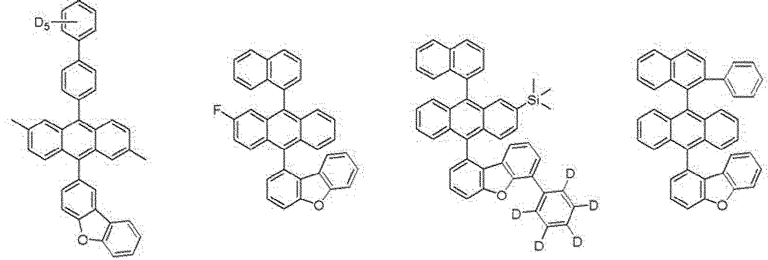

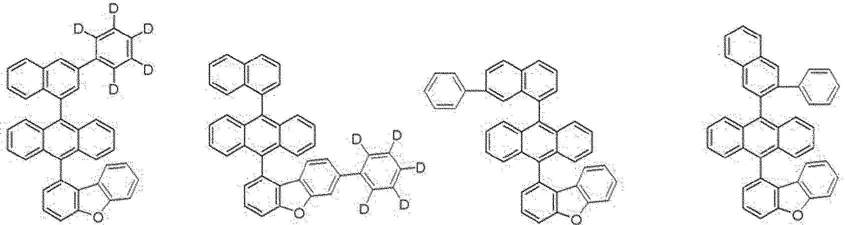

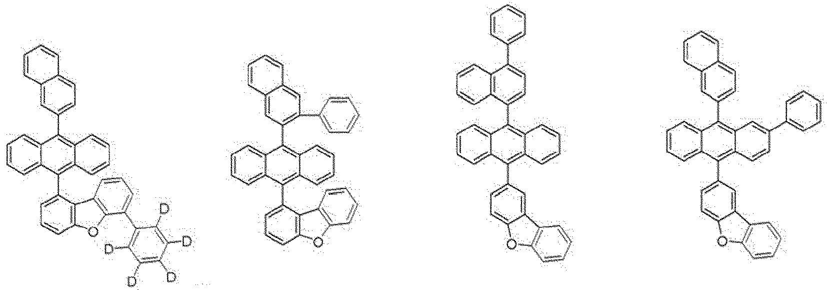

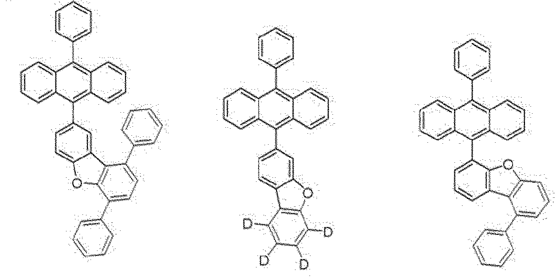

In addition, the organic layer of the organic light-emitting device according to the present invention may be formed in a single layer structure, but may be formed in a multilayer structure in which two or more organic layers are laminated. For example, the organic layer may have a structure including a hole injecting layer, a hole transport layer, a hole blocking layer, a light-emitting layer, an electron blocking layer, an electron transport layer, an electron injecting layer and the like. However, the structure is not limited thereto, and may also include a smaller or larger number of organic layers, and a preferred organic material layer structure of the organic light-emitting device according to the present invention will be described in more detail in examples to be described later.

Hereinafter, one embodiment of the organic light-emitting device according to the present invention will be described in more detail.

The organic light-emitting device of the present invention includes an anode, a hole transport layer, a light-emitting layer, an electron transport layer and a cathode. As necessary, the organic light-emitting device of the present invention may further include a hole injecting layer between the anode and the hole transport layer, and an electron injecting layer between the electron transport layer and the cathode. In addition thereto, one or two intermediate layers may be further formed, a hole blocking layer or an electron blocking layer may be further formed, and as described above, organic layers having various functions such as a capping layer may be further included depending on the device properties.

Meanwhile, the specific structure of the organic light-emitting device according to one embodiment of the present invention, a method for manufacturing the same, and the materials of each organic layer may be examined as follows.

First, a material for an anode electrode is coated on a substrate to form an anode. Herein, substrates used in common organic light-emitting devices may be used as the substrate, and organic substrates or transparent plastic substrates having excellent transparency, surface smoothness, handling readiness and waterproofness are preferred. As the material for an anode electrode, indium tin oxide (ITO), indium zinc oxide (IZO), tin oxide (SnO₂), zinc oxide (ZnO) or the like, which is transparent and has excellent conductivity, is used.

A hole injecting layer material is coated on the anode electrode by vacuum thermal deposition or spin coating to form a hole injecting layer. Then, a hole transport layer material is coated on the hole injecting layer by vacuum thermal deposition or spin coating to form a hole transport layer.

The hole injecting layer material is not particularly limited as long as it is commonly used in the art. Examples thereof may include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD) and the like.

The hole transport layer material is not particularly limited as well as long as it is commonly used in the art. Examples thereof may include N,N'-bis(3-methylphenyl)-N,N'-diphenyl-(1,1-biphenyl)-4,4'-diamine (TPD), N,N'-di(naphthalen-1-yl)-N,N'-diphenylbenzidine (α-NPD) and the like.

Subsequently, a hole auxiliary layer and a light-emitting layer are sequentially laminated on the hole transport layer, and a hole blocking layer may be optionally formed as a thin film on the light-emitting layer using a method of vacuum deposition or spin coating. When holes pass through an organic light-emitting layer and flow into a cathode, lifespan and efficiency of a device are reduced, and the hole blocking layer performs a role of preventing this problem by using a material having a very low highest occupied molecular orbital (HOMO) level. The hole blocking material used herein is not particularly limited, but needs to have higher ionization potential than a light-emitting compound while having an electron transport ability. Representative examples thereof may include BAlq, BCP, TPBI and the like.

As a material used for the hole blocking layer, BAlq, BCP, Bphen, TPBI, TAZ, BeBq₂, OXD-7, Liq and the like may be used, however, the material is not limited thereto.

After depositing an electron transport layer on the hole blocking layer using a method of vacuum deposition or spin coating, an electron injecting layer is formed thereon, and a metal for forming a cathode is vacuum thermal deposited on the electron injecting layer to form a cathode, and as a result, the organic light-emitting device according to one embodiment of the present invention is completed.

Herein, as the metal for forming a cathode, lithium (Li), magnesium (Mg), aluminum (Al), aluminum-lithium (Al-Li), calcium (Ca), magnesium-indium (Mg-In), magnesium-silver (Mg-Ag) or the like may be used, and in order to obtain a top emission-type light-emitting device, a transmissive cathode using ITO or IZO may be used.

As a material for the electron transport layer, known electron transport materials functioning to stably transport electrons injected from the cathode may be used. Examples of the known electron transport material may include materials such as quinoline derivatives, particularly tris(8-quinolinolato)aluminum (Alq₃), TAZ, BAlq, beryllium bis(benzoquinolin-10-olate) (Bebq₂) and oxadiazole derivatives (PBD, BMD, BND and the like).

In addition, each of the organic layers may be formed using a monomolecular deposition method or solution process. Herein, the monomolecular deposition method refers to a method of forming a thin film by evaporating a material used for forming each of the layers through heating and the like under vacuum or reduced pressure, and the solution process refers to a method of forming a thin film by mixing a material used for forming each of the layers with a solvent, and then applying a method such as ink-jet printing, roll-to-roll coating, screen printing, spray coating, dip coating or spin coating on the mixture.

In addition, the organic light-emitting device of the present invention may be used in devices selected from flat panel display devices, flexible display devices, monochromatic or white flat panel lighting devices, monochromatic or white flexible lighting devices, display devices for vehicles, display devices for virtual or augmented reality, and the like.

Hereinafter, preferred synthesis examples of compounds and device examples are provided in order to help understand the present invention. However, the following examples are for illustrative purposes only, and the scope of the present invention is not limited thereby.

### Synthesis Example 1: Synthesis of [Compound 1]

### Synthesis Example 1-1: Synthesis of A-1

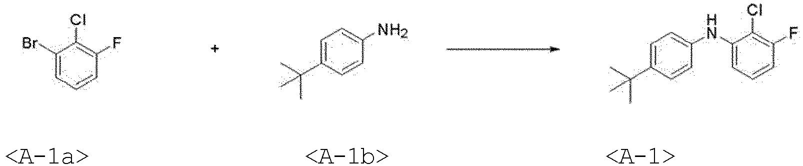

<A-1a> (45 g), <A-1b> (32 g), tris(dibenzylideneacetone)dipalladium(0) (3.94 g), sodium tertiary butoxide (41.3 g), bis(diphenylphosphino)-1,1'-binaphthyl (2.68 g) and toluene (450 mL) were introduced to a reactor, and then the mixture was stirred under reflux for 5 hours. After cooling the mixture to room temperature, ethyl acetate and water were introduced thereto, and then the organic layer was separated. The result was purified by silica gel chromatography to obtain <A-1> (38.5 g, 64.5%).

### Synthesis Example 1-2: Synthesis of A-2

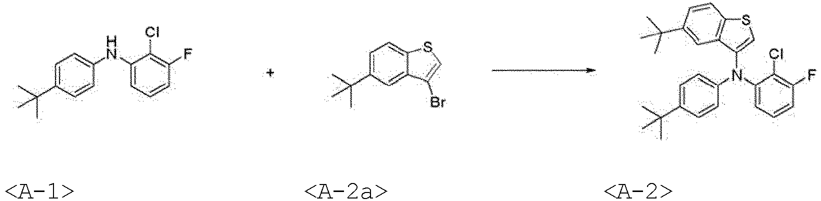

<A-1> (38 g), <A-2a> (36.8 g), bis(tri-tertiary-butylphosphine)palladium(0) (1.4 g), sodium tertiary butoxide (26.3 g) and toluene (400 mL) were introduced to a reactor, and then the mixture was stirred under reflux for 16 hours. After cooling the mixture to room temperature, ethyl acetate and water were introduced thereto, and then the organic layer was separated. The result was purified by silica gel chromatography to obtain <A-2> (36.7 g, 57.6%).

### Synthesis Example 1-3: Synthesis of A-3

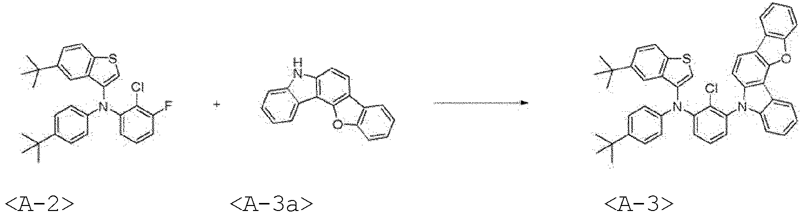

<A-2> (35 g), <A-3a> (18.4 g), cesium carbonate (76.7 g) and dimethylformamide (350 mL) were introduced to a reactor, and then the mixture was stirred under reflux for 8 hours. After cooling the mixture to room temperature, ethyl acetate and water were introduced thereto, and then the organic layer was separated. The result was purified by silica gel chromatography to obtain <A-3> (38 g, 73.1%).

### Synthesis Example 1-4: Synthesis of [Compound 1]

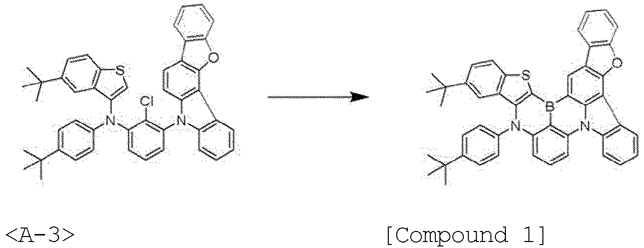

<A-3> (38 g) and toluene (400 mL) were introduced to a reactor, and then a 2 M tertiary butyllithium pentane solution (79 mL) was added dropwise thereto at -78°C. The mixture was stirred for 2 hours after raising the temperature to 60°C, and then pentane was completely removed by blowing nitrogen thereinto at 60°C. After lowering the temperature to -78°C, boron tribromide (5.1 mL) was added dropwise thereto. After raising the temperature to room temperature, the mixture was stirred for 2 hours, and N,N-diisopropylethylamine (9.4 mL) was added dropwise thereto after lowering the temperature to 0°C. After raising the temperature to 120°C, the mixture was stirred for 16 hours. After cooling the mixture to room temperature, an aqueous 10% sodium acetate solution and ethyl acetate were introduced thereto. The organic layer was separated and concentrated under reduced pressure. The result was purified by silica gel chromatography to obtain [Compound 1] (5.4 g, 14.7%).
MS (MALDI-TOF): m/z 676.27 [M⁺]

### Synthesis Example 2: Synthesis of [Compound 5]

### Synthesis Example 2-1: Synthesis of B-1

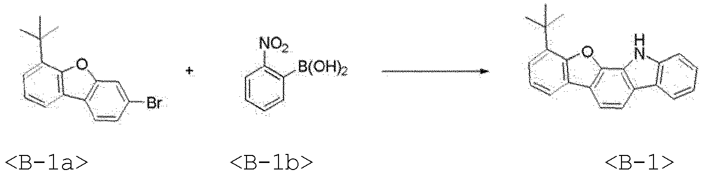

<B-1a> (45 g), <B-1b> (23.5 g), tetrakispalladium(0) (5.1 g), potassium carbonate (41.3 g), toluene (500 mL), ethanol (300 mL) and water (200 mL) were introduced to a reactor, and then the mixture was stirred under reflux for 8 hours. After cooling the mixture to room temperature, ethyl acetate and water were introduced thereto, and then the organic layer was separated. The organic layer was concentrated under reduced pressure, then triphenylphosphine (12.5 g) and methyl pyrrolidone (400 mL) were introduced thereto, and then the mixture was stirred under reflux for 8 hours. The result was purified by silica gel chromatography to obtain <B-1> (41.7 g, 90.6%).

### Synthesis Example 2-2: Synthesis of B-2

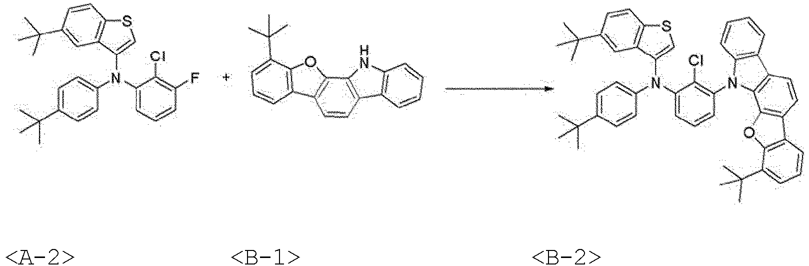

<B-2> was obtained by performing a synthesis in the same manner as in Synthesis Example 1-3, except that <B-1> was used instead of <A-3a>. (Yield 79.6%)

### Synthesis Example 2-3: Synthesis of [Compound 5]

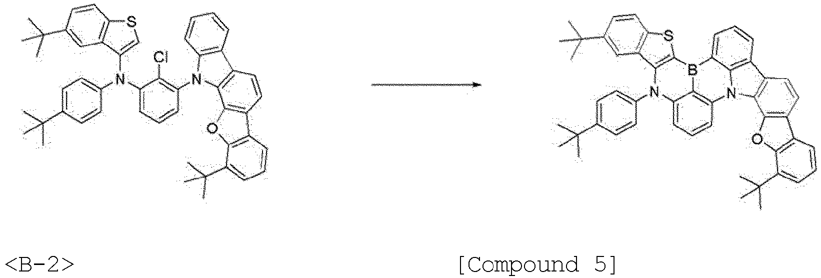

[Compound 5] was obtained by performing a synthesis in the same manner as in Synthesis Example 1-4, except that <B-2> was used instead of <A-3>. (Yield 15.4%)
MS (MALDI-TOF): m/z 732.33 [M⁺]

### Synthesis Example 3: Synthesis of [Compound 7]

### Synthesis Example 3-1: Synthesis of C-1

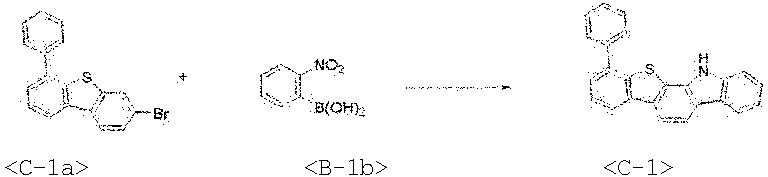

<C-1> was obtained by performing a synthesis in the same manner as in Synthesis Example 2-1, except that <C-1a> was used instead of <B-1a>. (Yield 81.4%)

### Synthesis Example 3-2: Synthesis of C-2

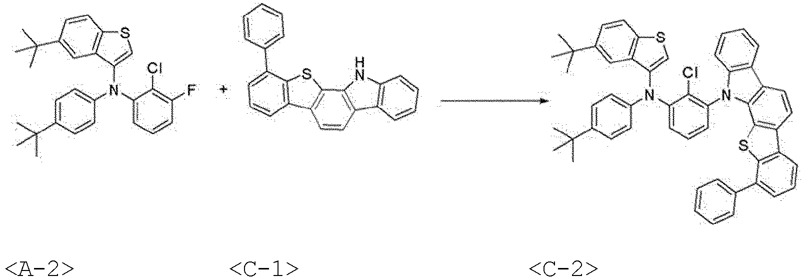

<C-2> was obtained by performing a synthesis in the same manner as in Synthesis Example 1-3, except that <C-1> was used instead of <A-3a>. (Yield 74.5%)

### Synthesis Example 3-3: Synthesis of [Compound 7]

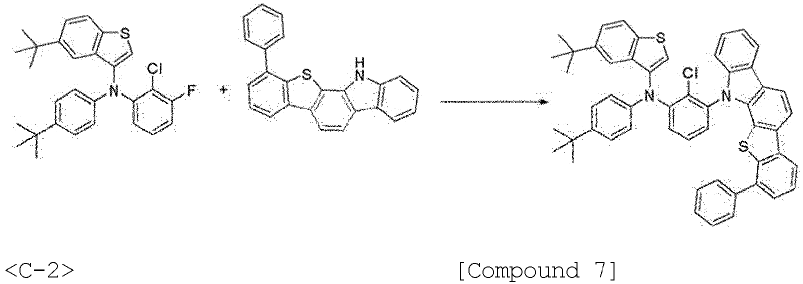

[Compound 7] was obtained by performing a synthesis in the same manner as in Synthesis Example 1-4, except that <C-2> was used instead of <A-3>. (Yield 16%)
MS (MALDI-TOF): m/z 768.28 [M⁺]

### Synthesis Example 4: Synthesis of [Compound 9]

### Synthesis Example 4-1: Synthesis of D-1

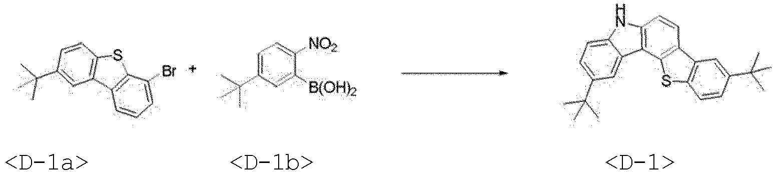

<D-1> was obtained by performing a synthesis in the same manner as in Synthesis Example 2-1, except that <D-1a> was used instead of <B-1a>, and <D-1b> was used instead of <B-1b>. (Yield 74.2%)

### Synthesis Example 4-2: Synthesis of D-2

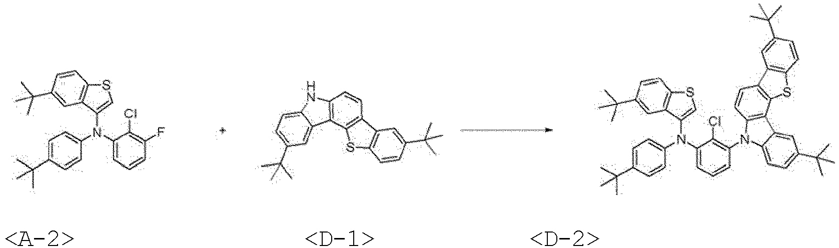

<D-2> was obtained by performing a synthesis in the same manner as in Synthesis Example 1-3, except that <D-1> was used instead of <A-3a>. (Yield 65.7%)

### Synthesis Example 4-3: Synthesis of [Compound 9]

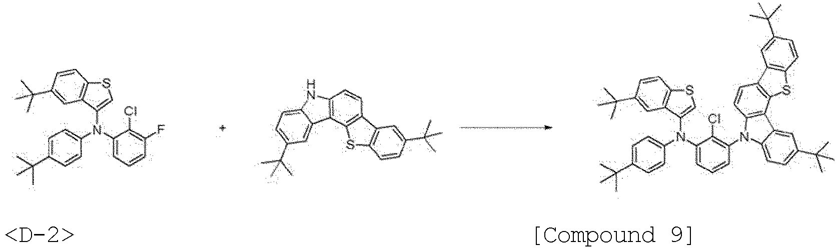

[Compound 9] was obtained by performing a synthesis in the same manner as in Synthesis Example 1-4, except that <D-2> was used instead of <A-3>. (Yield 10.1%)
MS (MALDI-TOF): m/z 804.37 [M⁺]

### Synthesis Example 5: Synthesis of [Compound 33]

### Synthesis Example 5-1: Synthesis of E-1

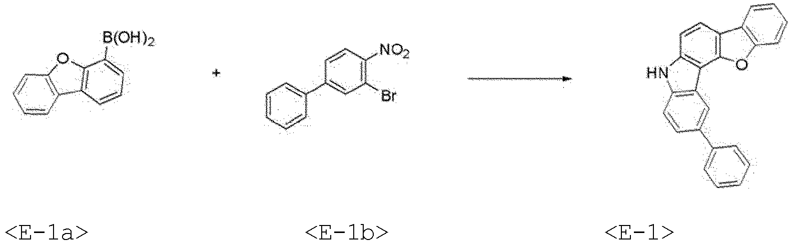

<E-1> was obtained by performing a synthesis in the same manner as in Synthesis Example 2-1, except that <E-1a> was used instead of <B-1a>, and <E-1b> was used instead of <B-1b>. (Yield 88.7%)

### Synthesis Example 5-2: Synthesis of E-2

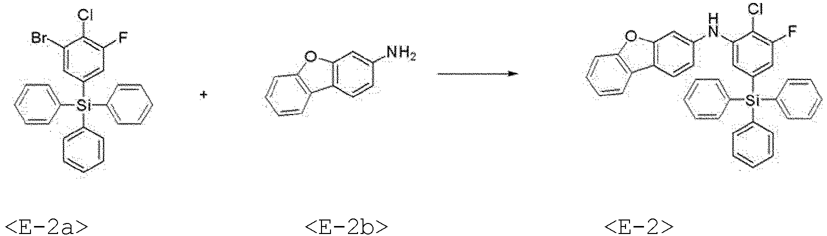

<E-2> was obtained by performing a synthesis in the same manner as in Synthesis Example 1-1, except that <E-2a> was used instead of <A-1a>, and <E-2b> was used instead of <A-1b>. (Yield 81.6%)

### Synthesis Example 5-3: Synthesis of E-3

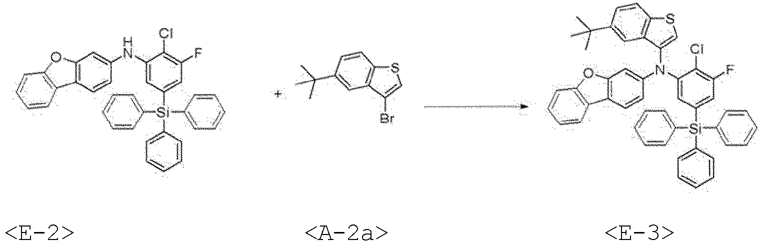

<E-3> was obtained by performing a synthesis in the same manner as in Synthesis Example 1-2, except that <E-2> was used instead of <A-1>. (Yield 74.1%)

### Synthesis Example 5-4: Synthesis of E-4

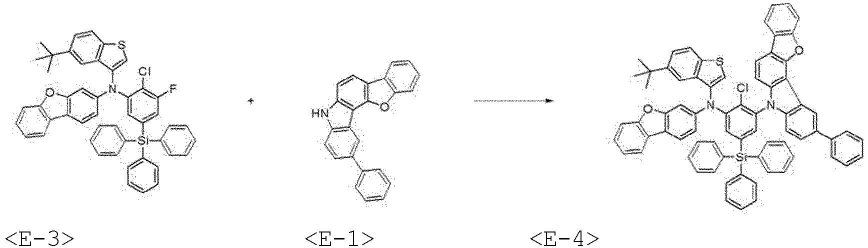

<E-4> was obtained by performing a synthesis in the same manner as in Synthesis Example 1-3, except that <E-3> was used instead of <A-2>, and <E-1> was used instead of <A-3a>. (Yield 65.4%)

### Synthesis Example 5-5: Synthesis of [Compound 33]

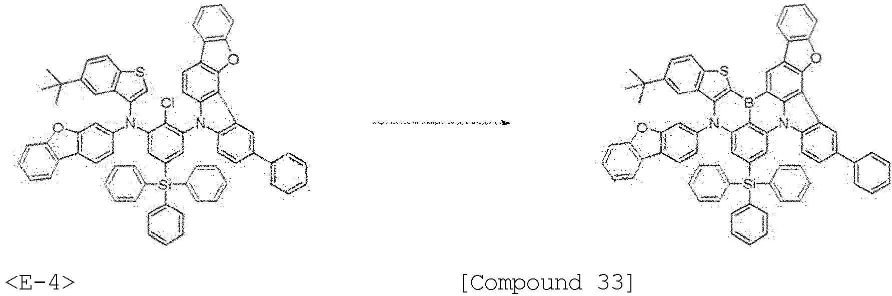

[Compound 33] was obtained by performing a synthesis in the same manner as in Synthesis Example 1-4, except that <E-4> was used instead of <A-3>. (Yield 8.4%)
MS (MALDI-TOF): m/z 1044.34 [M⁺]

### Synthesis Example 6: Synthesis of [Compound 20]

### Synthesis Example 6-1: Synthesis of F-1

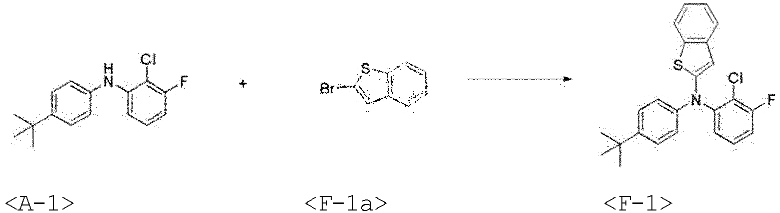

<F-1> was obtained by performing a synthesis in the same manner as in Synthesis Example 1-2, except that <F-1a> was used instead of <A-2a>. (Yield 88.4%)

### Synthesis Example 6-2: Synthesis of F-2

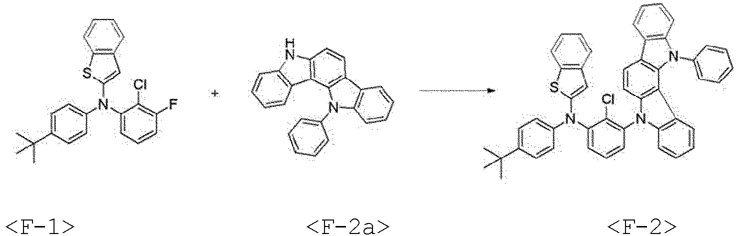

<F-2> was obtained by performing a synthesis in the same manner as in Synthesis Example 1-3, except that <F-1> was used instead of <A-2>, and <F-2a> was used instead of <A-3a>. (Yield 71.5%)

### Synthesis Example 6-3: Synthesis of [Compound 20]

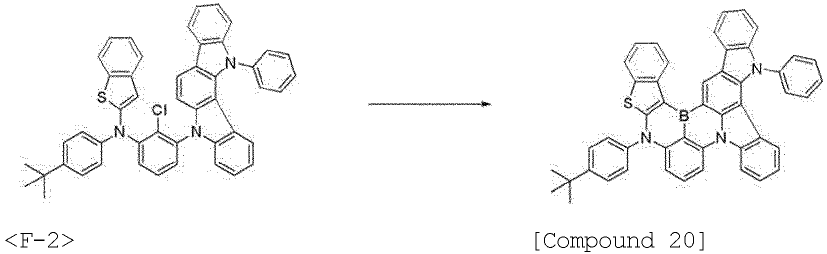

[Compound 20] was obtained by performing a synthesis in the same manner as in Synthesis Example 1-4, except that <F-2> was used instead of <A-3>. (Yield 10.5%)
MS (MALDI-TOF): m/z 695.26 [M⁺]

### Synthesis Example 7: Synthesis of [Compound 34]

### Synthesis Example 7-1: Synthesis of G-1

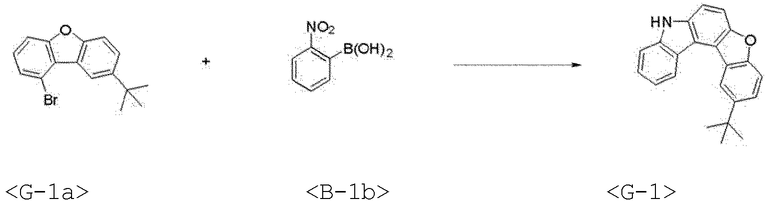

<G-1> was obtained by performing a synthesis in the same manner as in Synthesis Example 2-1, except that <G-1a> was used instead of <B-1a>. (Yield 74.7%)

### Synthesis Example 7-2: Synthesis of G-2

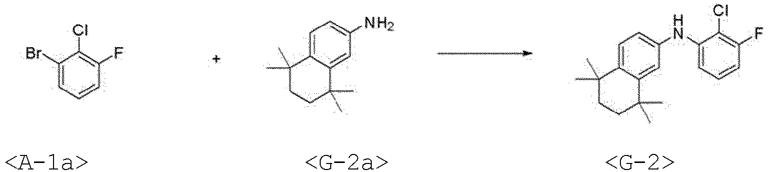

<G-2> was obtained by performing a synthesis in the same manner as in Synthesis Example 1-1, except that <G-2a> was used instead of <A-1b>. (Yield 88.6%)

### Synthesis Example 7-3: Synthesis of G-3

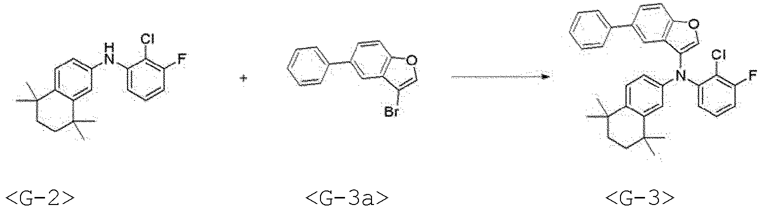

<G-3> was obtained by performing a synthesis in the same manner as in Synthesis Example 1-2, except that <G-2> was used instead of <A-1>, and <G-3a> was used instead of <A-2a>. (Yield 68.7%)

### Synthesis Example 7-4: Synthesis of G-4

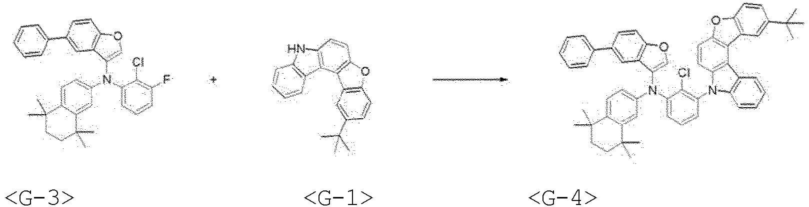

<G-4> was obtained by performing a synthesis in the same manner as in Synthesis Example 1-3, except that <G-3> was used instead of <A-2>, and <G-1> was used instead of <A-3a>. (Yield 74.3%)

### Synthesis Example 7-5: Synthesis of [Compound 34]

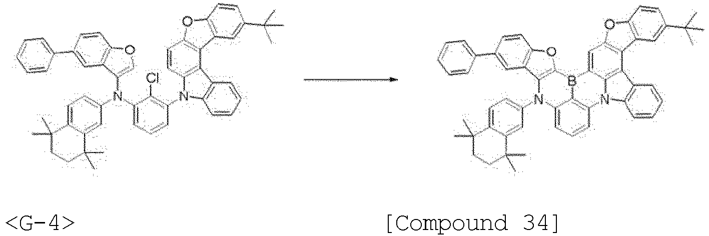

[Compound 34] was obtained by performing a synthesis in the same manner as in Synthesis Example 1-4, except that <G-4> was used instead of <A-3>. (Yield 12.7%)
MS (MALDI-TOF): m/z 790.37 [M]

### Examples 1 to 7: Manufacture of Organic Light-Emitting Device

An ITO glass was patterned to have a light-emitting area of 2 mm×2 mm, and then cleaned. The ITO glass was installed in a vacuum chamber, and after setting the base pressure at 1×10⁻⁷ torr, an electron acceptor of the following Structural Formula [Acceptor-1] and [Chemical Formula F] were deposited (100 Å) as a hole injecting layer on the ITO so that [Acceptor-1] and [Chemical Formula F] have a deposition ratio of 2:98. [Chemical Formula F] was deposited (550 Å) as a hole transport layer, and then, [Chemical Formula G] was deposited (50 Å) as an electron blocking layer. As a light-emitting layer, a host [BH-1] described below and the compound of the present invention (2 wt%) were mixed and deposited (200 Å), and after that, [Chemical Formula H] was deposited (50 Å) as a hole blocking layer, [Chemical Formula E-1] and [Chemical Formula E-2] were deposited (250 Å) in a ratio of 1:1 as an electron transport layer, [Chemical Formula E-2] was deposited (10 Å) as an electron injecting layer, and Al was deposited (1000 Å) in this order to manufacture an organic light-emitting device. Luminous characteristics of the organic light-emitting device were measured at 0.4 mA.

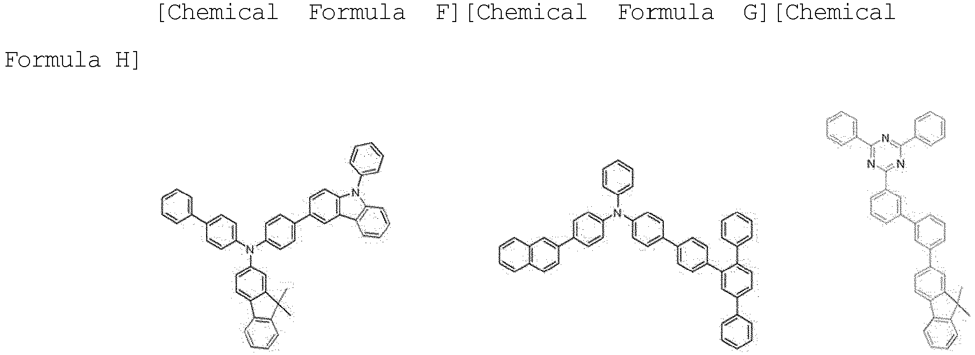

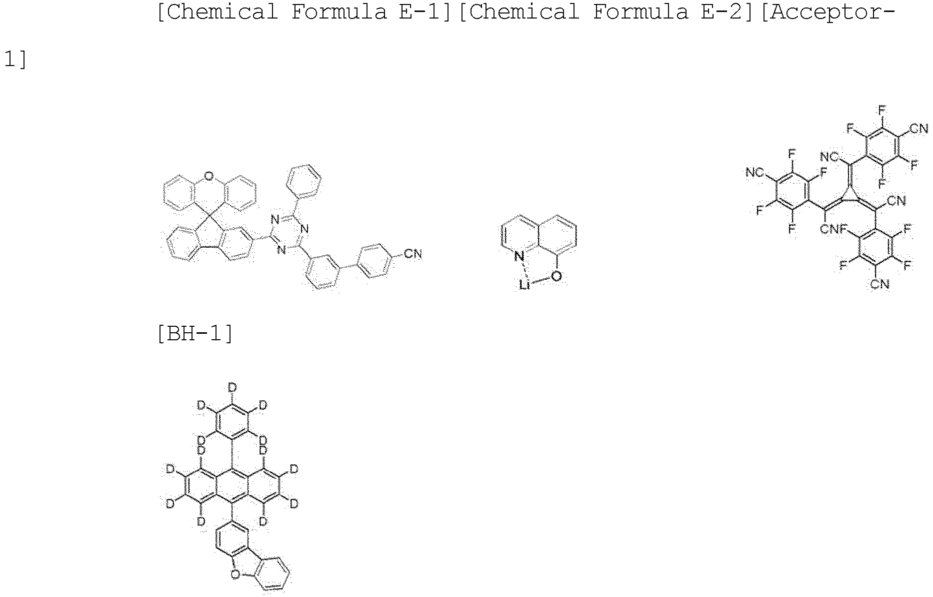

### Comparative Examples 1 to 3

Organic light-emitting devices were manufactured in the same manner as in Examples, except that [RD-1] to [RD-3] were used instead of the compounds used in Examples, and luminous characteristics of the organic light-emitting devices were measured at 0.4 mA. Structures of [RD-1] to [RD-3] are as follows.

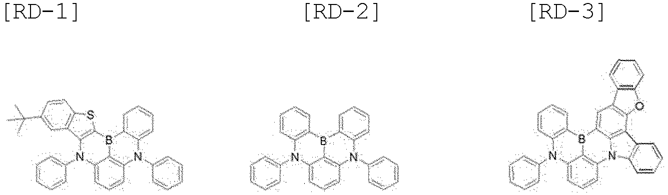

For each of the organic light-emitting devices manufactured according to Examples 1 to 7 and Comparative Examples 1 to 3, external quantum efficiency and lifespan were measured, and the results are shown in the following [Table 1].

**[Table 1]**

| Classification | Dopant | Efficiency (EQE, %) | Lifespan (T97, hr) |
|---|---|---|---|
| Example 1 | Compound 1 | 9.04 | 211 |
| Example 2 | Compound 5 | 8.63 | 214 |
| Example 3 | Compound 7 | 8.74 | 220 |
| Example 4 | Compound 9 | 9.11 | 226 |
| Example 5 | Compound 20 | 9.01 | 210 |
| Example 6 | Compound 33 | 9.14 | 212 |
| Example 7 | Compound 34 | 9.01 | 224 |
| Comparative Example 1 | RD-1 | 7.61 | 177 |
| Comparative Example 2 | RD-2 | 7.14 | 167 |
| Comparative Example 3 | RD-3 | 7.88 | 172 |

As shown in [Table 1], the devices employing the compound according to the present invention as a dopant compound of a light-emitting layer in the organic light-emitting device may achieve a high-efficiency and long-lifespan organic light-emitting device having excellent quantum efficiency and lifespan properties compared to the devices (Comparative Examples 1 to 3) employing compounds having structures contrasting with the characteristic structure of the compound according to the present invention.

### [Industrial Applicability]

The present invention relates to a polycyclic compound having a characteristic fused ring structure and an organic light-emitting device employing the same as a dopant of a light-emitting layer, and since an improved organic light-emitting device with high efficiency and long lifespan may be achieved using the compound according to the present invention, the device is industrially useful not only in lighting elements, but also in various display devices such as flat panel, flexible and wearable displays.

## Claims

1. A polycyclic compound represented by the following [Chemical Formula 1] or [Chemical Formula 2]: 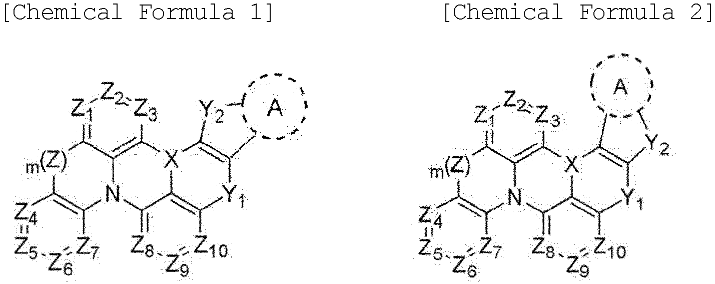 wherein, in [Chemical Formula 1] and [Chemical Formula 2],
X is B, P=O, P=S or Al;
Y₁ is NR₁, O, S, CR₂R₃, SiR₄R₅ or GeR₆R₇;
Y₂ is NR₈, O or S;
A is any one selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring and a substituted or unsubstituted fused ring of C₃-C₃₀ aliphatic ring and C₃-C₃₀ aromatic ring; and
at least one pair of neighboring two, Z₁ and Z₂, Z₂ and Z₃, Z₄ and Z₅, Z₅ and Z₄, and Z₆ and Z₇, among Z₁ to Z₇ are carbon atoms, and linked to two *s in [Structural Formula 1] at the same time to form a ring, 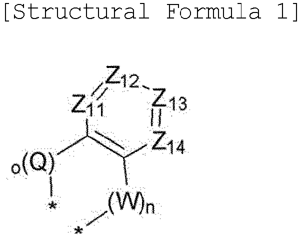
the rest of Z₁ to Z₇ not forming the ring and Z₈ to Z₁₄ are the same as or different from each other, and each independently CR₉ or N;
when Z₁ to Z₁₄ include a plurality of CR₉s, CR₉s are the same as or different from each other;
Z, Q and W are the same as or different from each other, and each independently NR₁₀, CR₁₁R₁₂, SiR₁₃R₁₄, GeR₁₅R₁₆, O or S;
R₁ to R₁₆ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group and a halogen group;
m is 0 or 1, and when m is 0, the carbon atom between Z and Z₁ and the carbon atom between Z and Z₄ are linked through a single bond;
o is 0 or 1, and when o is 0, the carbon atom between Z₁₁ and Q and the carbon atom linked to * are linked through a single bond;
n is 0 or 1, and when n is 0, the carbon atom between Z₁₄ and W and the carbon atom linked to * are linked through a single bond;
however, o+n≥1;
R₂ to R₁₆ are optionally linked to adjacent substituents to further form an alicyclic or aromatic monocyclic or polycyclic ring;
the adjacent plurality of R₉s are optionally linked to each other to further form an alicyclic or aromatic monocyclic or polycyclic ring;
R₂ and R₃, R₄ and R₅, R₆ and R₇, R₁₁ and R₁₂, R₁₃ and R₁₄, and R₁₅ and R₁₆ are each optionally linked to each other to further form an alicyclic or aromatic monocyclic or polycyclic ring; and
the 'substituted' in the 'substituted or unsubstituted' in [Chemical Formula 1], [Chemical Formula 2] and [Structural Formula 1] means being substituted with one, or two or more substituents selected from the group consisting of deuterium, a C₁-C₂₄ alkyl group, a C₁-C₂₄ halogenated alkyl group, a C₃-C₂₄ cycloalkyl group, a C₂ to C₂₄ alkenyl group, a C₂ to C₂₄ alkynyl group, a C₁-C₂₄ heteroalkyl group, a C₂ to C₂₄ heterocycloalkyl group, a C₆-C₃₀ aryl group, a C₇-C₃₀ arylalkyl group, a C₇-C₃₀ alkylaryl group, a C₂-C₃₀ heteroaryl group, a C₃-C₃₀ heteroarylalkyl group, a C₃-C₃₀ alkylheteroaryl group, a fused cyclic group of C₃-C₂₄ aliphatic ring and C₃-C₂₄ aromatic ring, a C₁-C₂₄ alkoxy group, a C₆-C₂₄ aryloxy group, a C₆-C₂₄ arylthionyl group, a C₁-C₄₀ amine group, a C₁-C₄₀ silyl group, a C₁-C₄₀ germanium group, a cyano group, a halogen group, a hydroxyl group and a nitro group, or being substituted with a substituent in which two or more of the above-mentioned substituents are linked, and hydrogens in the substituents are optionally substituted with one or more deuterium, and two or more adjacent substituents are optionally linked to each other to further form an alicyclic or aromatic monocyclic or polycyclic ring.

2. The polycyclic compound according to claim 1, wherein at least one of Z₁ to Z₇ and Z₁₁ to Z₁₄ in [Chemical Formula 1] and [Chemical Formula 2] is CR₉, and at least one of the plurality of R₉s is not hydrogen or deuterium.

3. The polycyclic compound according to claim 1, wherein [Chemical Formula 1] is represented by any one selected from the following [Chemical Formula 1-1] to [Chemical Formula 1-5]: 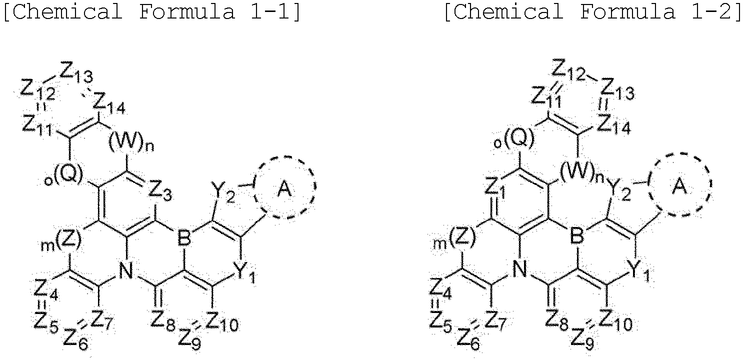 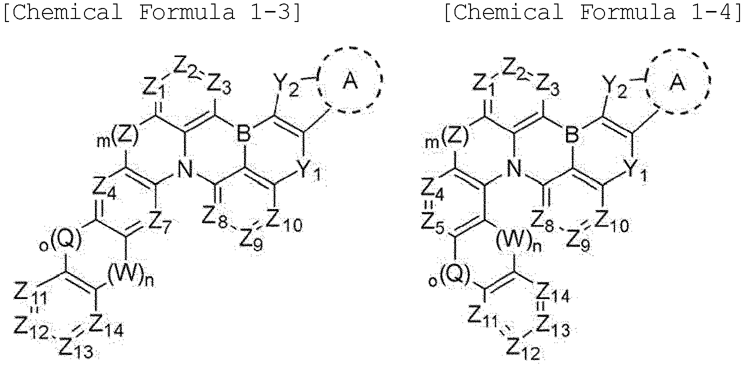 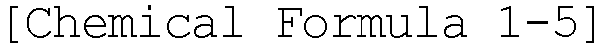 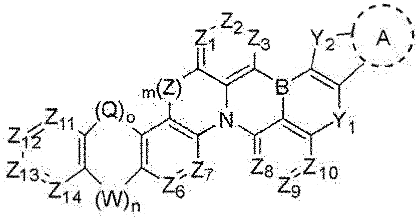 in [Chemical Formula 1-1] to [Chemical Formula 1-5],
Z, Q, W, Z₁ to Z₁₄, Y₁, Y₂, m, n, o and A have the same definitions as in [Chemical Formula 1] of claim 1.

4. The polycyclic compound according to claim 1, wherein [Chemical Formula 2] is represented by any one selected from the following [Chemical Formula 2-1] to [Chemical Formula 2-5]: 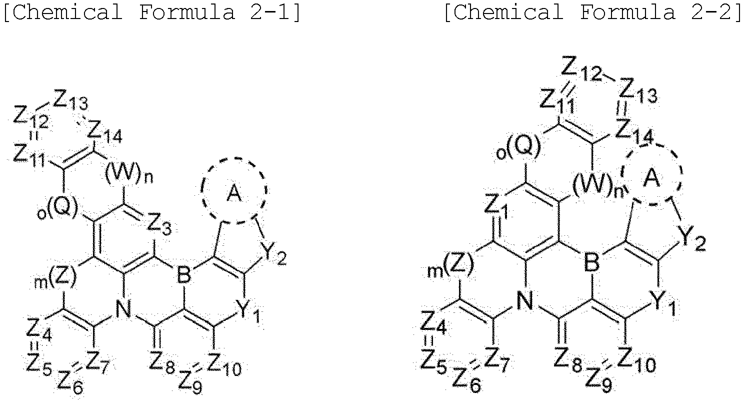 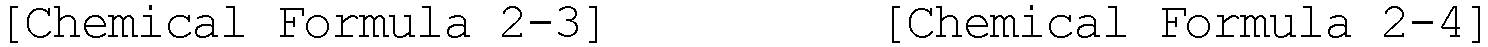 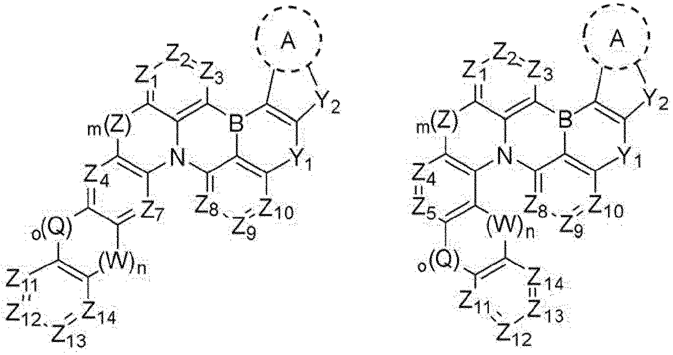 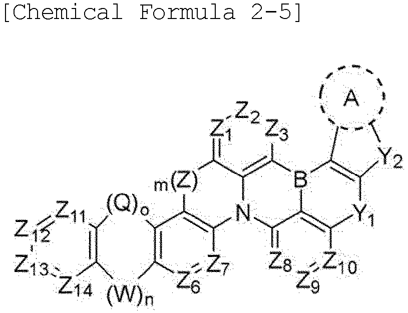 in [Chemical Formula 2-1] to [Chemical Formula 2-5],
Z, Q, W, Z₁ to Z₁₄, Y₁, Y₂, m, n, o and A have the same definitions as in [Chemical Formula 2] of claim 1.

5. The polycyclic compound according to claim 1, wherein [Chemical Formula 1] or [Chemical Formula 2] is any one selected from compounds represented by the following chemical formulae:

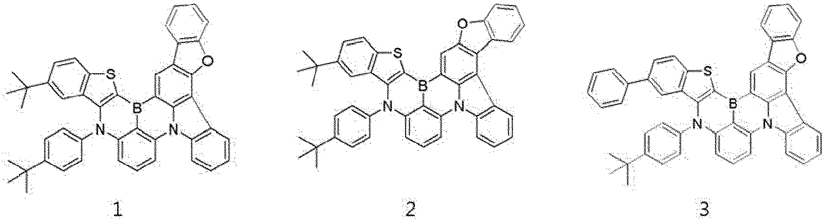

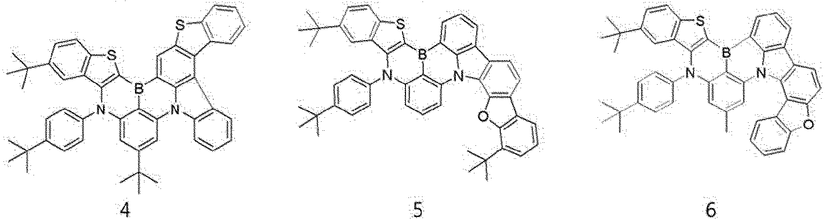

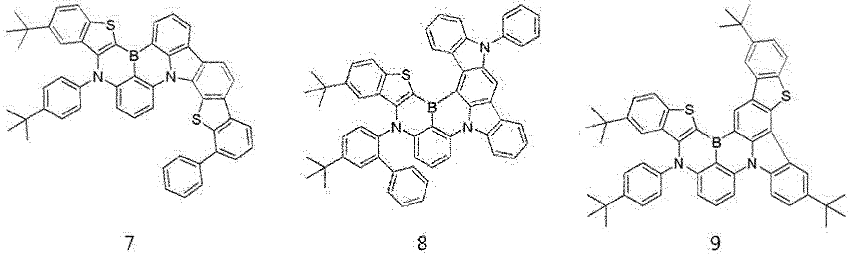

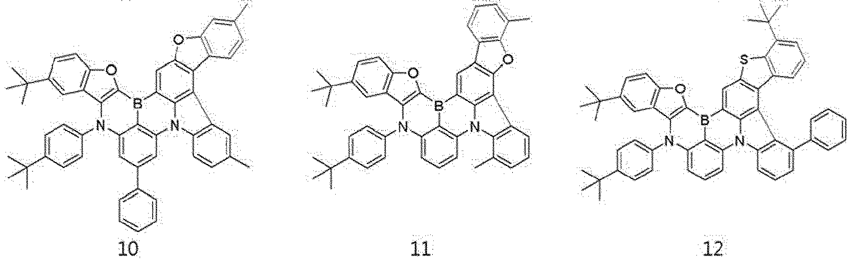

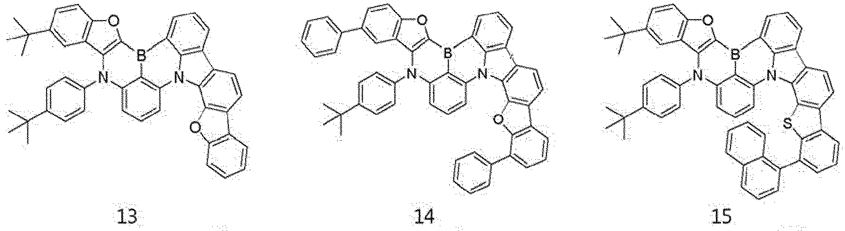

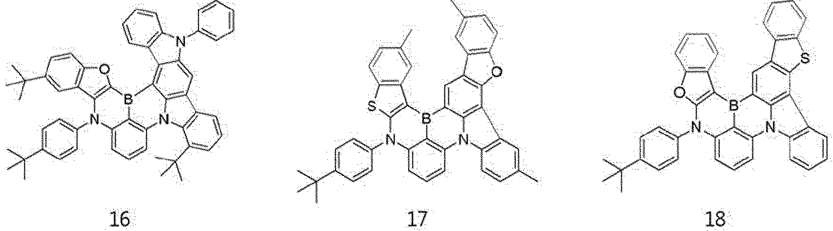

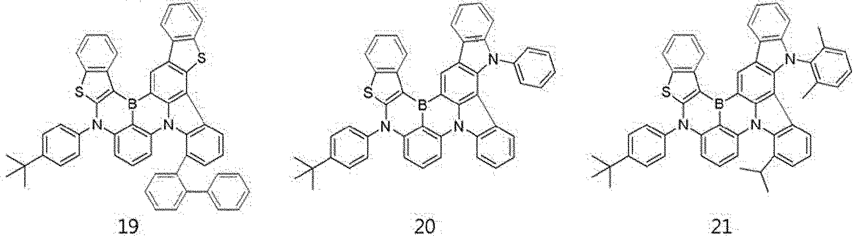

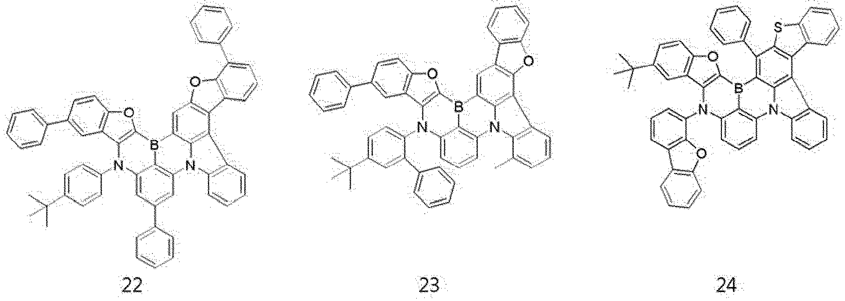

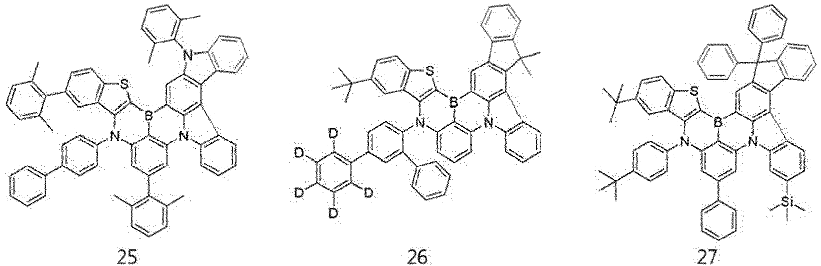

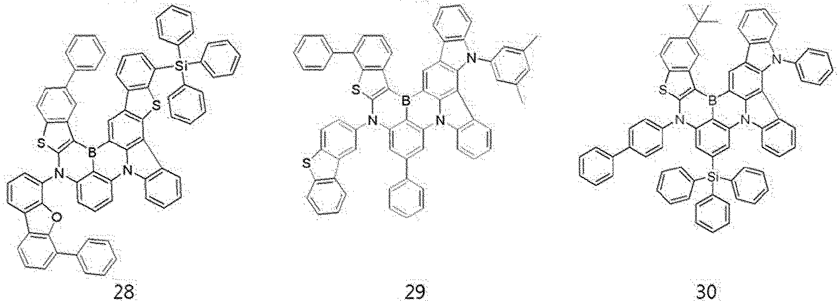

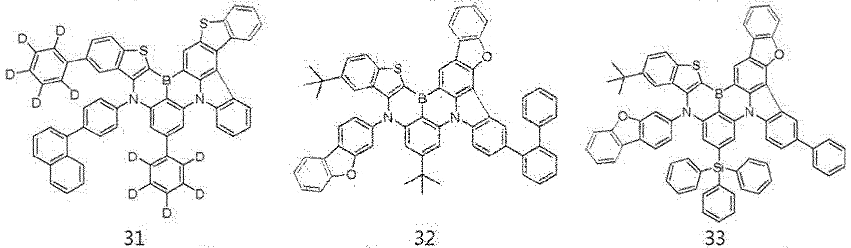

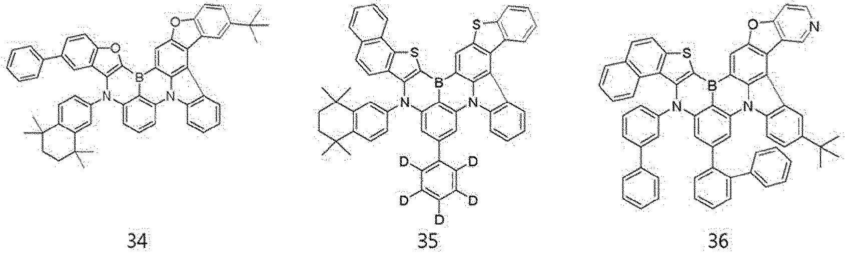

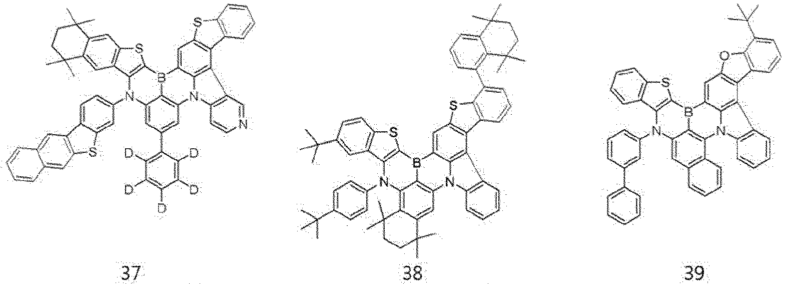

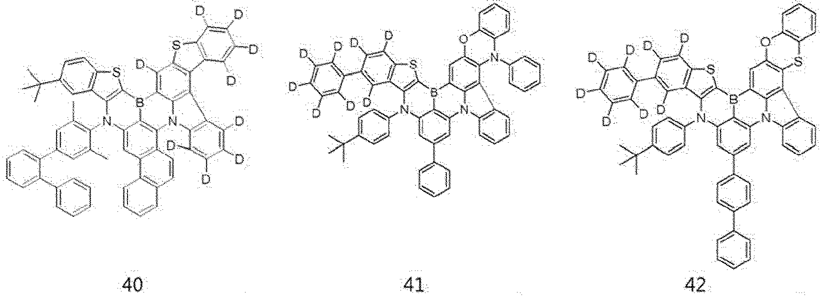

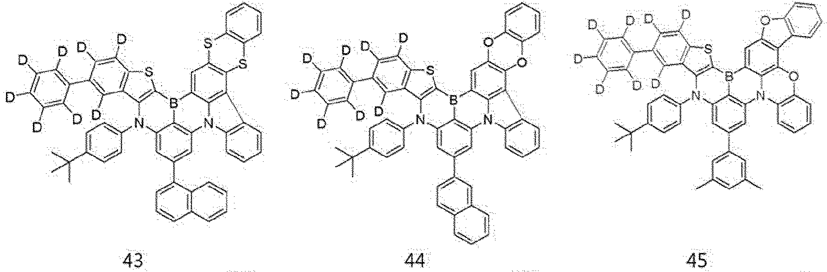

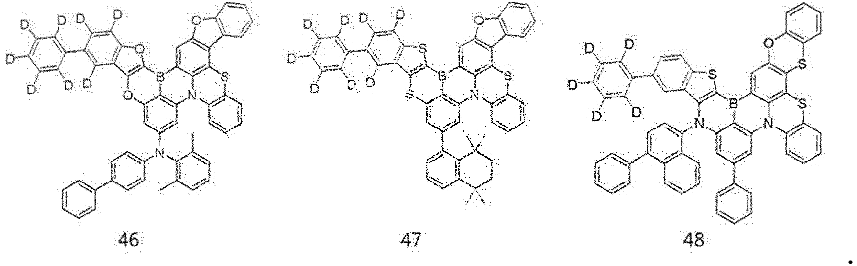

6. An organic light-emitting device comprising:
a first electrode;
a second electrode opposite to the first electrode; and
an organic layer interposed between the first electrode and the second electrode,
wherein the organic layer includes at least one type of the polycyclic compound represented by [Chemical Formula 1] or [Chemical Formula 2] of claim 1.

7. The organic light-emitting device according to claim 6, wherein the organic layer includes at least one of an electron injecting layer, a hole injecting layer, a hole transport layer, an electron blocking layer, a functional layer having both a hole injecting function and a hole transport function, a light-emitting layer, an electron transport layer, an electron injecting layer, a hole blocking layer, and a functional layer having both an electron injecting function and an electron transport function; and
at least one of the above-mentioned layers includes at least one type of the polycyclic compound represented by [Chemical Formula 1] or [Chemical Formula 2].

8. The organic light-emitting device according to claim 7, wherein the light-emitting layer is formed with a host and a dopant, and at least one type of the polycyclic compound represented by [Chemical Formula 1] or [Chemical Formula 2] is the dopant in the light-emitting layer.

9. The organic light-emitting device according to claim 8, wherein the host is an anthracene compound represented by the following [Chemical Formula 3]: 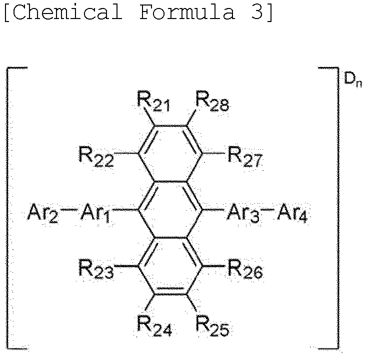 in [Chemical Formula 3],
R₂₁ to R₂₈ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group and a halogen group;
Ar₁ and Ar₃ are the same as or different from each other, and each independently a single bond, or a substituted or unsubstituted C₆-C₃₀ arylene group or a substituted or unsubstituted C₅-C₃₀ heteroarylene group;
Ar₂ and Ar₄ are the same as or different from each other, and each independently any one selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted fused cyclic group of C₃-C₃₀ aliphatic ring and C₃-C₃₀ aromatic ring; and
Dₙ refers to the number of hydrogens replaced by deuterium in [Chemical Formula 3], and n is an integer of 0 to 50.

10. The organic light-emitting device according to claim 9, wherein [Chemical Formula 3] is any one selected from compounds represented by the following chemical formulae: 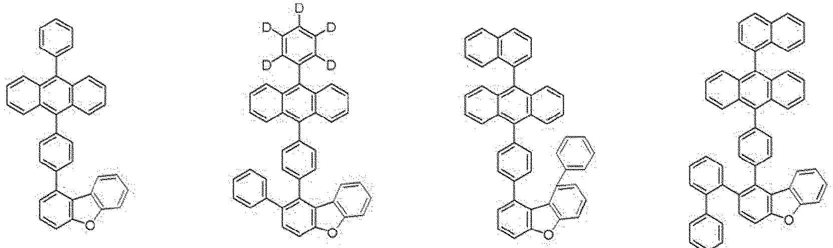 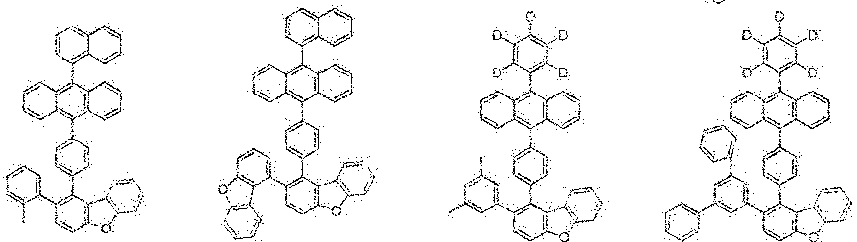 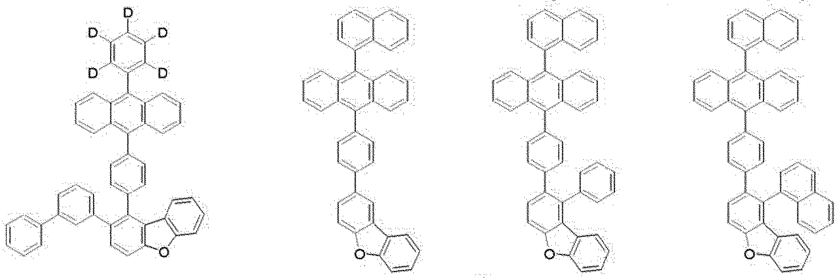 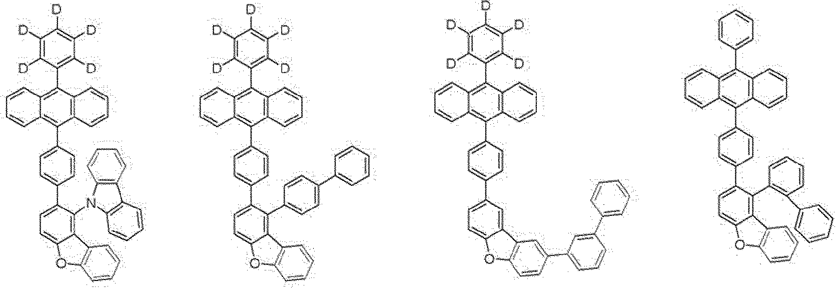 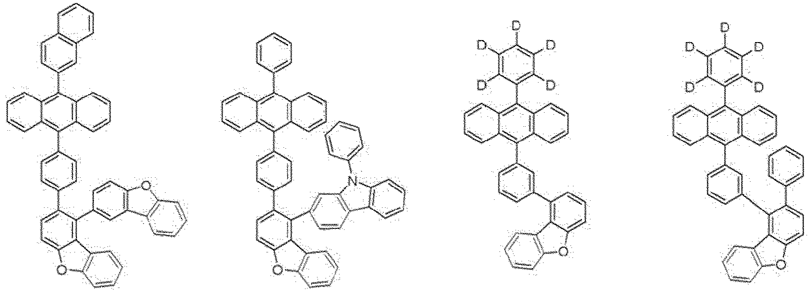 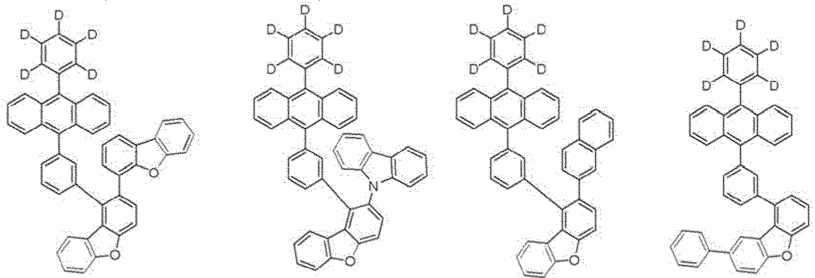 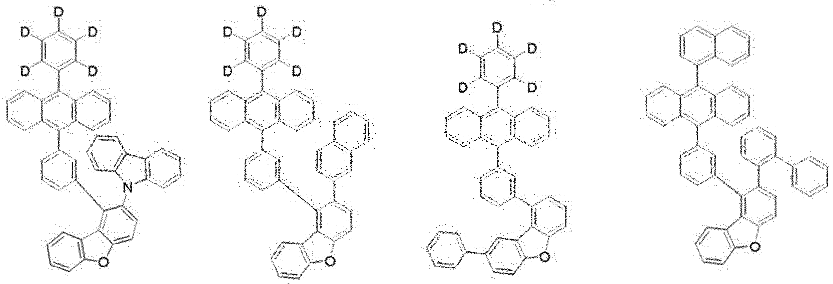 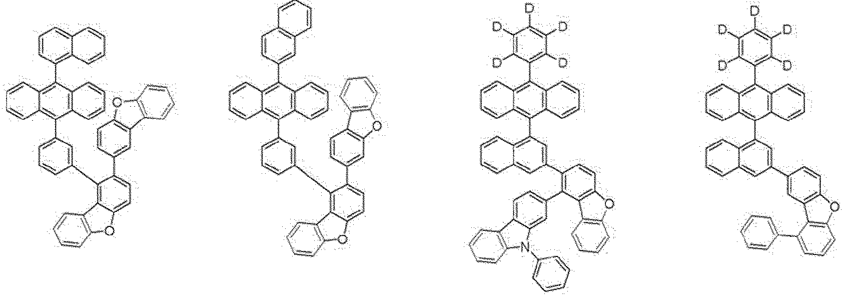 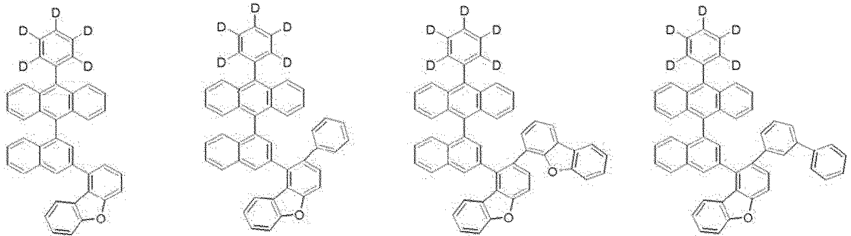 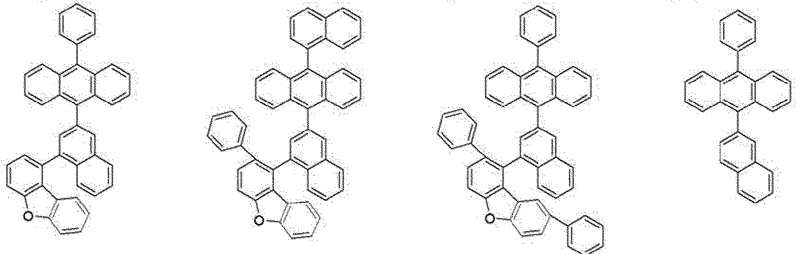 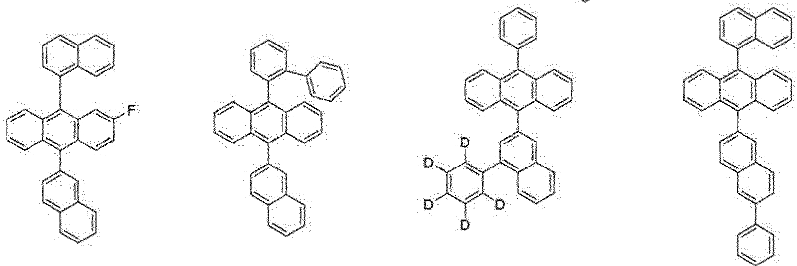 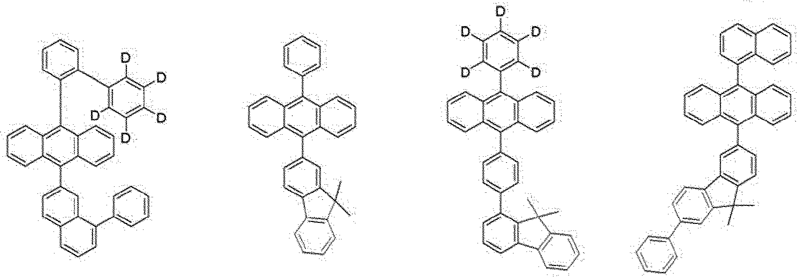 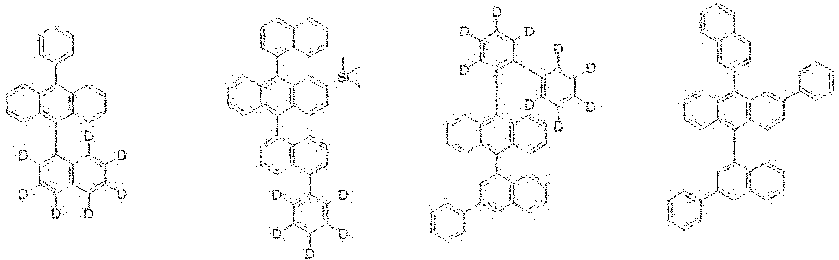 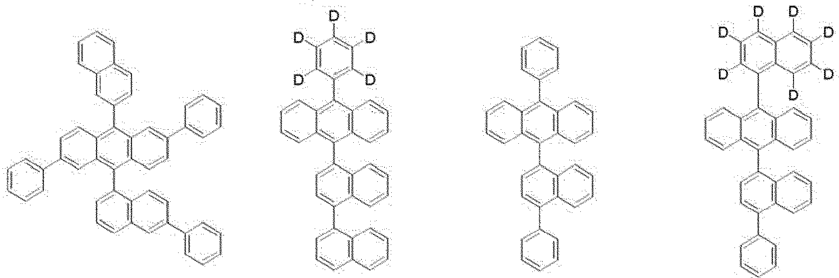 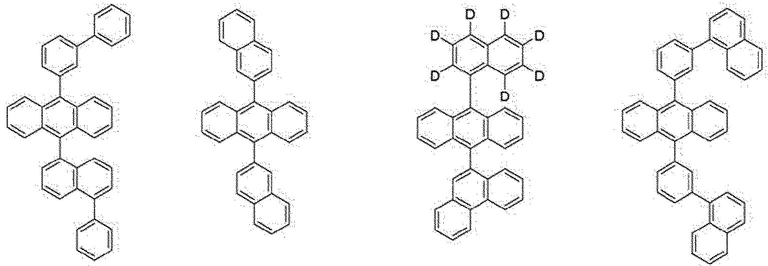 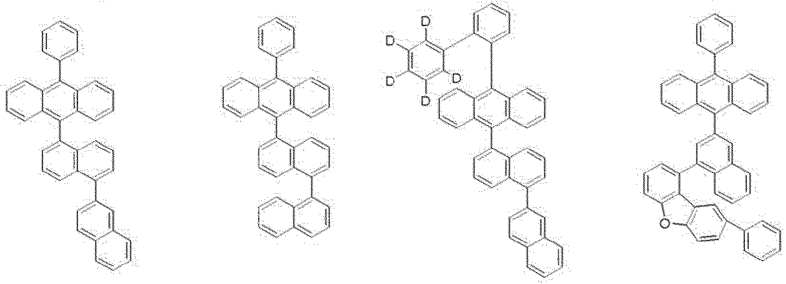 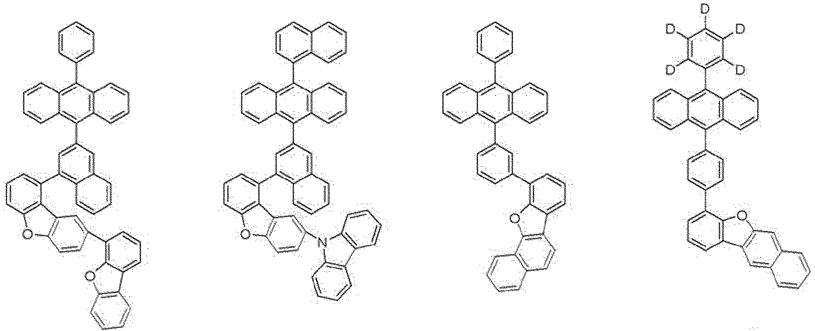 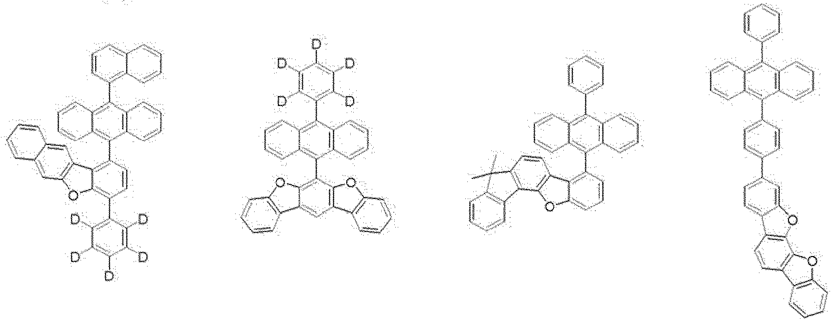 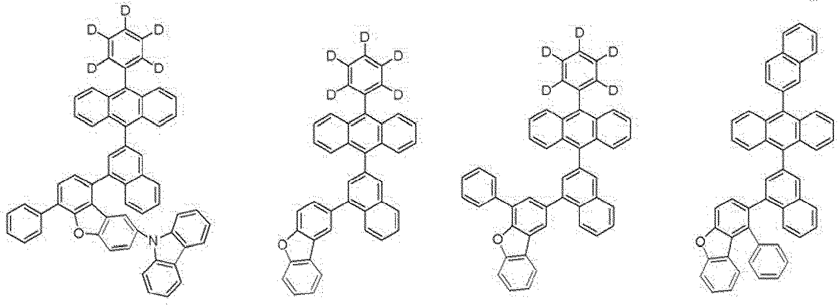 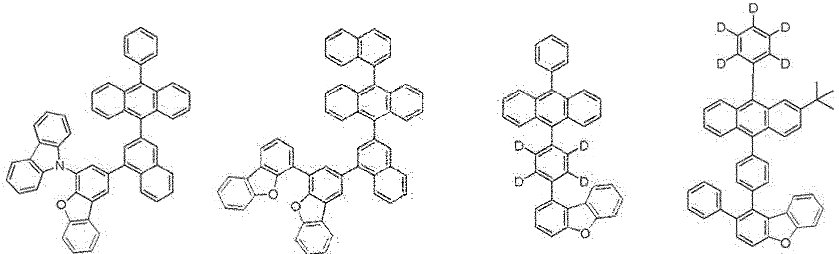 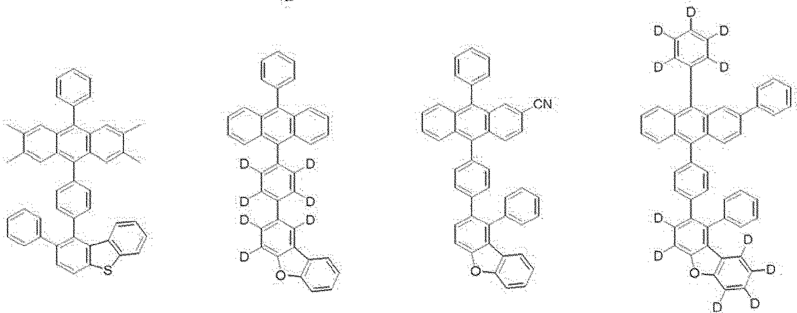 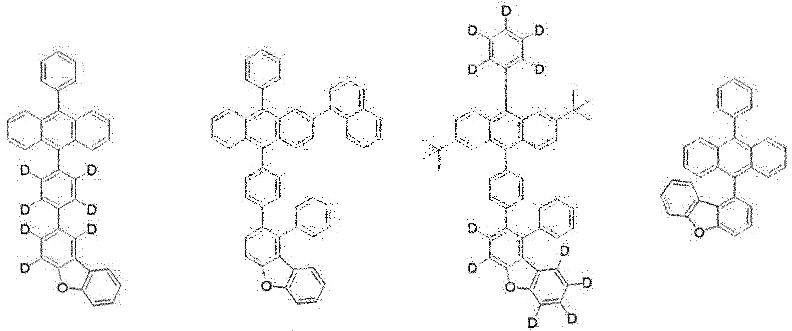 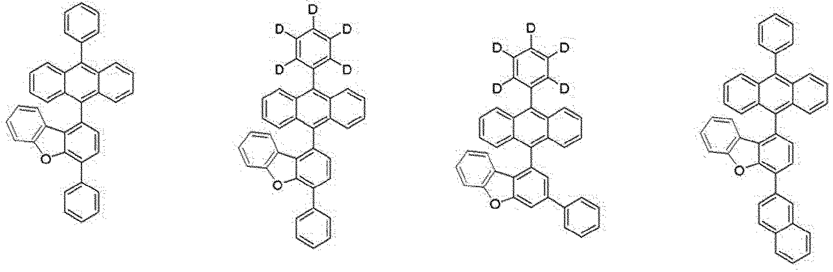 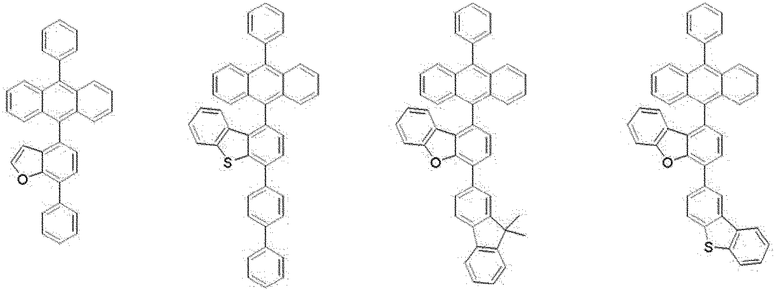 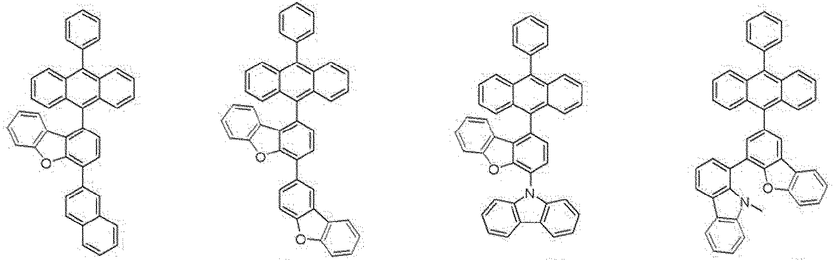 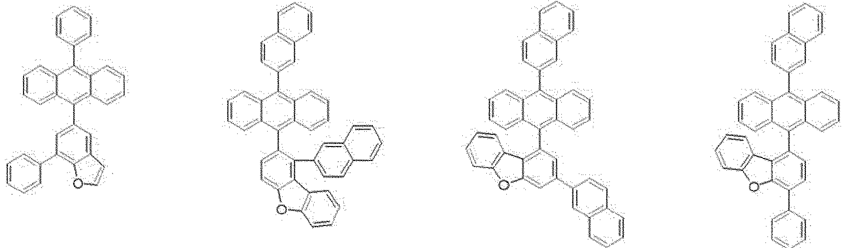 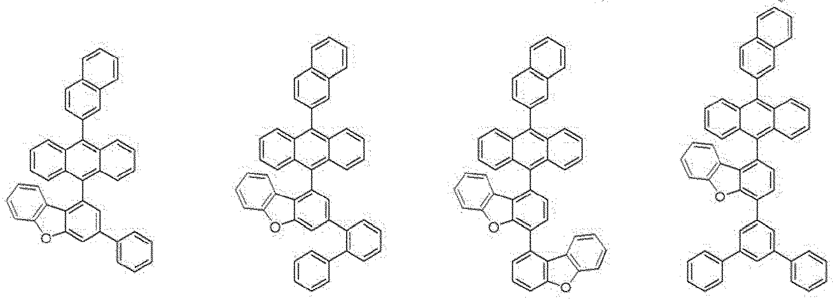 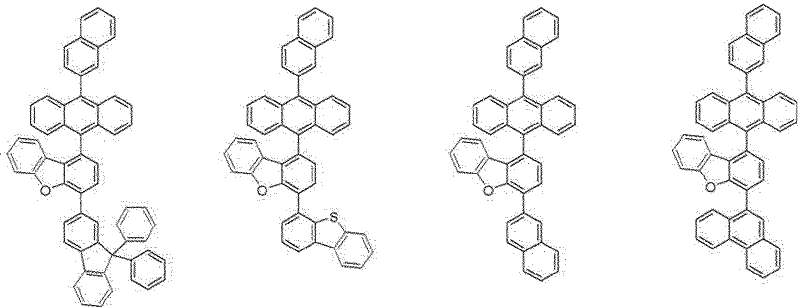 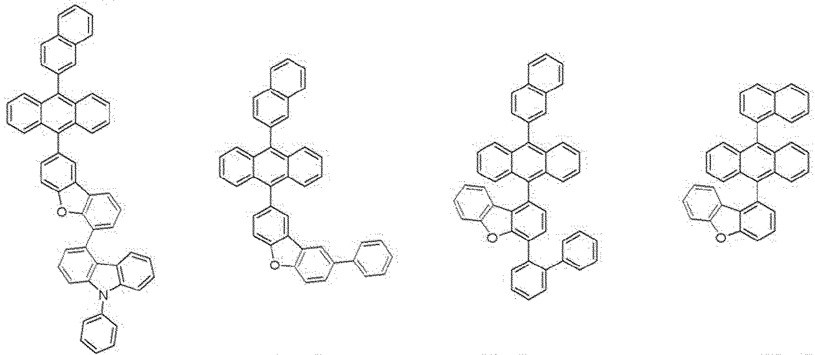 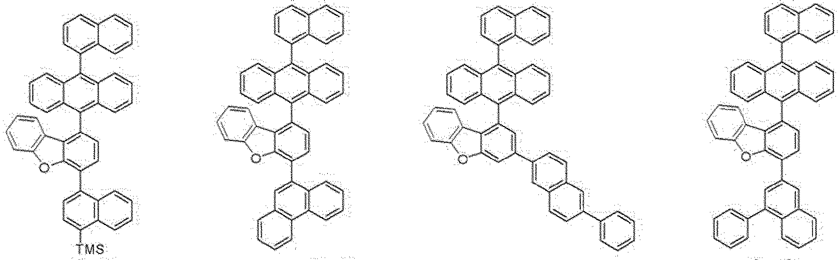 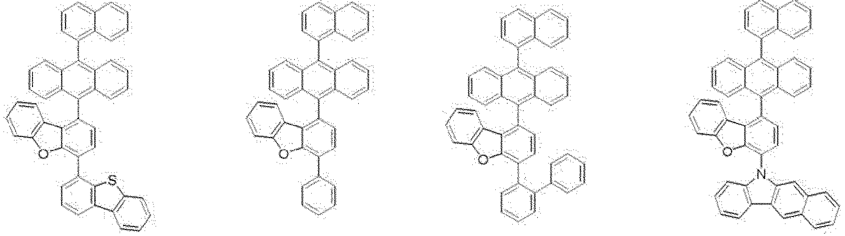 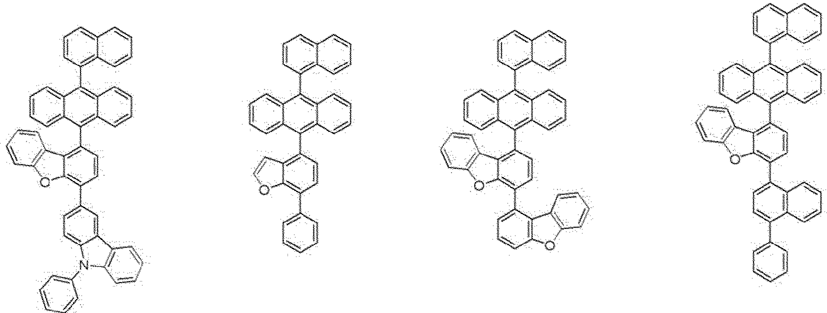 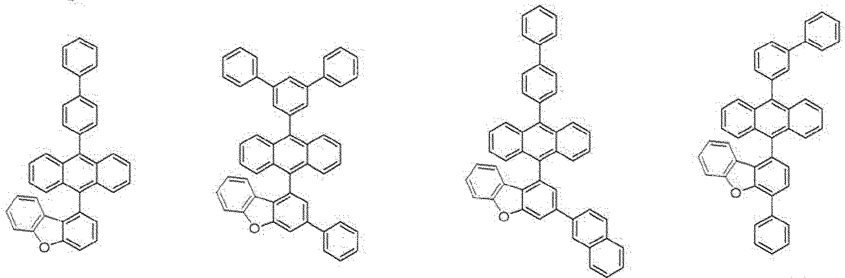 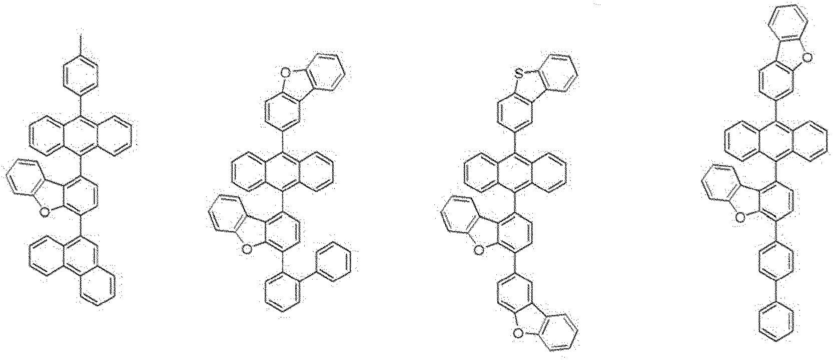 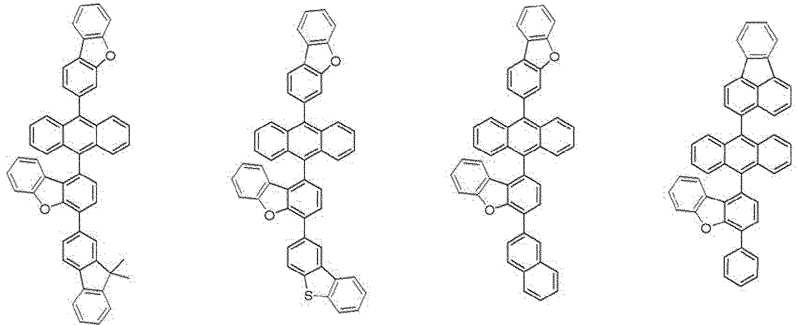 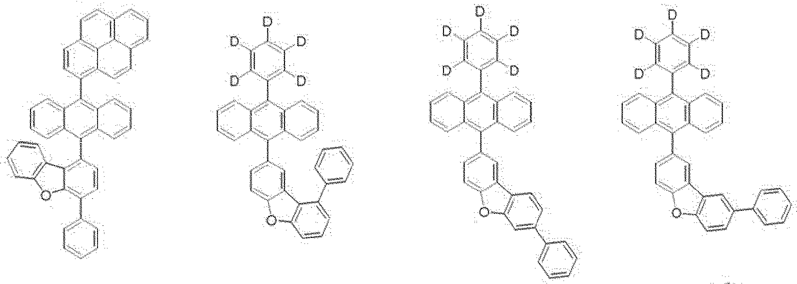 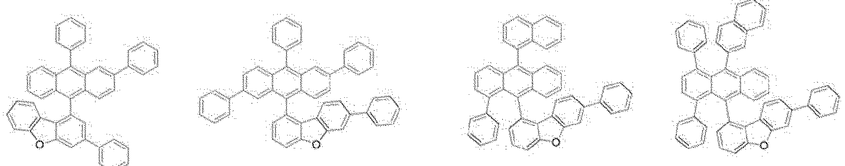 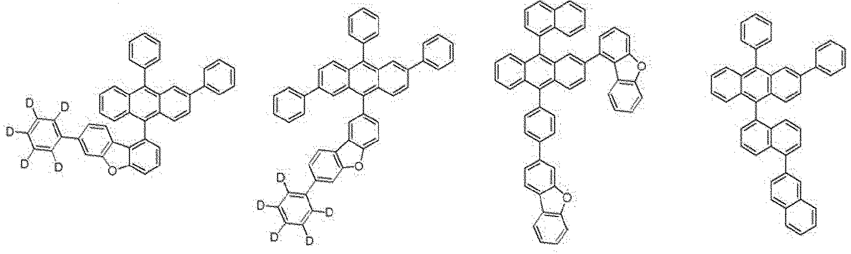 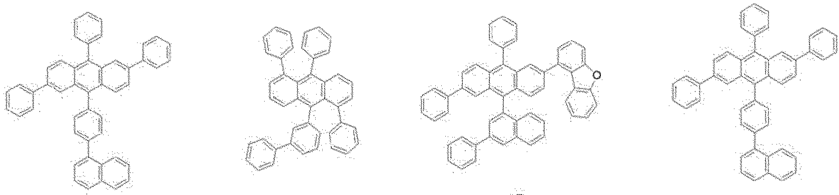 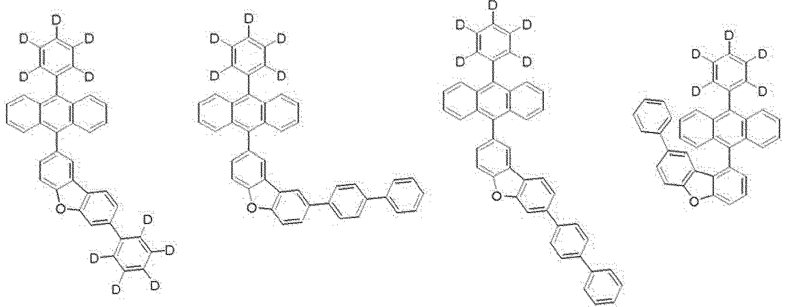 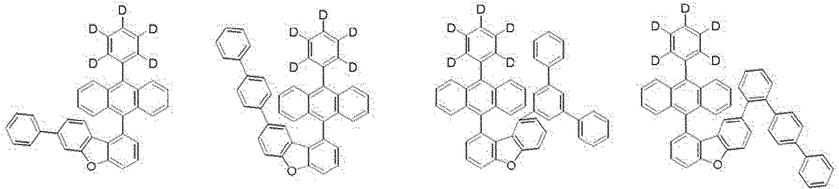 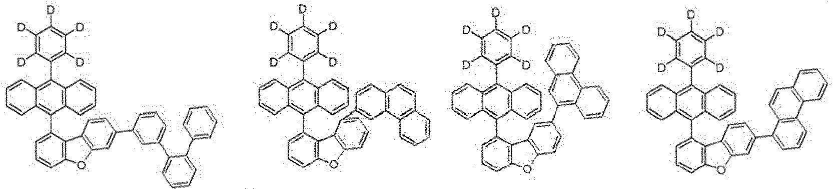 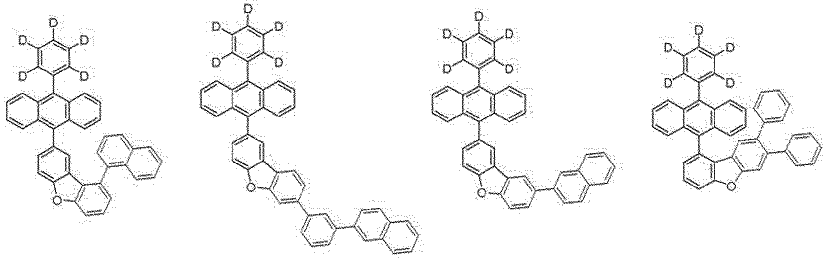 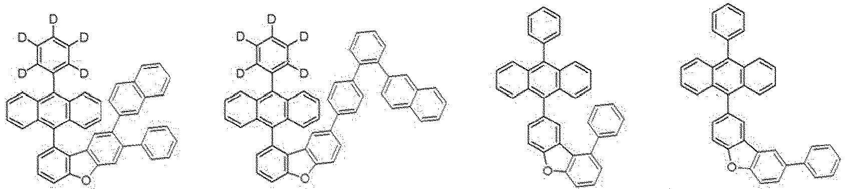 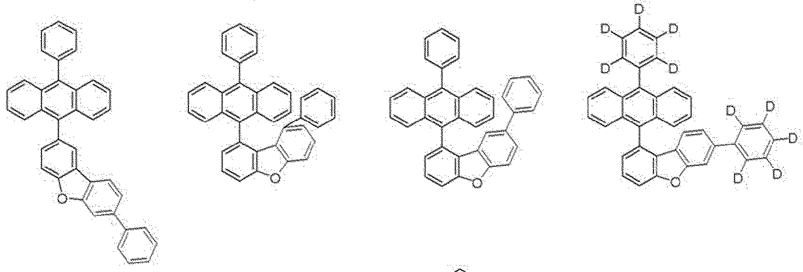 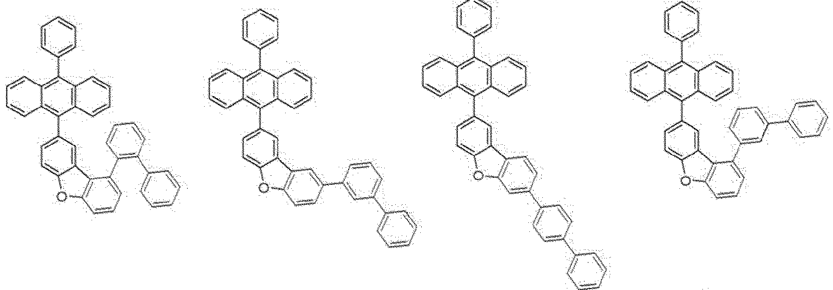 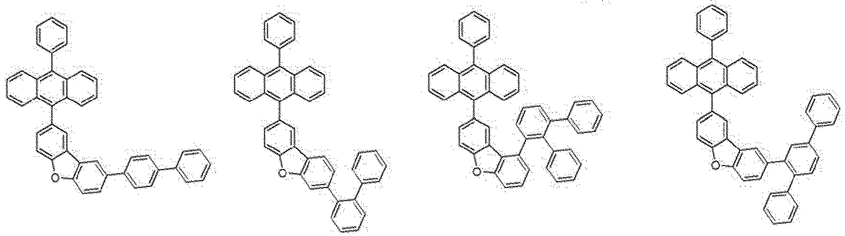 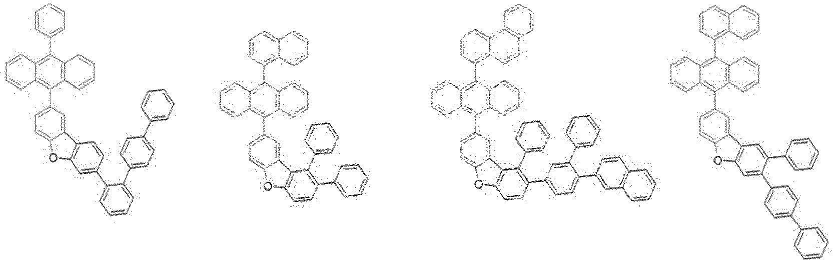 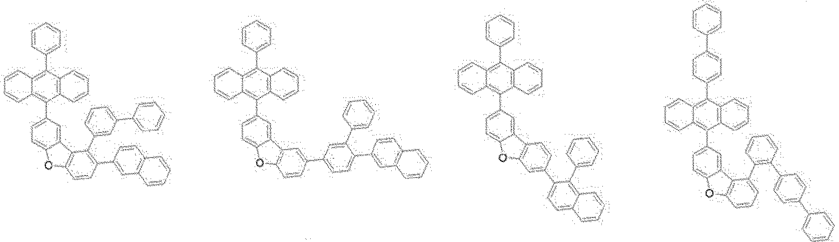 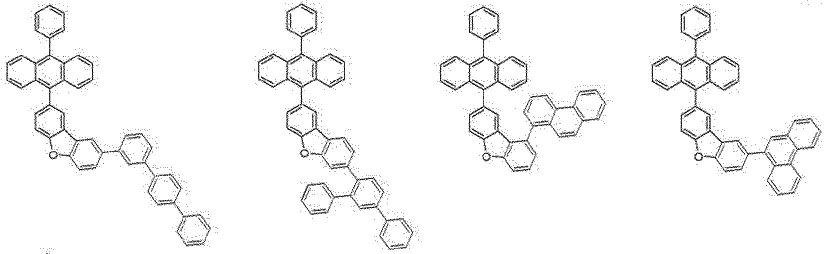 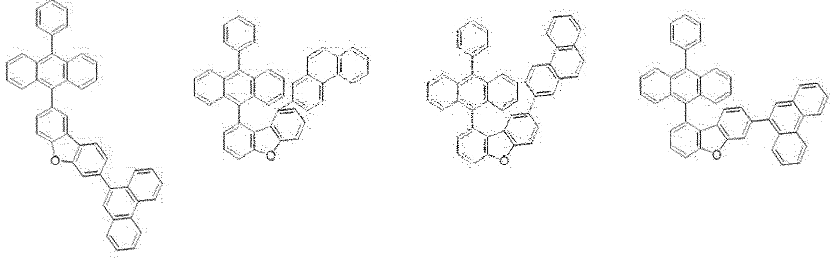 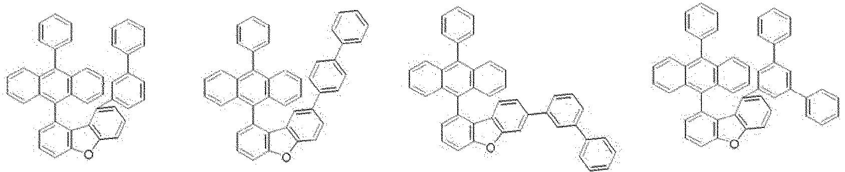 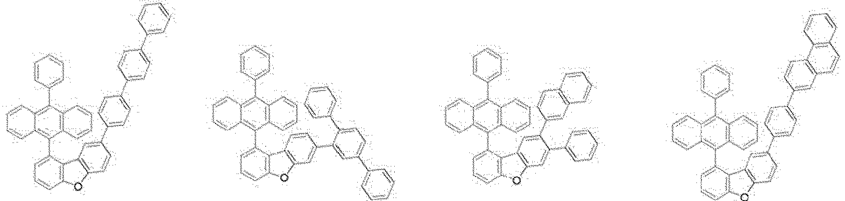 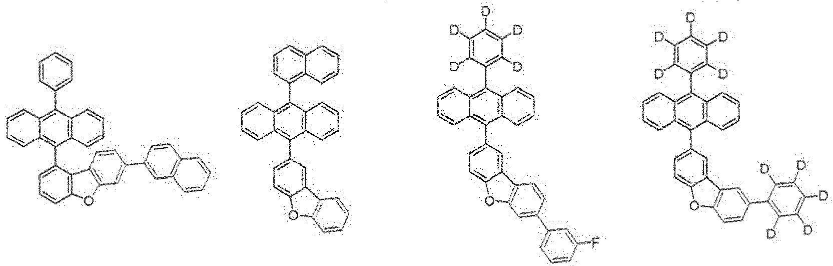 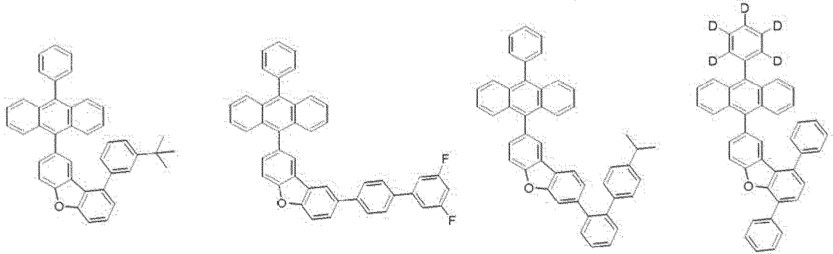 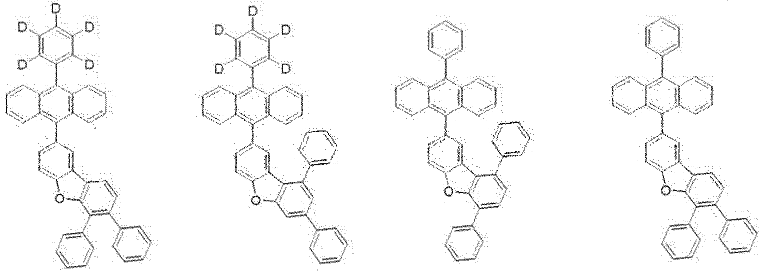 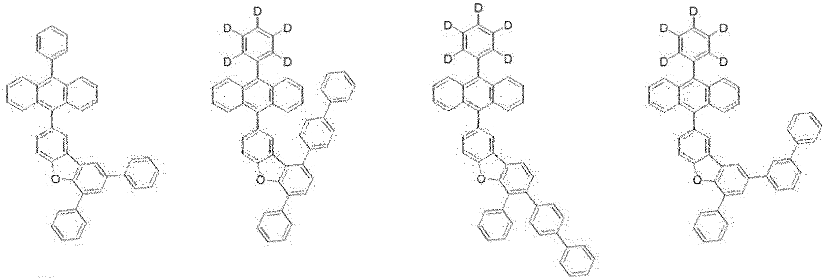 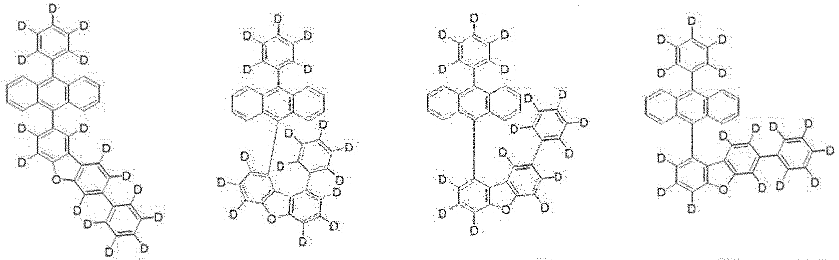 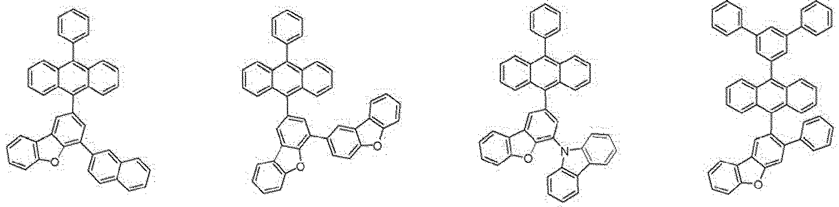 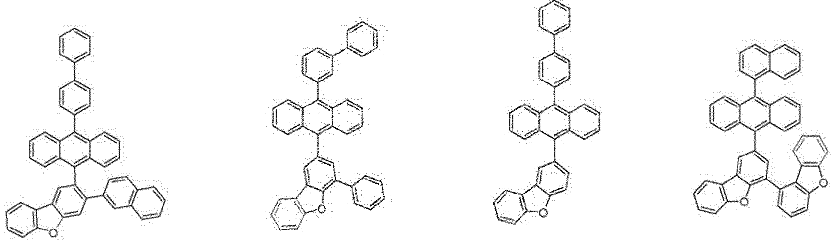 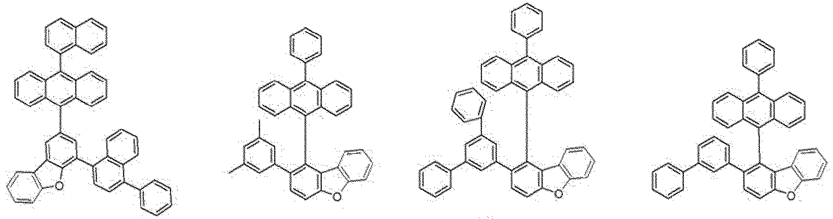 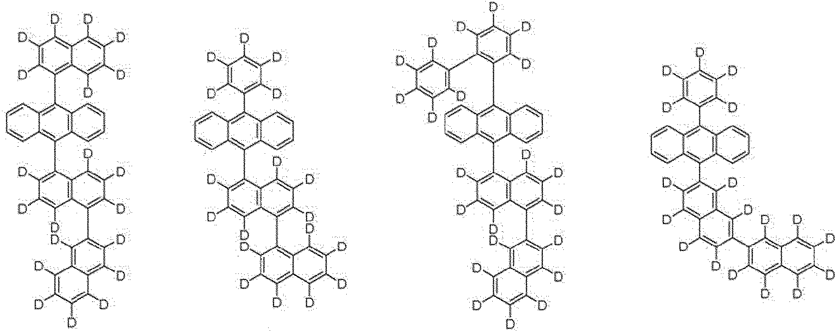 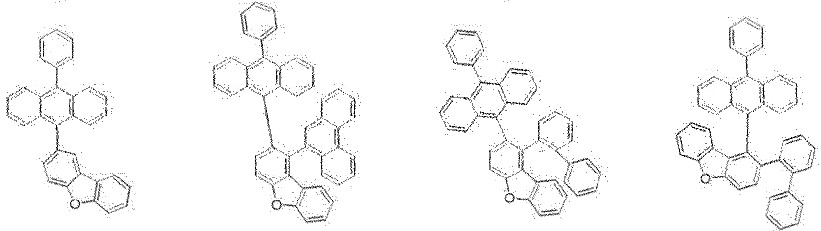 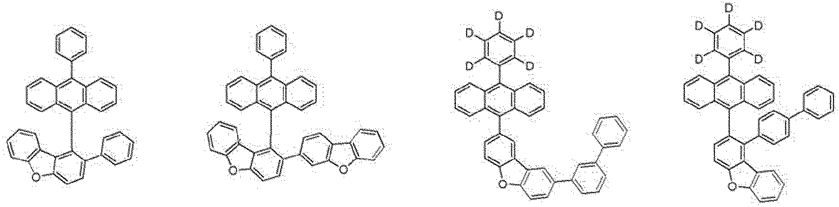 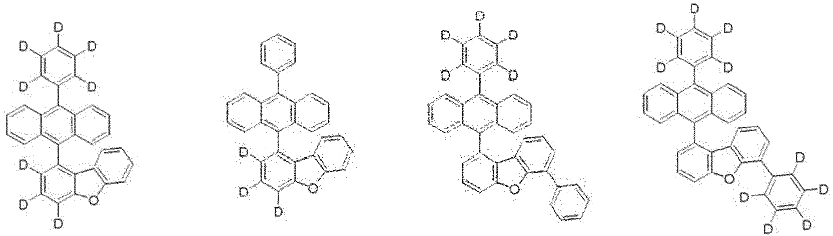 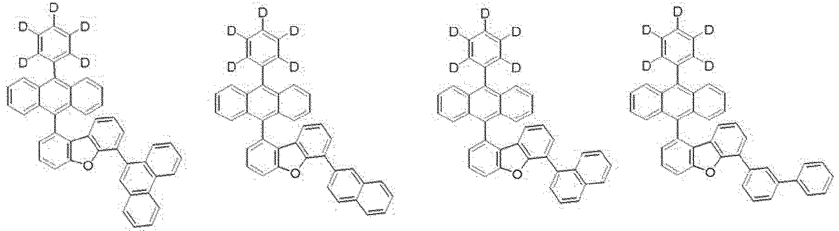 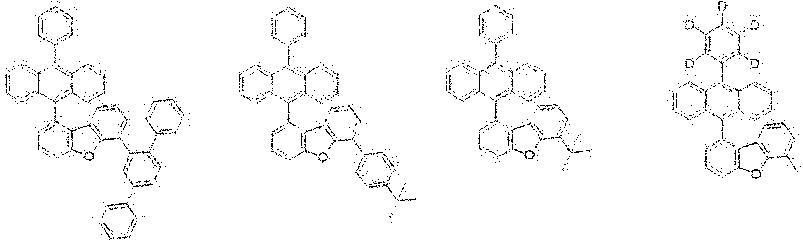 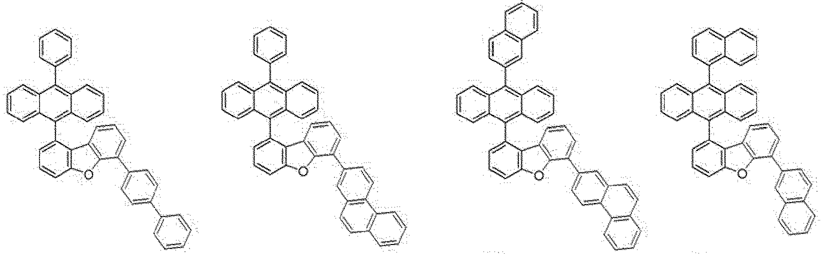 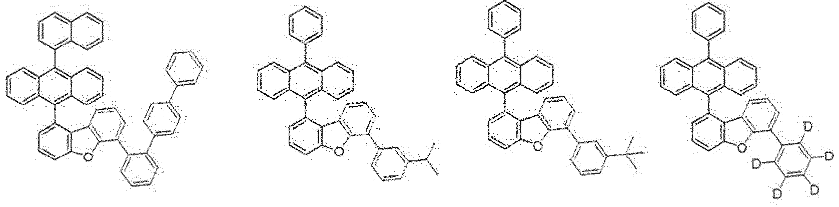 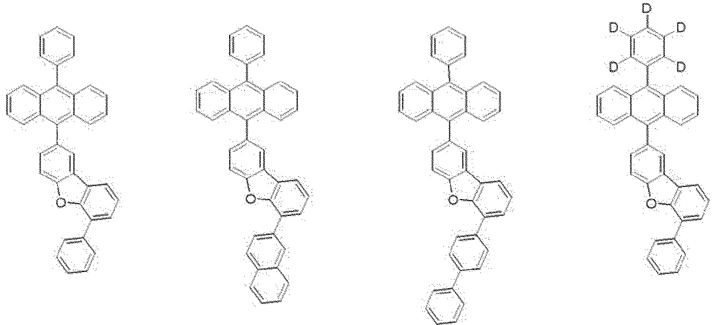 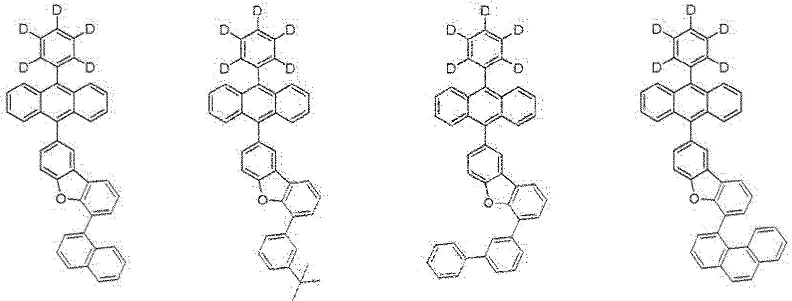 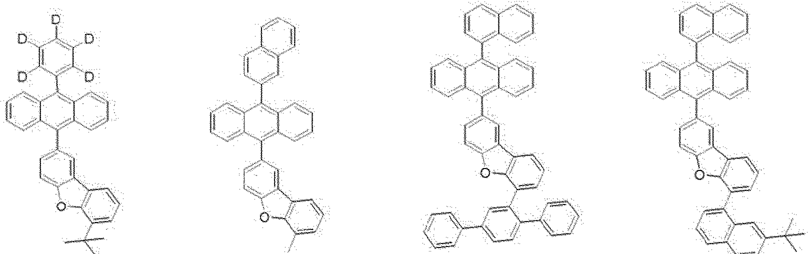 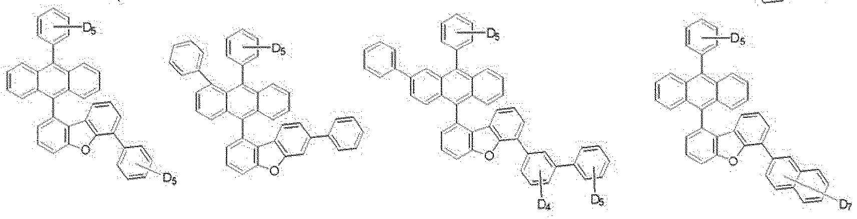 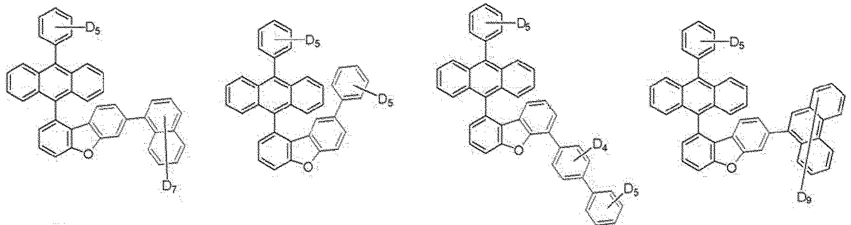 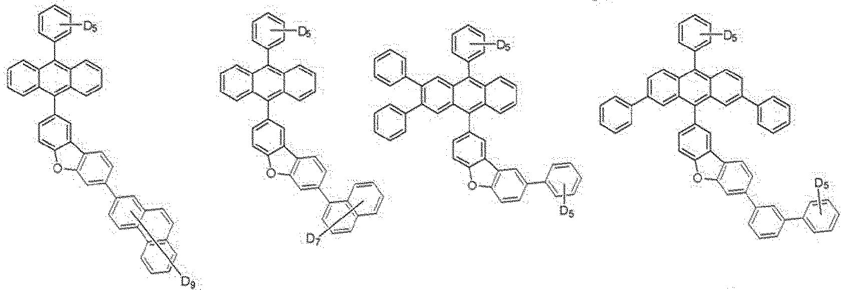 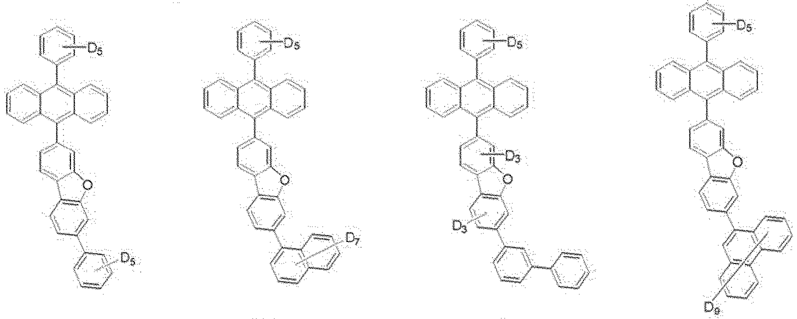 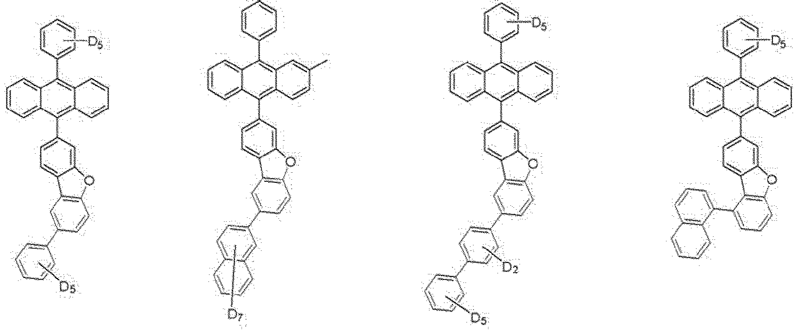 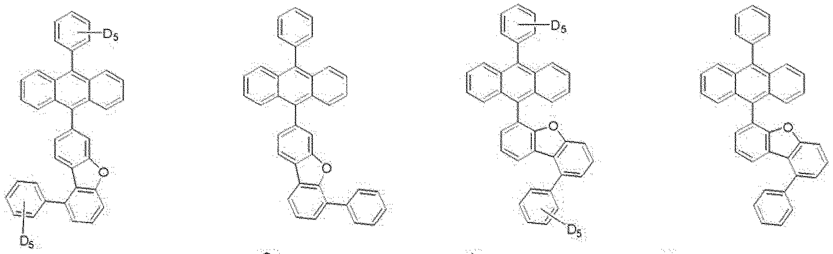 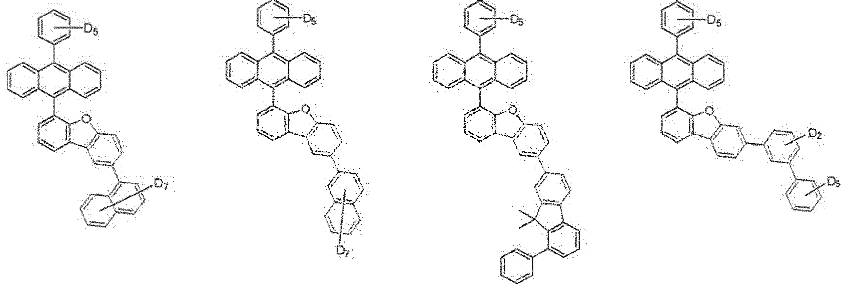 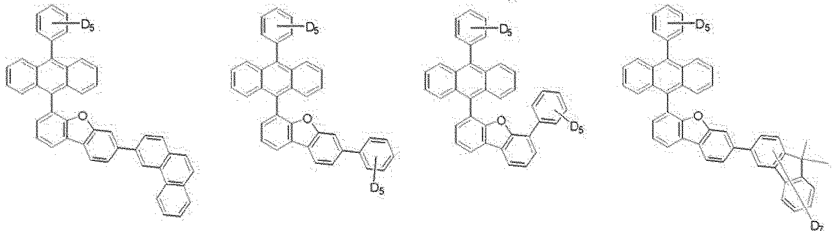 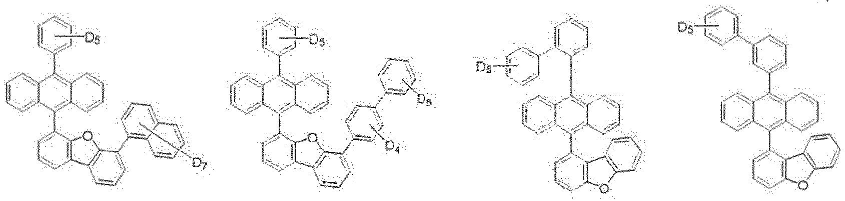 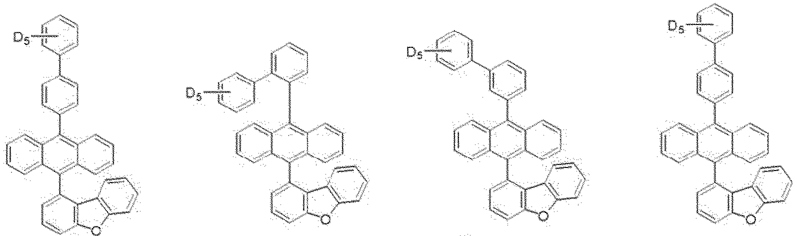 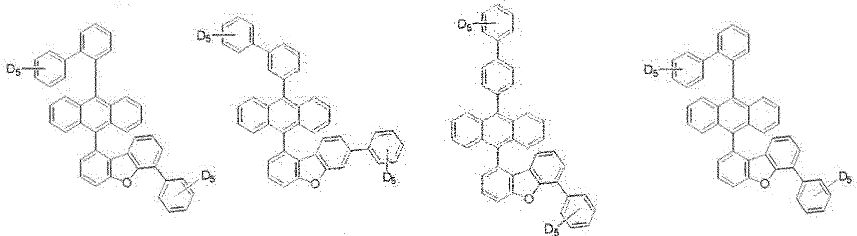 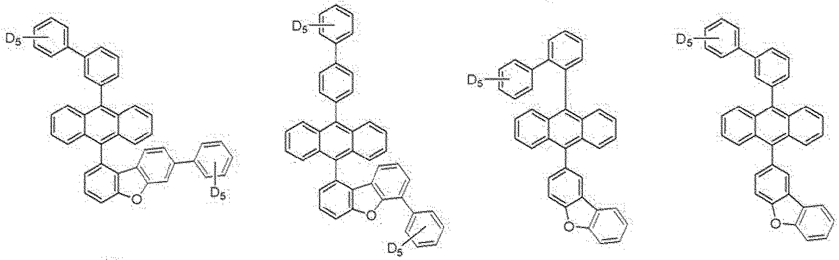 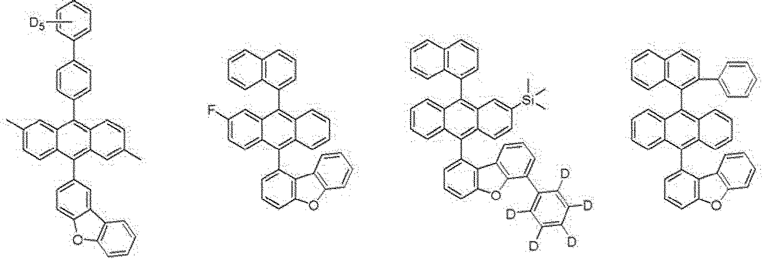 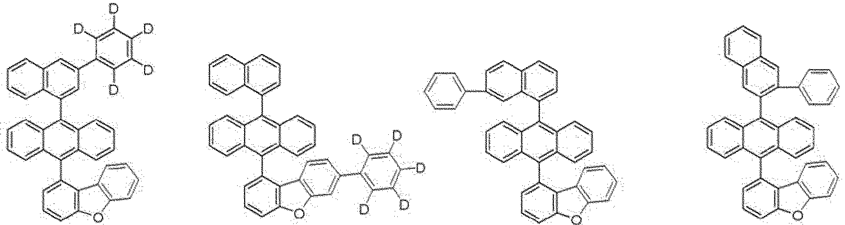 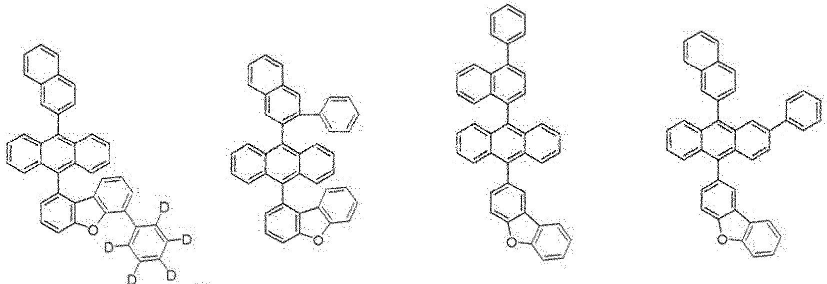 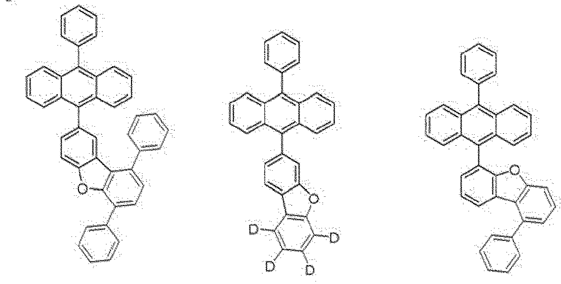 .

11. The organic light-emitting device according to claim 7, wherein at least one selected from the layers is formed using a deposition process or a solution process.

12. The organic light-emitting device according to claim 8, wherein one or more types of compounds other than the one type of compound represented by [Chemical Formula 3] are mixed or laminated to be used as the host in the light-emitting layer.

13. The organic light-emitting device according to claim 8, wherein one or more types of compounds other than the one type of compound represented by [Chemical Formula 1] or [Chemical Formula 2] are mixed or laminated to be used as the dopant in the light-emitting layer.

14. The organic light-emitting device according to claim 6, which is used in any one device selected from flat panel display devices; flexible display devices; monochromatic or white flat panel lighting devices; monochromatic or white flexible lighting devices; display devices for vehicles; and display devices for virtual or augmented reality.
